# EUROPEAN PATENT SPECIFICATION

(11) **EP 1 642 917 B1**
(45) Date of publication and mention of the grant of the patent: **27.03.2013**
(21) Application number: 04747259.2
(22) Date of filing: 02.07.2004
(51) Int. Cl.: C08G 59/62

(54) **EPOXY RESIN COMPOSITION**
EPOXIDHARZZUSAMMENSETZUNG
COMPOSITION DE RÉSINE ÉPOXYDE

(30) Priority: 03.07.2003 JP 2003270825; 17.10.2003 JP 2003357811
(43) Date of publication of application: 05.04.2006
(73) Proprietor: NEC Corporation, Minato-ku Tokyo 108-8001 (JP); Arisawa Manufacturing Co., Ltd., Joetsu-shi, Niigata 943-8610 (JP)
(72) Inventor: KIUCHI, Yukihiro, c/o NEC Corporation, Tokyo 108-8001 (JP); IJI, Masatoshi, c/o NEC Corporation, Tokyo 108-8001 (JP); NAGASHIMA, Hiroaki, c/o Arisawa Manufact. Co., Ltd, Joetsu-shi, Niigata 943-8610 (JP); TSUKADA, Mamoru, c/o Arisawa Manufact. Co., Ltd, Joetsu-shi, Niigata 943-8610 (JP)
(74) Representative: von Samson-Himmelstjerna, Friedrich
(86) International application number: PCT/JP2004/009791
(87) International publication number: WO 2005/003208

(56) References cited:
- EP-A1- 1 260 551
- JP-A- 2001 226 465
- JP-A- 2001 329 051
- JP-A- 2001 329 051
- JP-A- 2002 003 711
- JP-A- 2002 220 514
- JP-A- 2002 220 514
- JP-A- 2002 241 475
- JP-A- 2002 241 475
- JP-A- 2002 241 590
- JP-A- 2003 136 620
- JP-A- 2003 136 620
- JP-A- 2003 147 052

## Description

### Technical Field

The present invention relates to a printed circuit board material simultaneously having superior heat resistance and adhesion. In the present invention, the printed circuit board material indicates an epoxy resin composition, a resin sheet (hereinafter referred to as "prepreg material") which is prepared by impregnating a base material, such as a glass cloth or a non-woven glass cloth, with an epoxy resin composition, followed by semi-curing or semi hardening, a laminate using an epoxy resin composition, a glass epoxy resin copper-clad laminate, and a printed circuit board.

### Background Art

Heretofore, when a glass epoxy resin copper-clad laminate is required to have flame retardant properties in view of fire prevention and safety ensuring, a halogen-based flame retardant has been generally used as a flame retardant.

However, when electronic components or semiconductor devices are mounted on a glass epoxy resin copper-clad laminate containing the above flame retardant by using a high melting point solder such as a lead free solder, since the flame retardant is partly decomposed, and/or the total amount of thermal expansion of the laminate is increased due to a high temperature generated in the mounting step, there has been a problem (degradation in solder heat resistance) in that peeling or swelling of the copper-clad laminate occurs. Hence, development of a glass epoxy resin copper-clad laminate has been desired which has a superior heat resistance (high Tg) indicated by a glass transition temperature (Tg) and which can reduce the amount of the total thermal expansion, without using a halogen-based flame retardant.

In addition, as a method for imparting flame retardant properties besides the use of a halogen-based flame retardant, various techniques using a phosphorus-based compound for laminates have been known. However, the phosphorus-based compound is dissolved in a blackening treatment liquid (strong alkaline solution), which is used for roughening a copper foil surface, and seriously degrades the performance of the treatment liquid, that is, a problem occurs in that the usable time of the treatment liquid is considerably decreased. In the case in which a glass epoxy resin copper-clad laminate is applied to a multilayer board, when an inner circuit is formed, in order to improve the adhesion between a prepreg material and a shiny surface or a glossy surface of a copper foil opposite to a mat surface thereof which is also called a non-glossy surface, the blackening treatment is performed which is a method for forming anchors of copper oxide on the shiny surface of the copper foil using a blackening treatment liquid.

As a method for solving the above problems caused by the use of a halogen-based and a phosphorus-based flame retardant, the inventors of the present invention developed a flame retardant epoxy resin composition for printed circuit board materials, which can realize superior flame retardant properties without using a halogen-based and a phosphorus-based flame retardant (see Japanese Unexamined Patent Application Publication No. 2001-226465, hereinafter referred to as "Reference 1 "). The flame retardant epoxy resin composition is essentially composed of a phenolaralkyl type resin having a repeating unit containing an aromatic ring selected, for example, from biphenyl, benzene, and a derivative thereof in a structural formula (the number (n) of repetitions of the repeating unit in the structural formula being 0 to 10); a metal hydrate such as aluminum hydroxide; and/or an epoxy compound of the above phenolaralkyl resin, which is hereinafter referred to as a phenolaralkyl type epoxy resin. The flame retardant epoxy resin composition is formulated so that an effect of forming a heat insulating layer using foams which are generated from a resin component in a cured epoxy resin composition by a decomposed gas in ignition and an endothermic effect by various metal hydrates (in particular, aluminum hydroxide is most preferable) collaboratively work together, and as a result, a particular flame retardant effect can be obtained.

In addition, it has been disclosed in Japanese Patent No. 3122834 (hereinafter referred to as "Reference 2") that an epoxy resin composition has superior adhesion properties which uses a phenol novolac condensate (hereinafter referred to as "phenolbiphenylenearalkyl type resin") and an epoxy compound of a phenolbiphenylenearalkyl type resin (hereinafter referred to as "phenolbiphenylenearalkyl type epoxy resin"). In the above epoxy resin composition, the phenol novolac condensate has a repeating unit number (n) of 0 to 9 in the structure and is obtained by reaction of a phenol-based compound with biphenyl and its derivative (such as various isomers of bismethoxymethylbiphenyl) among the resins disclosed in Reference 1.

However, cured or hardened materials of the epoxy resin compositions using the phenolaralkyl type resin and/or phenolaralkyl type epoxy resin, which are disclosed in References 1 and 2, have not been optimized for laminates, the heat resistance and adhesion thereof were not sufficient.

That is, even when the epoxy resin compositions disclosed in References 1 and 2 are used for laminates, the glass transition temperature, an index indicating the heat resistance, is lower than that of a required level, and when mounting of components and the like is performed at a high temperature using a lead free solder or the like, the total expansion amount in the laminated direction, that is, in a z axis direction, is large, so that swelling and/or peeling is liable to occur. Accordingly, it is necessary to further improve the glass transition temperature without degrading particular flame retardant properties of the cured material of the above epoxy resin composition.

In addition, with reference to the evaluation results on the adhesion to an aluminum foil, disclosed in Reference 2, a cured material obtained by reaction of the phenolbiphenylenearalkyl type resin and/or the phenolbiphenylenearalkyl type epoxy resin disclosed in the above reference was applied to a prepreg material used for glass epoxy resin copper-clad laminates, and the adhesion between this prepreg material and a copper foil was evaluated.

However, the effect on the adhesion similar to that disclosed in Reference 2 was not obtained when a copper foil was used. The reason for this was construed that the flexibility (represented by the amount of elongation and that of deformation when rupture or breakage occurs) of the cured materials obtained by reaction of the phenolbiphenylenearalkyl type resin and/or the phenolbiphenylenearalkyl type epoxy resin is insufficient. The same thing can also be said to the epoxy resin composition in Reference 1, and the flexibility of the cured material thereof was also insufficient.

That is, in glass epoxy resin laminates using the resin components disclosed in References 1 and 2, when being peeled away from a copper foil along an adhesion surface, the laminate cannot follow the deformation of the copper, and as a result, sufficient adhesion cannot be obtained. Hence, in order to obtain tight adhesion between the prepreg material and the copper foil, it has been required to improve the flexibility of a cured material of an epoxy resin composition used for forming the prepreg material, that is, it has been necessary to increase the amount elongation when rupture or breakage occurs.

Furthermore, in order to improve the adhesion between a copper foil and a prepreg material, it is also important that when an epoxy resin composition is melted by a heating press, the surface of the copper foil is sufficiently wetted with this molten composition (superior wettability is obtained when the melt fluidity of the epoxy resin composition is higher). However, in the epoxy resin composition disclosed in Reference 1, the structure (in particular, the repeating unit number (n) in the structure or the molecular weight) of the resin component having a significant influence on the fluidity and the selection of metal hydrate particles were not optimized, besides insufficient wettability between the resin composition and the copper foil surface, the wettability between the resin component and the metal hydrate particles was also insufficient.

Hence, compared to surface irregularities, which are generally called "anchors" having a depth of 5 to 10 µm, of a mat surface of a copper foil, a blackening treatment surface or the like has small anchors having a depth of 1 to 2 µm, so that the anchor effect cannot be expected. Accordingly, the adhesion of a prepreg material using the epoxy resin composition of Reference 1 to the above blackening treatment surface is seriously decreased as compared to that of a conventional FR-4 material.

### Disclosure of Invention

It is an object of the present invention to provide an epoxy resin composition for printed circuit boards and the like, simultaneously having superior heat resistance and adhesion without using a halogen-based or a phosphorus-based flame retardant.

It is another object of the present invention to provide a prepreg material using the above epoxy resin composition.

In addition, it is still another object of the present invention to provide a laminate using the above epoxy resin composition.

In addition, it is yet another object of the present invention to provide a copper-clad laminate having a copper foil adhered to one surface of the above prepreg material.

In addition, it is a further object of the present invention to provide a copper foil provided with a resin, which is obtained by applying the above epoxy resin composition onto a surface of a copper foil.

In addition, it is a still further object of the present invention to provide a printed circuit board formed by laminating at least one type of the prepreg material, the laminate, the copper-clad laminate, and the copper foil provided with a resin.

According to the objects described above, intensive research was carried out by the inventors of the present invention in order to develop an epoxy resin composition used for printed circuit boards, which simultaneously has superior heat resistance and adhesion without using a halogen-based or a phosphorus-based flame retardant.

First, the reason the heat resistance and adhesion of the cured material of the epoxy resin composition using a phenolaralkyl type resin and/or a phenolaralkyl type epoxy resin do not reach the required levels were analyzed. As a result, the reasons are construed that in addition to a low cross-linking density of the cured material and a large free volume in the cured material, intermolecular forces (interlocking of molecular chains and the like) of molecular networks and molecular chains forming a cross-linking structure cannot sufficiently suppress the micro-Brownian motion of the cross-linking structure.

Next, a method for improving the cross-linking density and a method for increasing the intermolecular forces in the molecular networks and of the molecular chains were variously investigated.

When the cross-linking density was improved, the heat resistance was improved. However, the flexibility of the cross-linking structure was seriously degraded, and the adhesion was also degraded. Accordingly, in order to simultaneously improve the heat resistance and the adhesion, it was believed that increase in intermolecular force in the molecular networks and of the molecular chains is effective while a low cross-linking density is maintained. Hence, the method of the present invention was investigated. As a result, it was found that a particular effect of improving the heat resistance and the adhesion can be obtained by the following. That is, as an epoxy-resin curing agent, a phenolaralkyl type resin having a larger repeating unit number (n) (higher molecular weight) in the structure than that in the preceding example and having a molecular weight distribution in a specific range is used, and in addition, as an epoxy resin, a phenolaralkyl type epoxy resin having a specific molecular weight distribution (within the molecular weight distribution of the preceding example, and a lower molecular weight than that of the epoxy-resin curing agent that is to be used at the same time).

In addition, by using a phenolaralkyl type resin as the epoxy-resin curing agent, having a specific molecular weight distribution (within the molecular weight distribution of the preceding example, and a lower molecular weight than that of an epoxy resin which is to be used at the same time), and by using a phenolaralkyl type epoxy resin as the epoxy resin, having a larger repeating unit number (n) (higher molecular weight) in the structure than that in the preceding example and having a molecular weight distribution in a specific range, the inventors of the present invention obtained a particular effect of improving the heat resistance and the adhesion. That is, in the preceding example, the phenolaralkyl resin and the epoxy resin, which are to be used together, have similar repeating unit numbers and molecular weights to each other. However, in the present invention, it was found that a particular effect of improving the heat resistance and the adhesion can be obtained when one resin is selected having a larger molecular weight than that of the preceding example, and the other resin is selected having a smaller molecular weight than that of said one resin.

That is, the present invention provides the following epoxy resin compositions.

In accordance with a first aspect of the present invention, there is provided an epoxy resin composition comprising: an epoxy resin (A); and an epoxy-resin curing agent or hardener for epoxy-resins (B) containing at least one of a structural unit X, which is represented by the following general formula (1) obtained by reaction between a phenol-based compound and a biphenyl isomer or a mixture of biphenyl isomers, and a structural unit Y, which is represented by the following general formula (2) obtained by reaction between a phenol-based compound and a benzene isomer or an mixture of benzene isomers, the sum of the number of repetitions of the structural unit X and the number of repetitions of the structural unit Y being more than 10 to less than 75. The general formulas are as follows: 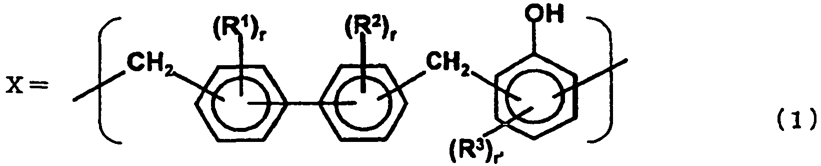 (where R¹, R², and R³ each independently represent hydrogen or a monovalent substituent having 1 to 3 carbon atoms, each r independently represents an integer from 0 to 4, and r' represents an integer from 0 to 3); and 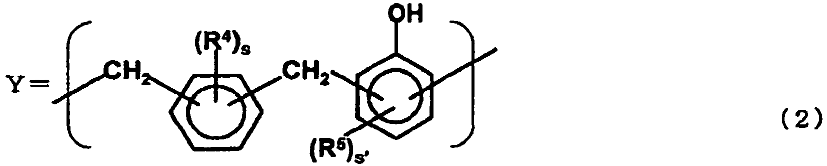 (where R⁴ and R⁵ each independently represent hydrogen or a monovalent substituent having 1 to 3 carbon atoms, s represents an integer from 0 to 4, each s independently represents an integer from 0 to 4, and s' represents an integer from 0 to 3).

That is, the epoxy resin composition of the first aspect of the present invention comprises: the epoxy resin (A); and the epoxy-resin curing agent (B) including a phenol resin represented by one of the following general formulas (3) to (8): 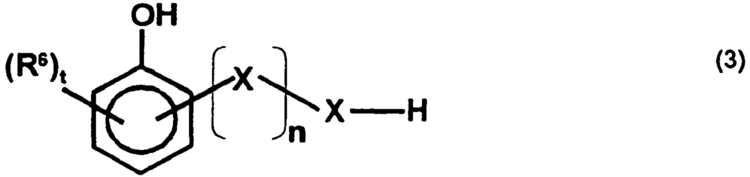 or 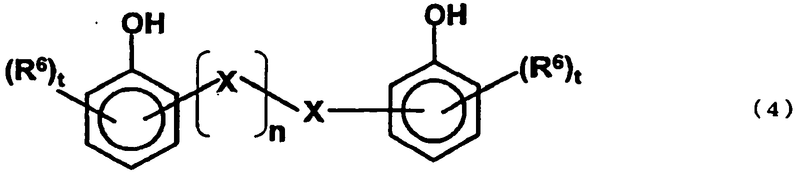 (where R⁶ represents hydrogen or a monovalent substituent having 1 to 3 carbon atoms, t represents an integer from 0 to 4, and n is more than 10 to less than 75); 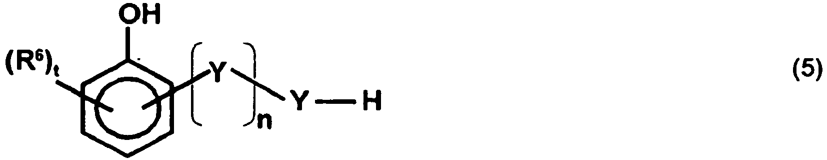 or 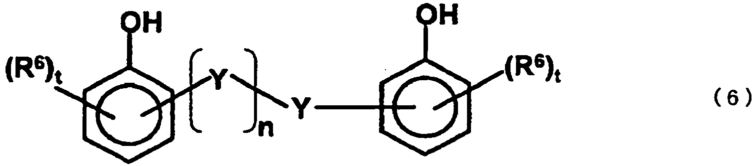 (where R⁶ represents hydrogen or a monovalent substituent having 1 to 3 carbon atoms, t represents an integer from 0 to 4, and n is more than 10 to less than 75); and 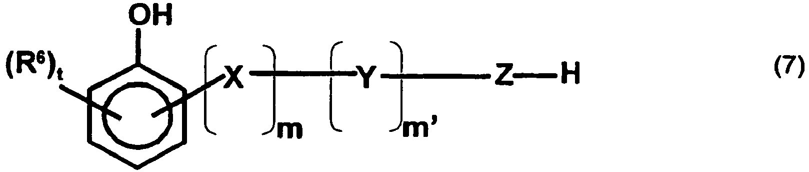 or 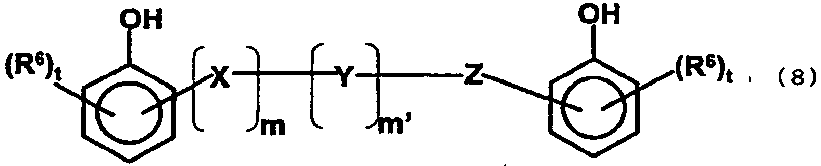 (where R⁶ represents hydrogen or a monovalent substituent having 1 to 3 carbon atoms, t represents an integer from 0 to 4, m and m' are each independently 1 to 74, m+m' is more than 10 to less than 75, and Z represents one of X and Y).

In the epoxy resin composition according to the first aspect of the present invention, the epoxy resin (A) preferably contains at least one of a structural unit X', which is represented by the following general formula (9) obtained by epoxidation of a product by reaction between a phenol-based compound and a biphenyl isomer or a mixture of biphenyl isomers, and a structural unit Y', which is represented by the following general formula (10) obtained by epoxidation of a product by reaction between a phenol-based compound and a benzene isomer or an mixture of benzene isomers, the sum of the number of repetitions of the structural unit X' and the number of repetitions of the structural unit Y' being 0 to 10. The general formulas are as follows: 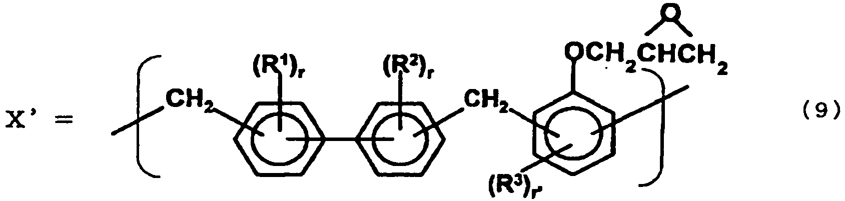 (where R¹, R², and R³ each independently represent hydrogen or a monovalent substituent having 1 to 3 carbon atoms, each r independently represents an integer from 0 to 4, and r' represents an integer from 0 to 3); and 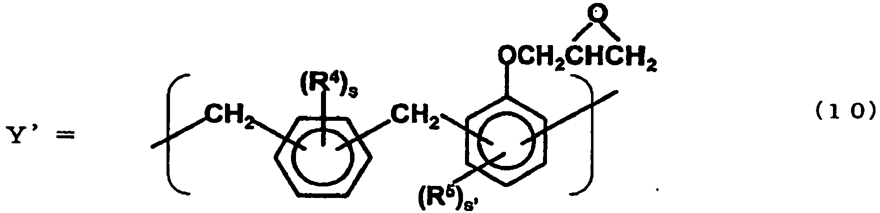 (where R⁴ and R⁵ represent hydrogen or a monovalent substituent having 1 to 3 carbon atoms, s represents an integer from 0 to 4, and s' represents an integer from 0 to 3).

That is, the epoxy resin composition according to the first aspect of the present invention comprises the epoxy resin (A) and the epoxy-resin curing agent (A) as the essential components, and the epoxy-resin curing agent (B) preferably contains an epoxy compound (G) represented by one of the following general formulas (11) to (16): 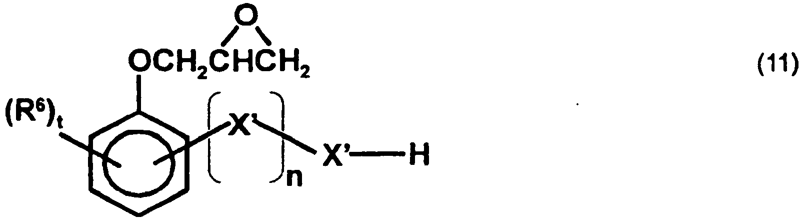 or 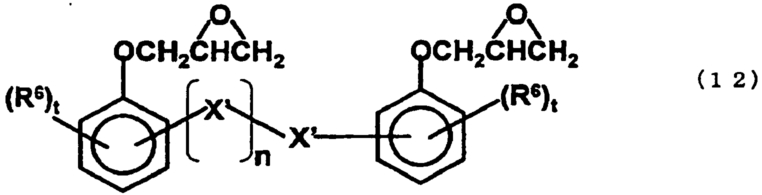 (where R⁶ represents hydrogen or a monovalent substituent having 1 to 3 carbon atoms, t represents an integer from 0 to 4, and n is 0 to 10); 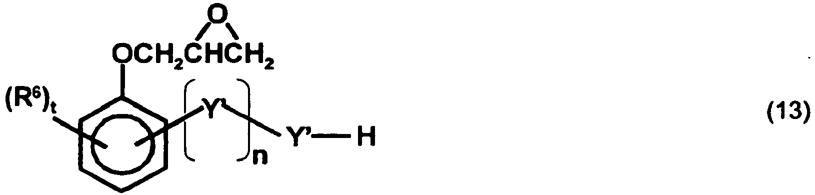 or 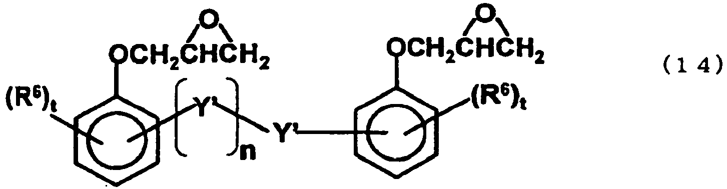 (where R⁶ represents hydrogen or a monovalent substituent having 1 to 3 carbon atoms, t represents an integer from 0 to 4, and n is 0 to 10); and 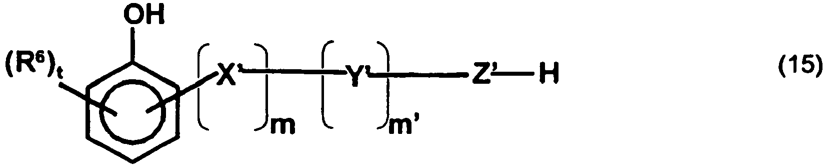 or 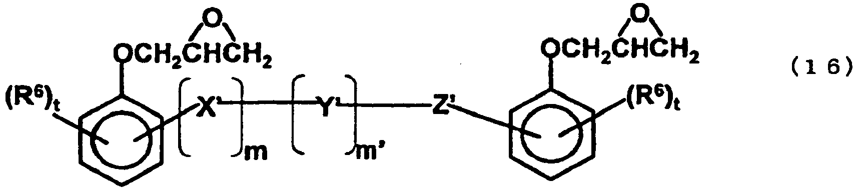 (where R⁶ represents hydrogen or a monovalent substituent having 1 to 3 carbon atoms, t represents an integer from 0 to 4, m and m' are each independently 1 to 9, m+m' is 1 to 10, and Z' represents one of X' and Y').

In accordance with a second aspect of the present invention, there is provided an epoxy resin composition comprising: an epoxy resin (A); and an epoxy-resin curing agent (B), the epoxy resin (A) containing at least one of a structural unit X', which is represented by the following general formula (9), and a structural unit Y', which is represented by the following general formula (10), the sum of the number of repetitions of the structural unit X' and the number of repetitions of the structural unit Y' being more than 10 to less than 75. The general formulas are as follows: 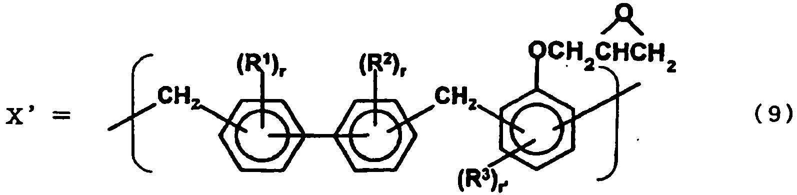 (where R¹, R², and R³ each independently represent hydrogen or a monovalent substituent having 1 to 3 carbon atoms, each r independently represents an integer from 0 to 4, and r' represents an integer from 0 to 3); and 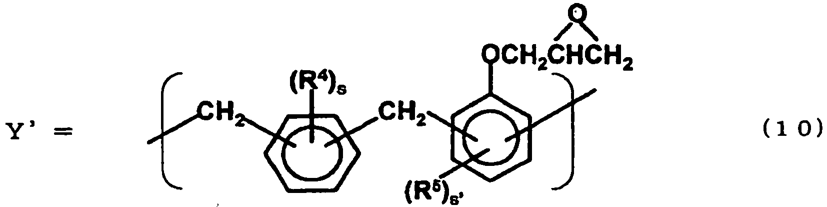 (where R⁴ and R⁵ represent hydrogen or a monovalent substituent having 1 to 3 carbon atoms, s represents an integer from 0 to 4, and s' represents an integer from 0 to 3).

In the epoxy resin composition according to the second aspect of the present invention, the epoxy-resin curing agent (B) preferably contains at least one of a structural unit X, which is represented by the following general formula (1) obtained by reaction between a phenol-based compound and a biphenyl isomer or a mixture of biphenyl isomers, and a structural unit Y, which is represented by the following general formula (2) obtained by reaction between a phenol-based compound and a benzene isomer or an mixture of benzene isomers, the sum of the number of repetitions of the structural unit X and the number of repetitions of the structural unit Y being 0 to 10. The general formulas are as follows: 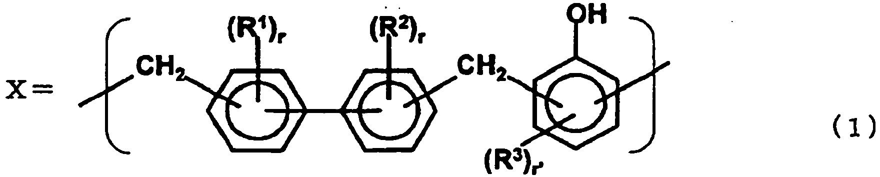 (where R¹, R², and R³ each independently represent hydrogen or a monovalent substituent having 1 to 3 carbon atoms, r represents an integer from 0 to 4, and r' represents an integer from 0 to 3); and 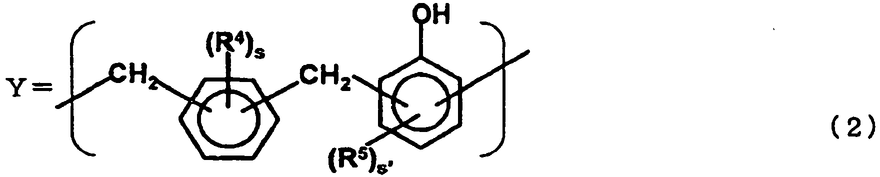 (where R⁴ and R⁵ each independently represent hydrogen or a monovalent substituent having 1 to 3 carbon atoms, s represents an integer from 0 to 4, and s' represents an integer from 0 to 3).

In addition, the epoxy resin composition described above preferably contains an inorganic filler (C).

In the epoxy resin compositions according to the first and the second aspects of the present invention, the inorganic filler (C) is preferably aluminum hydroxide.

In the epoxy resin compositions according to the first and the second aspects of the present invention, a 50 mass% average particle diameter (D₅₀) of the aluminum hydroxide (C') is preferably 0.5 to 20 µm.

In accordance with a third aspect of the present invention, there is provided an epoxy resin composition comprising: an epoxy resin (A), an epoxy-resin curing agent (B); and aluminum hydroxide (C'), wherein the epoxy resin (A) is an epoxy resin containing at least one of an epoxy compound X' represented by the following general formula (9) and an epoxy compound Y' represented by the following general formula (10), the epoxy-resin curing agent (B) is a phenol resin containing at least one of a structural unit X represented by the following general formula (1) and a structural unit Y represented by the following general formula (2), and the aluminum hydroxide (C') has a 50 mass% average particle diameter (D₅₀) of 1 to 10 µm. The general formulas are as follows: 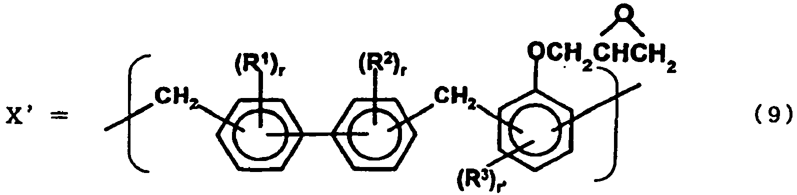 (where R¹, R², and R³ each independently represent hydrogen or a monovalent substituent having 1 to 3 carbon atoms, each r independently represents an integer from 0 to 4, and r' represents an integer from 0 to 3); 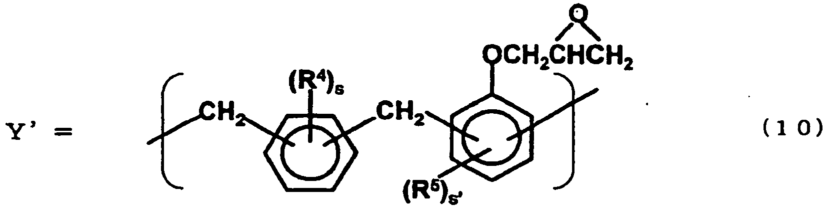 (where R⁴ and R⁵ represent hydrogen or a monovalent substituent having 1 to 3 carbon atoms, s represents an integer from 0 to 4, and s' represents an integer from 0 to 3); 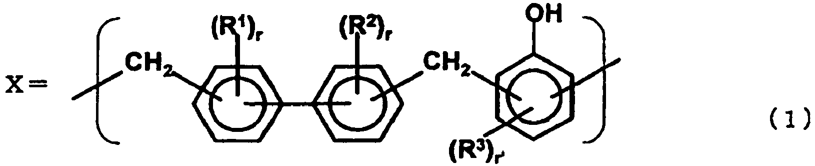 (where R¹, R², and R³ each independently represent hydrogen or a monovalent substituent having 1 to 3 carbon atoms, each r independently represents an integer from 0 to 4, and r' represents an integer from 0 to 3); and 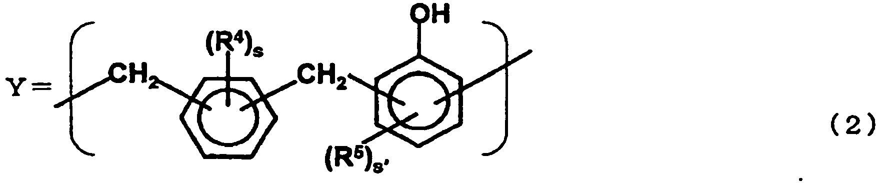 (where R⁴ and R⁵ each independently represent hydrogen or a monovalent substituent having 1 to 3 carbon atoms, s represents an integer from 0 to 4, and s' represents an integer from 0 to 3).

Next, in accordance with a fourth aspect of the present invention, there are provided the following materials using the above epoxy resin compositions.

According to the fourth aspect of the present invention, for example, there are provided a varnish solution formed by dissolving or dispersing the above epoxy resin composition in an organic solvent, a resin sheet (prepreg material) in a semi-cured state which is obtained by a process comprising the steps of impregnating a base material with this varnish solution, and then removing the solvent therefrom; a laminate using this prepreg material; a laminate formed by laminating a copper foil on one surface of the above laminate; and a copper foil provided with a resin, obtained by applying the epoxy resin composition onto a surface of the copper foil.

In accordance with a fifth aspect of the present invention, there is provided a printed circuit board composed of at least two selected from the group consisting of the prepreg material, the laminate, the copper foil provided with a resin, and a copper foil.

The present invention realizes an epoxy resin composition for printed circuit boards, simultaneously having superior heat resistance and adhesion by containing both a phenolaralkyl type resin as the epoxy-resin curing agent, which has a larger repeating unit number (n or m+m') (higher molecular weight) than that of the preceding example and which has a molecular weight distribution in a specific range, and a phenolaralkyl type epoxy resin as the epoxy resin which has a specific molecular weight distribution (within that of the preceding example, and a lower molecular weight than that of the epoxy-resin curing agent which is to be used at the same time).

Furthermore, the present invention realizes an epoxy resin composition for printed circuit boards, simultaneously having superior heat resistance and adhesion by using a phenolaralkyl type resin as the epoxy-resin curing agent, which has a specific molecular weight distribution (within that of the preceding example, and a lower molecular weight than that of an epoxy resin which is to be used at the same time), and a phenolaralkyl epoxy resin as the epoxy resin which has a larger repeating unit number (n or m+m') (higher molecular weight) than that in the preceding example and which has a molecular weight distribution in a specific range.

The reason the epoxy resin composition of the present invention simultaneously has superior heat resistance (in particular, represented by the glass transition temperature) and superior adhesion (represented by adhesion between a copper foil and a cured prepreg material) has not been understood clearly. However, the mechanism has been construed as described below.

The mechanism simultaneously realizing superior heat resistance and adhesion will be described with reference to an epoxy resin composition by way of example, containing both a phenolaralkyl type resin as the epoxy-resin curing agent, which has a larger repeating unit number (n or m+m') (a higher molecular weight) than that of the preceding example and which has a molecular weight distribution in a specific range, and a phenolaralkyl type epoxy resin as the epoxy resin which has a specific molecular weight distribution (within that of the preceding example, and a lower molecular weight than that of the epoxy-resin curing agent which is to be used at the same time).

The epoxy-resin curing agent and the epoxy resin of the present invention have molecular structures similar to that of the phenolaralkyl type resin and that of the phenolaralkyl type epoxy resin in the preceding example, respectively. Hence, it is estimated that the degree of free volume present in the cured material of the epoxy resin composition of the present invention is approximately equivalent to that in the preceding example. However, in the cross-linking structure of the cured material of the present invention, owing to an effect of containing the phenolaralkyl type resin having a larger repeating unit number (n or m+m') (larger molecular weight) than that of the preceding example, during the step in which a cross-linking structure is being grown by reaction between this curing agent and the epoxy resin having a low molecular weight (within that of the preceding example), interlocking between molecular chains are very likely to occur.

As described above, although the cured material of the epoxy resin composition of the present invention has a free volume approximately equivalent to that of the preceding example, the intermolecular force caused by the interlocking of molecular chains is very strong. Hence, it is construed that in the present invention, by the effect obtained by the increase in intermolecular force, since the micro-Brownian motion of the cross-linking structure of the resin can be significantly suppressed, the glass transition temperature (Tg) of the cured material is significantly increased (formation of a higher Tg material).

Furthermore, in a cured material of a laminate composed of a copper foil and the prepreg material of the present invention, that is, in a copper-clad laminate, the increase in intermolecular force caused by the interlocking of molecular chains is also significantly effective to improve the adhesion between the copper foil and a cured resin material. In this embodiment, with reference to the case by way of example in which a mat surface (non-glossy surface) of a copper foil and a cured resin material is peeled away at the interface therebetween of a copper-clad laminate obtained by curing the prepreg material of the present invention with a copper foil by a heat press molding, the reason the epoxy resin composition of the present invention is significantly effective to improve the adhesion to a copper foil will be described.

As factors of the adhesion, there may be mentioned the anchor shape on the copper foil surface, formation of bonds between polar groups in the cured epoxy resin and the copper foil surface, flexibility of the cured epoxy resin, and melt fluidity of the epoxy resin composition, which has a considerable influence on the wettability to the copper foil surface. Among those mentioned above, the formation of bonds between polar groups in the cured epoxy resin and the copper foil surface may be ignored since the molecular structure of the present invention is similar to that of the preceding example. In addition, the anchor shape on the copper foil surface may also be ignored. Hence, as the factors having influence on the adhesion, the flexibility of the cured material of the epoxy resin composition (including the prepreg) and the melt fluidity of the epoxy resin composition (uncured) may only be taken into consideration.

A material having superior flexibility, defined in the present invention, has a larger amount of elongation, a lager amount of strain, and the like when being ruptured or broken, for example, in the case in which mechanical properties of two types of materials are compared with each other.

When the flexibility of the cured epoxy resin composition of the present invention and that of the preceding example are compared with each other, the cured material of the present invention is superior. That is, since the cross-linking structure of the cured material of the present invention contains a phenolaralkyl resin having a larger repeating unit number (n or m+m') (larger molecular weight) than that of the preceding example, while the cross-linking structure is grown by reaction between this curing agent and the epoxy resin having a low molecular weight (within the range of the preceding example), the interlocking is very likely to occur between molecular chains. When a tensile stress is applied to the cured material of the present invention, the entire cured material is deformed since this interlocking between the molecular chains is loosened. Accordingly, compared to the cured material of the preceding example in which the interlocking between the molecular chains is not present, the amount of deformation (the amount of elongation in this case) until the bonds between the molecular chains are broken is considerably large.

With respect to a force (indicating a peeling force) for peeling a copper foil from the copper-clad laminate, since the laminate is also likely to follow the deformation of the copper owing to the effect of loosening the interlocking between molecular chains of the cured resin material of the laminate, it is construed that a superior adhesion to the copper foil can be obtained. Furthermore, owing to the higher molecular weight of the epoxy-resin curing agent, it has been estimated that the melt fluidity of the epoxy resin composition (uncured material), which is an important adhesion factor and which has significant influence on the wettability to a cooper foil surface, may be seriously degraded in some cases. That is, the higher molecular weight of the curing agent, which is effective to improve the flexibility of the cured material, may simultaneously serve as a factor of decreasing the fluidity. Hence, in the present invention, by using the epoxy-resin curing agent having a high molecular weight together with the epoxy resin having a low molecular weight (in the range of the preceding example), the decrease in melt fluidity of the epoxy resin composition is suppressed.

Accordingly, without degrading the wettability of the epoxy resin composition of the present invention to a copper foil surface, the flexibility of the cured material can be significantly improved as compared to that of the epoxy resin composition of the preceding example, and hence it is believed that a superior adhesion can be realized.

Owing to the n electron effect of aromatic derivatives (such as isomers of biphenyl and benzene) of the main chain of the resin, an epoxy resin composition has high orientation properties which is formed by simultaneously using a phenolaralkyl type resin of the preceding example containing a small repeating unit number (that is, n or m+m' is 0 to 10) and a phenolaralkyl type epoxy resin of the preceding example containing a small repeating unit number (that is, n or m+m' is 0 to 10), and the cross-linking structure is uniformly grown. Accordingly, the degree of interlocking of molecular chains is considerably low as compared to that of the resin composition of the present invention. However, since the free volume of the cured material is equivalent to that of the present invention, the micro-Brownian motion of the molecular chains is likely to occur. Hence, the glass transition temperature (Tg) is lower than that of the present invention. Furthermore, in this preceding example, the flexibility of the cured material is also insufficient, and hence the adhesion to the copper foil and the base material is also low as compared to that of the present invention.

Unlike the present invention, when a phenolaralkyl type curing agent and epoxy resin, both having a larger repeating unit number, that is, n or m+m' is more than 10, than that of the preceding example are simultaneously used for the epoxy-resin curing agent and the epoxy resin, respectively, since the curing insufficiently proceeds, and the melt fluidity is degraded, the heat resistance indicated by the glass transition temperature (Tg) and the adhesion to a copper foil are both degraded.

In the above example, the composition was described in which a higher molecular weight material is used for the epoxy-resin curing agent and a lower molecular weight material is used for the epoxy resin. However, also in the reverse case, superior heat resistance and adhesion equivalent to that described above can be obtained.

Accordingly, when a resin having a larger repeating unit number (higher molecular weight) than that of the preceding example is used for one of the epoxy-resin curing agent and the epoxy resin, and an epoxy resin or an epoxy-resin curing agent having a smaller repeating unit number (within that of the preceding example) than that described above is used, an epoxy resin composition for printed circuit boards can be provided simultaneously having superior heat resistance and adhesion.

### Brief Description of the Drawings

Fig. 1 is a graph showing the relationship between the molecular weight (Mw) of a phenol resin (F) and the glass transition temperature (Tg, °C) according to examples of the present invention; and
Fig. 2 is a graph showing the relationship between the molecular weight (Mw) of the phenol resin (F) and the adhesion (kN/m) according to examples of the present invention.

### Best Mode for Carrying Out the Invention

Hereinafter, the present invention will be described in detail.

The present invention contains an epoxy resin (A) and an epoxy-resin curing agent (B) as the essential components, the epoxy-resin curing agent (B) including a phenol resin (F) represented by one of the general formulas (3) to (8), the phenol resin (F) containing a structural unit X, which is represented by the following general formula (1) obtained by reaction between a phenol-based compound and a biphenyl isomer or a mixture of biphenyl isomers, or a structural unit Y, which is represented by the following general formula (2) obtained by reaction between a phenol-based compound and a benzene isomer or an mixture of benzene isomers.

The general formulas are as follows: 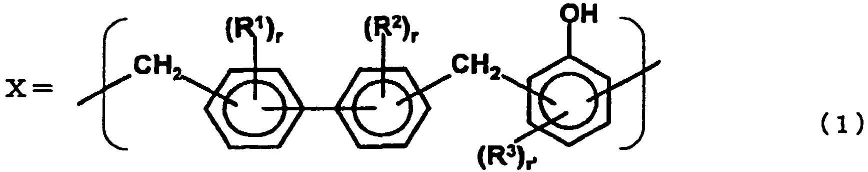 (where R¹, R², and R³ each independently represent hydrogen or a monovalent substituent having 1 to 3 carbon atoms, each r independently represents an integer from 0 to 4, and r' represents an integer from 0 to 3); 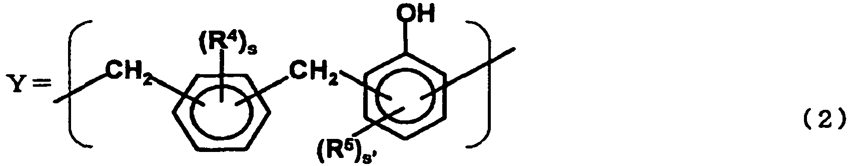 (where R⁴ and R⁵ each independently represent hydrogen or a monovalent substituent having 1 to 3 carbon atoms, s represents an integer from 0 to 4, and s' represents an integer from 0 to 3); 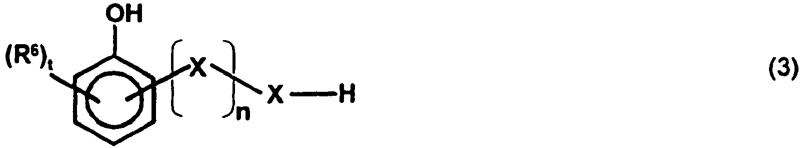 or 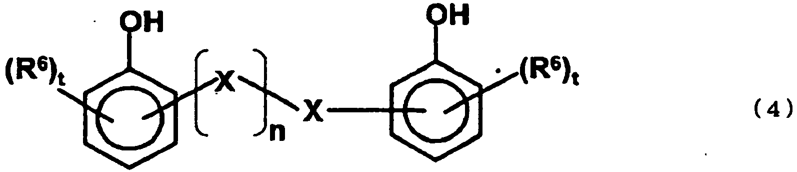 (where R⁶ represents hydrogen or a monovalent substituent having 1 to 3 carbon atoms, t represents an integer from 0 to 4, and n is more than 10 to less than 75); 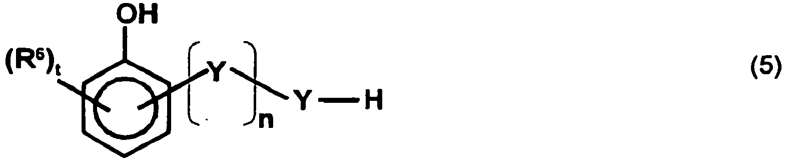 or 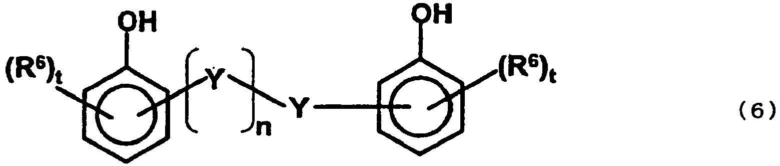 (where R⁶ represents hydrogen or a monovalent substituent having 1 to 3 carbon atoms, t represents an integer from 0 to 4, and n is more than 10 to less than 75); and 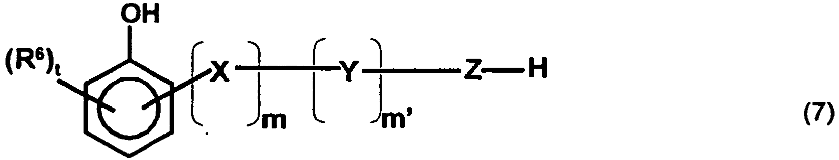 or 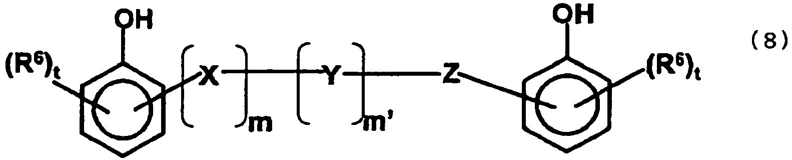 (where R⁶ represents hydrogen or a monovalent substituent having 1 to 3 carbon atoms, t represents an integer from 0 to 4, m and m' are each independently 1 to 74, m+m' is more than 10 to less than 75, and Z represents one of X and Y).

As the phenol resin (F) described above, a phenolbiphenylenearalkyl type resin, phenolxylylenearalkyl type resin, and a phenolaralkyl type resin simultaneously containing a biphenylene isomer and a benzene isomer in the structure thereof are mentioned.

Furthermore, as particular examples of the phenol resin (F), the following general formulas (17) to (20) are shown. However, the present invention is not limited thereto.

The general formulas are as follows: 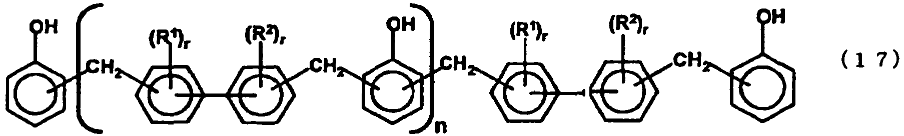 (where R¹ and R² each independently represent hydrogen or a monovalent substituent having 1 to 3 carbon atoms, r represents an integer from 0 to 4, and n is more than 10 to less than 75); 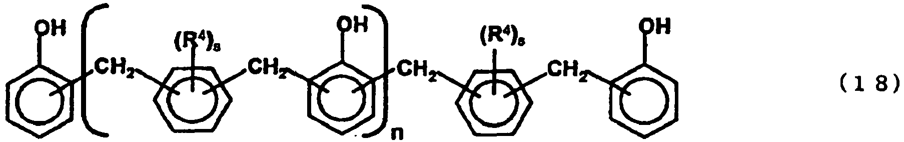 (where R⁴ represents hydrogen or a monovalent substituent having 1 to 3 carbon atoms, s represents an integer from 0 to 4, and n is more than 10 to less than 75); 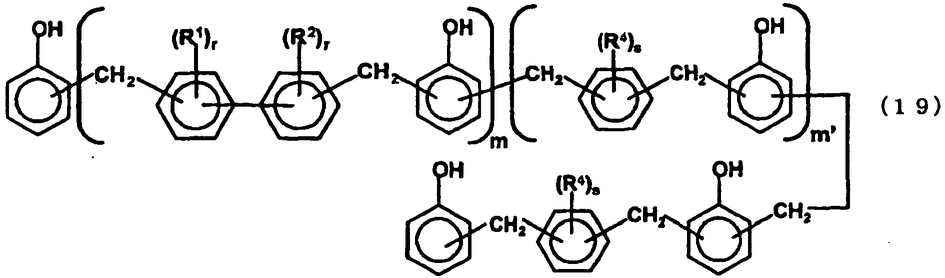 (where R¹, R², and R⁴ each independently represent hydrogen or a monovalent substituent having 1 to 3 carbon atoms, t represents an integer from 0 to 4, r and s each independently represent an integer from 0 to 4, and m+m' is more than 10 to less than 75); and 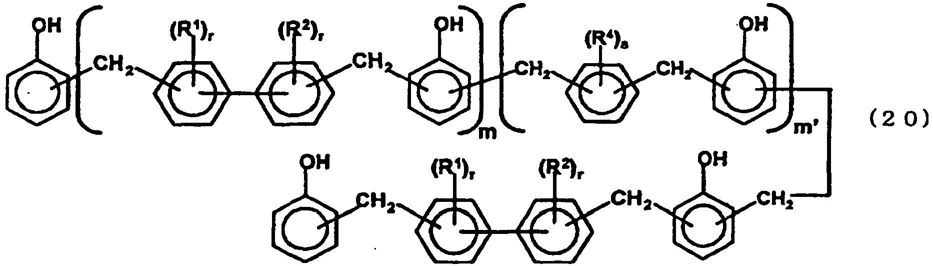 (where R¹, R², and R⁴ each independently represent hydrogen or a monovalent substituent having 1 to 3 carbon atoms, t represents an integer from 0 to 4, r and s each independently represent an integer from 0 to 4, and m+m' is more than 10 to less than 75).

In addition, when being used, the phenol resins (F) are not limited to one type, and more than two types thereof may be used in combination. Furthermore, a phenol resin (F') shown by one of the following general formulas (21) to (26) may also be used.

The general formulas are as follows: 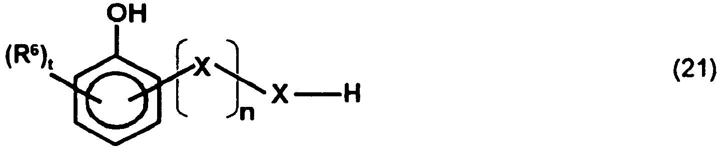 or 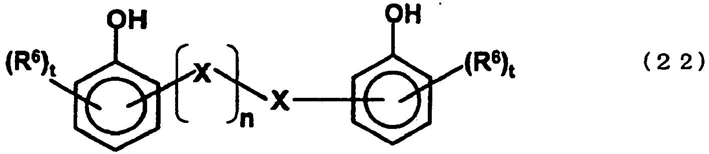 (where R⁶ represents hydrogen or a monovalent substituent having 1 to 3 carbon atoms, t represents an integer from 0 to 4, and n is 0 to 10); 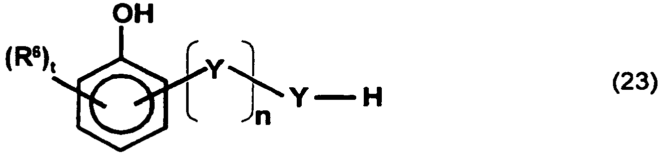 or 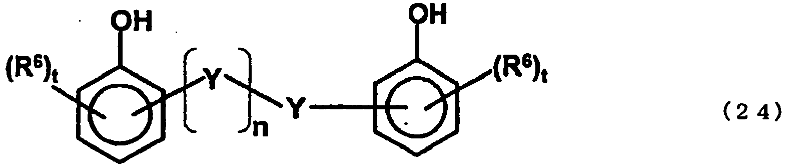 (where R⁶ represents hydrogen or a monovalent substituent having 1 to 3 carbon atoms, t represents an integer from 0 to 4, and n is 0 to 10); and 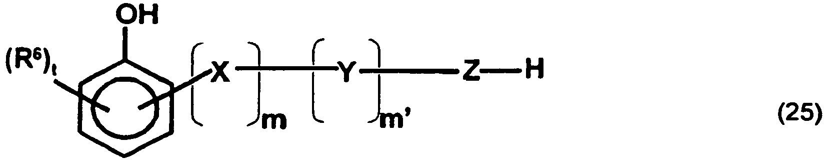 or 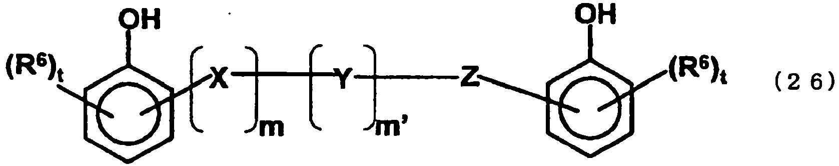 (where R⁶ represents hydrogen or a monovalent substituent having 1 to 3 carbon atoms, t represents an integer from 0 to 4, m and m' are each independently 1 to 9, m+m' is 1 to 10, and Z indicates X or Y).

As the phenol resin (F') described above, a phenolbiphenylenearalkyl type resin, a phenolxylylenearalkyl type resin, and a phenolaralkyl type resin simultaneously containing a biphenylene isomer and a benzene isomer in the structure thereof are mentioned.

Hereinafter, particular examples of the phenol resin (F') are shown by the following general formulas (27) to (30). However, the present invention is not limited to the examples below.

The general formulas are as follows: 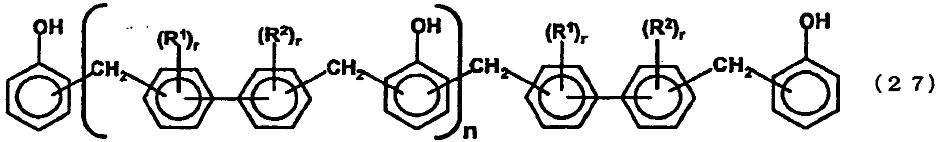 (where R¹ and R² each independently represent hydrogen or a monovalent substituent having 1 to 3 carbon atoms, r represents an integer from 0 to 4, and n is 0 to 10); 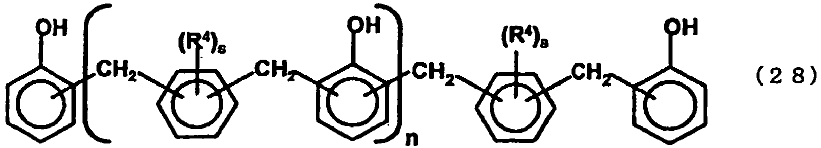 (where R⁴ represents hydrogen or a monovalent substituent having 1 to 3 carbon atoms, s represents an integer from 0 to 4, and n is 0 to 10); 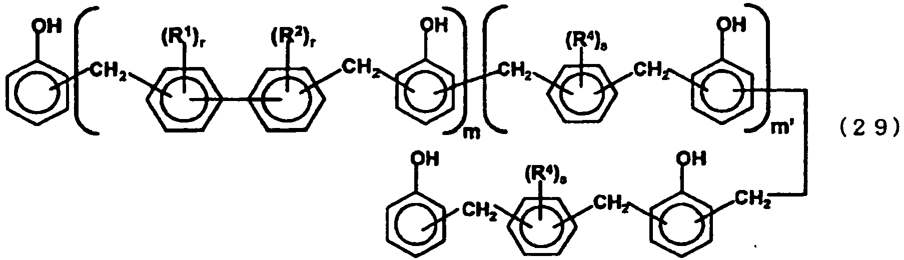 (where R¹, R², and R⁴ each independently represent hydrogen or a monovalent substituent having 1 to 3 carbon atoms, t represents an integer from 0 to 4, r and s each independently represent an integer from 0 to 4, and m+m' is 1 to 10); and 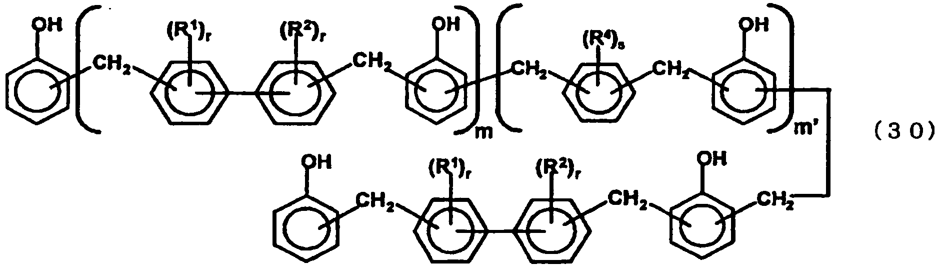 (where R¹, R², and R⁴ each independently represent hydrogen or a monovalent substituent having 1 to 3 carbon atoms, t represents an integer from 0 to 4, r and s each independently represent an integer from 0 to 4, and m+m' is 1 to 10).

Furthermore, when the phenol resin (F) of the present invention has a weight average molecular weight (Mw) of 3,000 to 15,000 represented by polystyrene conversion, since the interlocking effect of the molecular chains in a cured material is superior, and the melt fluidity of the epoxy resin composition is also superior, the above phenol resin is significantly effective to improve the heat resistance indicated by the glass transition temperature and the adhesion to a copper foil. On the other hand, when a component (F_{-3,000}) having an equivalent structure to that of the phenol resin (F) and having a Mw of less than 3,000 is used, the melt fluidity of an epoxy resin composition containing the above component is superior. However, since the interlocking effect of the molecular chains is low, a sufficient heat resistance (indicated by the glass transition temperature) cannot be achieved. In addition, since a component (F_{+15,000}) having an equivalent structure to that of the phenol resin (F) and having a Mw of more than 15,000 is gelled by itself, the synthesis thereof is difficult, and in addition, an epoxy resin composition containing this component has very low melt fluidity, the wettability to a copper foil or a base material is degraded, and as a result, sufficient adhesion may not be obtained in some cases.

Incidentally, the weight average molecular weight represented by polystyrene conversion indicates an average molecular weight obtained by a GPC method (Gel Permeation Chromatography), one type of liquid chromatography, in which isolation is performed based on the difference in molecular size.

In the present invention, when the phenol resin (F) is contained in the epoxy-resin curing agent (B), an epoxy compound (G) is necessarily contained in the epoxy resin (A), which is represented by one of the following general formulas (11) to (16), containing at least one of the an epoxy compound X' represented by the above general formula (9) and an epoxy compound Y' represented by the above general formula (10).

The general formulas are as follows: 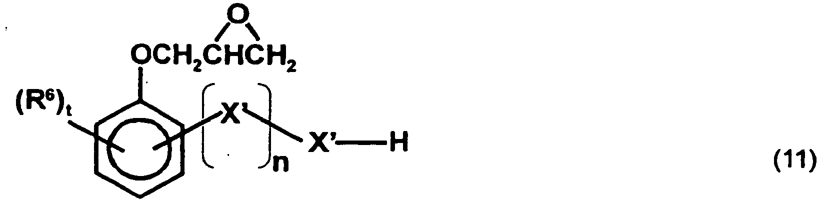 or 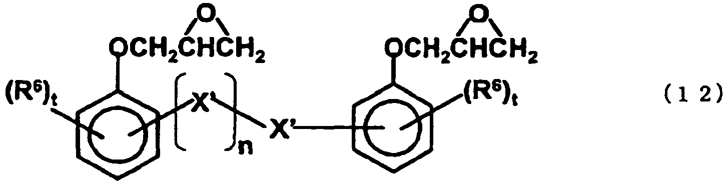 (where R⁶ represents hydrogen or a monovalent substituent having 1 to 3 carbon atoms, t represents an integer from 0 to 4, and n is 0 to 10): 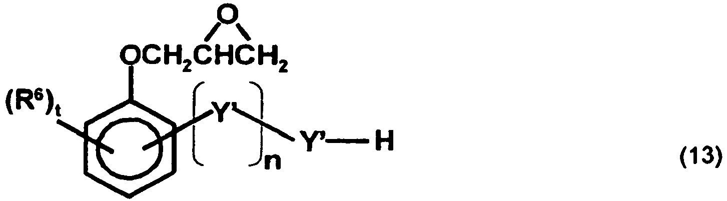 or 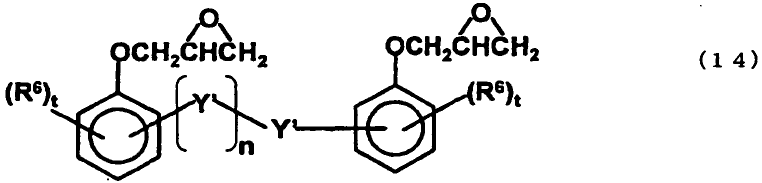 (where R⁶ represents hydrogen or a monovalent substituent having 1 to 3 carbon atoms, t represents an integer from 0 to 4, and n is 0 to 10): and 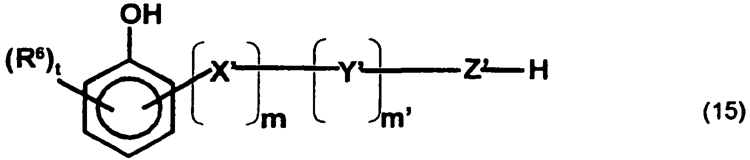 or 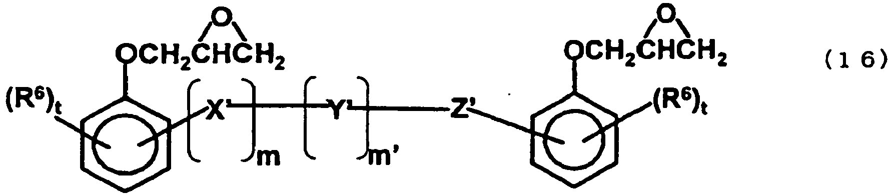 (where R⁶ represents hydrogen or a monovalent substituent having 1 to 3 carbon atoms, t represents an integer from 0 to 4, m and m' are each independently 1 to 9, m+m' is 1 to 10, and Z' is one of X' and Y').

As the epoxy compound (G) described above, a phenolbiphenylenearalkyl type epoxy resin, a phenolxylylenearalkyl type epoxy resin, and a phenolaralkyl type epoxy resin simultaneously containing a biphenylene isomer and a benzene isomer are mentioned.

In addition, when being used, the above epoxy resins may be used alone or in combination.

Hereinafter, as particular examples of the epoxy resin (G), the following general formulas (31) to (34) are shown. However, the present invention is not limited thereto.

The general formulas are as follows: 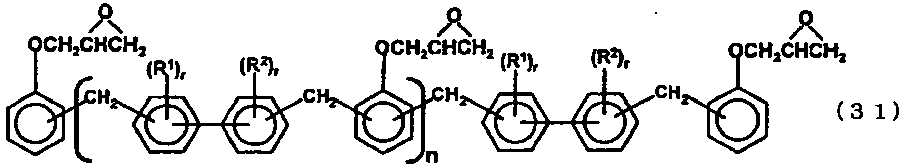 (where R¹ and R² each independently represent hydrogen or a monovalent substituent having 1 to 3 carbon atoms, r represents an integer from 0 to 4, and n is 0 to 10): 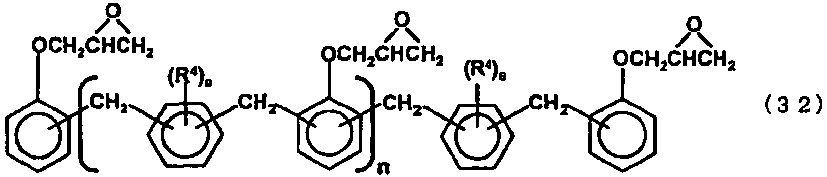 (where each R⁴ independently represents hydrogen or a monovalent substituent having 1 to 3 carbon atoms, s represents an integer from 0 to 4, and n is 0 to 10): 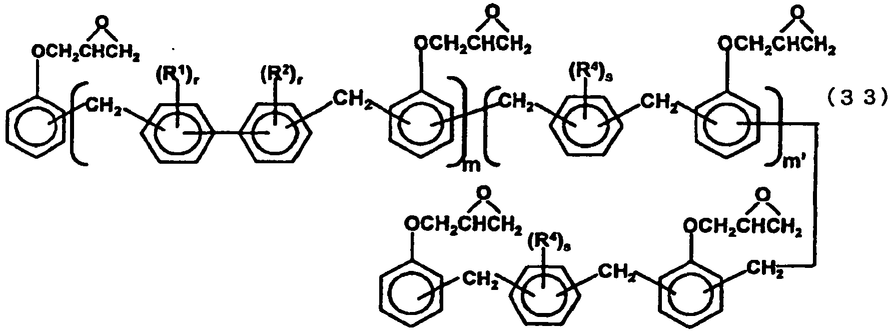 (where R¹, R² and R⁴ each independently represent hydrogen or a monovalent substituent having 1 to 3 carbon atoms, r and s each independently represent an integer from 0 to 4, and m or m' is 1 to 10): and 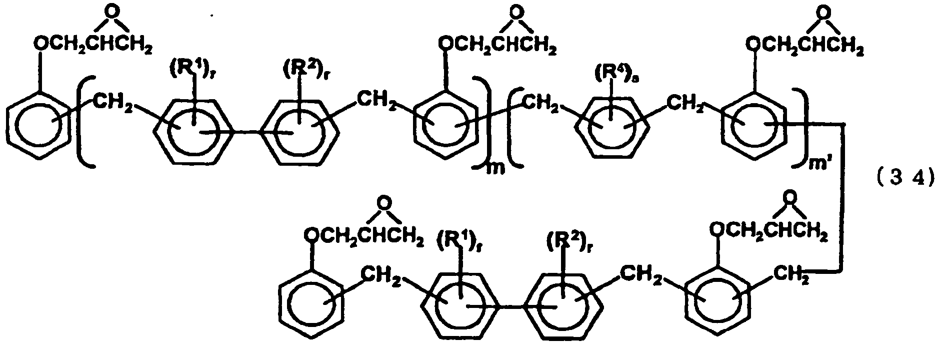 (where R¹, R² and R⁴ each independently represent hydrogen or a monovalent substituent having 1 to 3 carbon atoms, r and s each independently represent an integer from 0 to 4, and m or m' is 1 to 10).

When the epoxy resin (G) of the present invention has a weight average molecular weight (Mw) of 700 to 3,000 represented by polystyrene conversion, it is preferable since an epoxy resin composition containing the epoxy compound (G) and the phenol resin (F) as the essential components has superior fluidity and workability. On the other hand, when a component (F₋₇₀₀) having an equivalent structure to that of the epoxy compound (G) and having a Mw of less than 700, the melt fluidity of an epoxy resin composition containing the above component is superior. However, since the crystallinity itself is high, and even after being dissolved in a solvent at a high temperature, the epoxy resin composition is recrystallized when the temperature is returned to room temperature. Hence, as a result, a uniform composition may not be obtained in some cases. In order to inhibit the crystallization of the component (G₋₇₀₀), when a biphenyl isomer or a benzene isomer is changed to an isomer other than a 4,4'-compound and a para-isomer, the free volume is increased, and the glass transition temperature is considerably decreased. In addition, when a component (G_{+3,000}) having an equivalent structure to that of the epoxy compound (G) and having a Mw of more than 3,000 is used, since the melt fluidity of an epoxy resin composition containing this component and the phenol resin (F) is seriously decreased, the wettability to a copper foil is degraded, and sufficient adhesion thereto may not be obtained in some cases.

In addition, in the present invention in which the phenol resin (F) and the epoxy resin (G) are contained as the essential components, when the total amount of the phenol resin (F) represented by one of the above general formulas (3) to (8) and the phenol resin (F') represented by one of the above general formulas (21) to (26) is 60 percent by mass or more to the total amount of the epoxy-resin curing agent (B), it is particularly preferable since a cured material of the epoxy resin composition of the present invention has superior flame retardant properties and adhesion to a copper foil. In this case, the reason the flame retardant properties of the epoxy resin composition of the present invention is superior is believed that since a foaming layer is formed in ignition, a heat insulating effect can be easily obtained. Furthermore, when the total amount of the phenol resin (F) and the phenol resin (F') is 80 percent by mass or more, it is preferable since the flame retardant properties are further improved.

Furthermore, in the present invention in which the phenol resin (F) and the epoxy resin (G) are contained as the essential components, when 60 percent by mass or more of the epoxy resin (G) represented by one of the general formulas (11) to (16) is contained relative to the total amount of the epoxy resin (A), it is particularly preferable since a cured material of the epoxy resin composition of the present invention has superior flame retardant properties and adhesion to a copper foil. It is believed that since the cured material of the epoxy resin composition containing 60 percent by mass or more of the total amount of the epoxy resin (G) forms a foaming layer in ignition, a heat insulating effect can be easily obtained. Furthermore, when the amount of the epoxy resin (G) is 80 percent by mass or more of the total amount of the epoxy resin (A), it is preferable since the flame retardant properties are further improved.

In addition, a second epoxy resin composition of the present invention contains an epoxy resin (A) and an epoxy-resin curing agent (B) as the essential components, in which the epoxy compound (A) contains an epoxy compound (H) represented by one of the following general formulas (35) to (40), which contains at least one of an epoxy compound X' represented by the above general formula (9) and an epoxy compound Y' represented by the above general formula (10).

The general formulas are as follows: 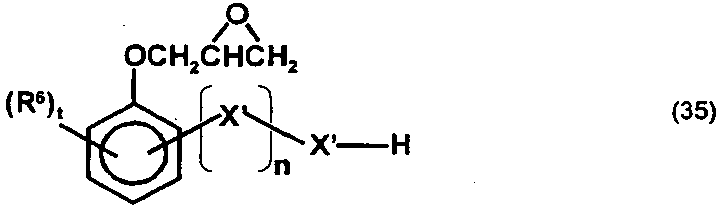 or 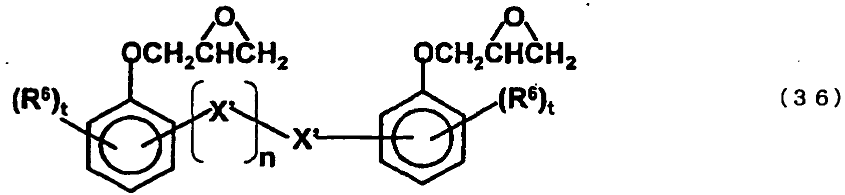 (where R⁶ represents hydrogen or a monovalent substituent having 1 to 3 carbon atoms, t represents an integer from 0 to 4, and n is more than 10 to less than 75): 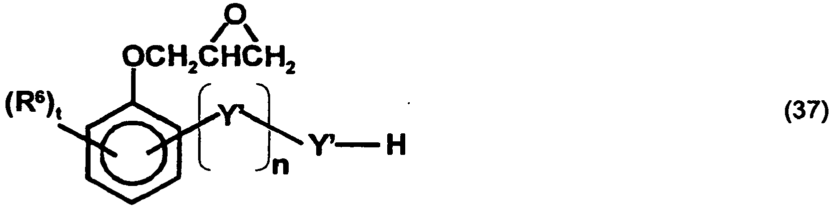 or 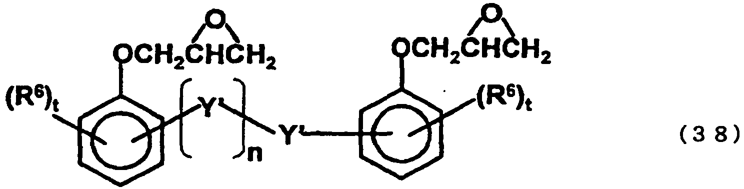 (where R⁶ represents hydrogen or a monovalent substituent having 1 to 3 carbon atoms, t represents an integer from 0 to 4, and n is more than 10 to less than 75): and 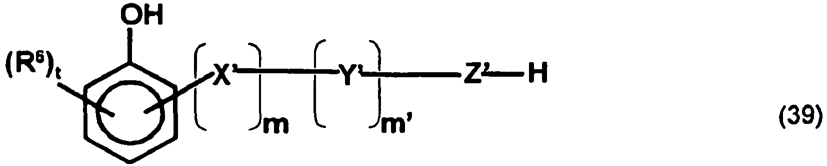 or 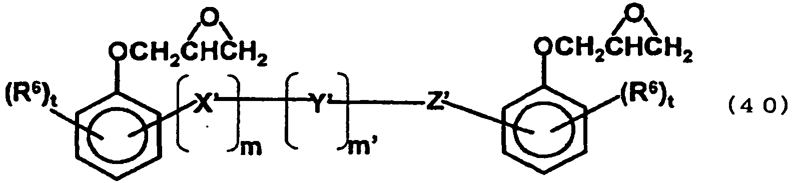 (where R⁶ represents hydrogen or a monovalent substituent having 1 to 3 carbon atoms, t represents an integer from 0 to 4, m and m' are each independently 1 to 74, m+m' is more than 10 to less than 75, and Z' is one of X' and Y').

As the epoxy compound (H) described above, a phenolbiphenylenearalkyl type epoxy resin, a phenolxylylenearalkyl type epoxy resin, and a phenolaralkyl type epoxy resin simultaneously containing a biphenylene isomer and a benzene isomer in the structure thereof are mentioned.

In addition, the epoxy resins mentioned above may be used alone or in combination.

Hereinafter, as particular examples of the epoxy resin (H), the following general formulas (41) to (44) are shown. However, the present invention is not limited thereto.

The general formulas are as follows: 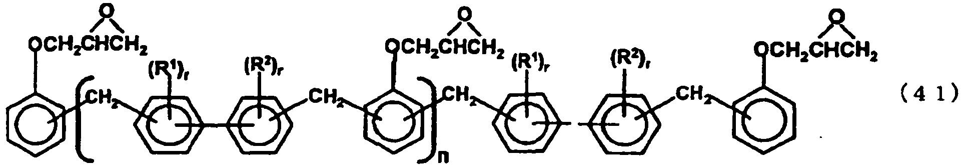 (where R¹ and R² each independently represent hydrogen or a monovalent substituent having 1 to 3 carbon atoms, r represents an integer from 0 to 4, and n is more than 10 to less than 75): 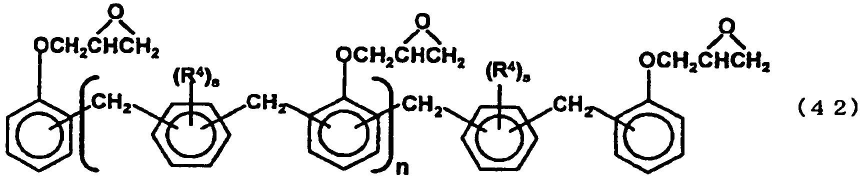 (where each R⁴ independently represents hydrogen or a monovalent substituent having 1 to 3 carbon atoms, s represents an integer from 0 to 4, and n is more than 10 to less than 75): 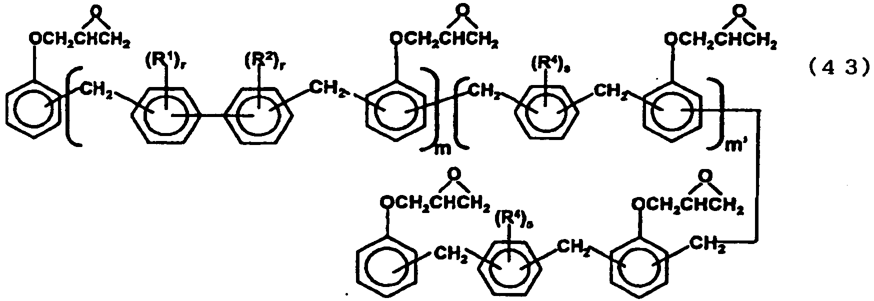 (where R¹, R², and R⁴ each independently represent hydrogen or a monovalent substituent having 1 to 3 carbon atoms, r and s each independently represent an integer from 0 to 4, and m or m' is more than 10 to less than 75): and 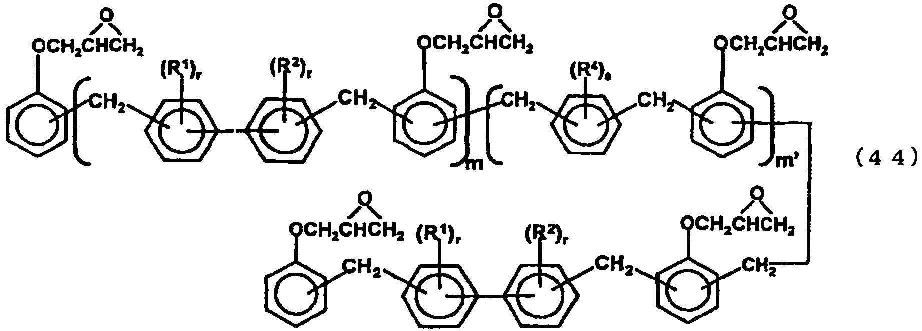 (where R¹, R², and R⁴ each independently represent hydrogen or a monovalent substituent having 1 to 3 carbon atoms, r and s each independently represent an integer from 0 to 4, and m or m' is more than 10 to less than 75).

When the epoxy resin (H) of the present invention has a weight average molecular weight (Mw) of 3,000 to 20,000 represented by polystyrene conversion, superior interlocking effect of molecular chains in the cured material and superior melt fluidity of the epoxy resin composition can be simultaneously obtained, and hence improvement in heat resistance indicated by the glass transition temperature and improvement in adhesion to a copper foil can be very effectively achieved. On the other hand, when a component (H_{-3,000}) having an equivalent structure to that of the epoxy compound (H) and having a Mw of less than 3,000, the melt fluidity of an epoxy resin composition containing the above component is superior. However, since the degree of interlocking of molecular chains is low, a sufficient heat resistance (represented by the glass transition temperature) cannot be achieved. In addition, in a component (H_{-20,000}) having an equivalent structure to that of the epoxy resin (H) and having a Mw of more than 20,000, it is difficult to remove sodium chloride as a byproduct derived from a catalyst, and the manufacturing itself cannot be easily performed. Furthermore, an epoxy resin composition containing the epoxy resin (H_{+20,000}) has very low melt fluidity and has inferior wettability to a copper foil and a base material, and hence the adhesion may also be insufficient in some cases.

Furthermore, when the epoxy resin (H) is contained in the epoxy resin (A), the epoxy-resin curing agent (B) contains the phenol resin (F') represented by one of the above general formulas (21) to (26).

In addition, as the phenol resin (F'), there are mentioned a phenolbiphenylenearalkyl type epoxy resin, a phenolxylylenearalkyl type epoxy resin, and a phenolaralkyl type epoxy resin simultaneously containing a biphenylene isomer and a benzene isomer in the structure.

In addition, the phenol resins mentioned above may be used alone or in combination.

As the phenol resin (F'), the above general formulas (28) to (30) may be shown by way of example. However, the present invention is not limited thereto.

Furthermore, when the phenol resin (F') of the present invention has a weight average molecular weight (Mw) of 450 to 1,500 represented by polystyrene conversion, it is more preferable since an epoxy resin composition containing the phenol resin (F') and the above epoxy resin (H) as the essential components has superior fluidity and workability. On the other hand, when a component (F'₋₄₅₀) having an equivalent structure to that of the phenol resin (F') and having a Mw of less than 450 is used, the melt fluidity of an epoxy resin composition containing the above component is superior. However, since the crystallinity itself is high, and even after being dissolved in a solvent at a high temperature, the epoxy resin composition is recrystallized when the temperature is returned to room temperature, and as a result, a uniform composition may not be obtained in some cases. In order to inhibit the crystallization of the component (F'₋₄₅₀), when a biphenyl isomer or a benzene isomer in the (F'₋₄₅₀) component is changed to an isomer other than a 4,4'-compound and a para-isomer, the free volume is increased, and the glass transition temperature is considerably decreased. In addition, when a component (F_{+1,500}) having an equivalent structure to that of the phenol resin (F') and having a Mw of more than 1,500 is used, since the melt fluidity of an epoxy resin composition containing this component and the epoxy resin (H) is seriously degraded, the wettability to a copper foil is degraded, and sufficient adhesion may not be obtained in some cases.

In addition, in the present invention in which the phenol resin (F') and the epoxy resin (H) are contained as the essential components, when the total amount of the epoxy resin (H) represented by one of the above general formulas (35) to (40) and the epoxy resin (G) represented by one of the above general formulas (11) to (16) is 60 percent by mass or more relative to the total amount of the epoxy resin (A), it is particularly preferable since a cured material of the epoxy resin composition of the present invention has significantly superior flame retardant properties and adhesion to a copper foil surface which is processed by blackening treatment. In this case, the reason the flame retardant properties of the epoxy resin composition of the present invention is superior is believed that since a foaming layer is formed in ignition, a heat insulating effect can be easily obtained. Furthermore, when the total amount of the epoxy resin (H) and the epoxy resin (G) is 80 percent by mass or more relative to the total amount of the epoxy resin (A), it is preferable since the flame retardant properties are further improved.

Furthermore, in the present invention in which the phenol resin (F') and the epoxy resin (H) are contained as the essential components, when 60 percent by mass or more of the phenol resin (F') represented by one of the above general formulas (21) to (26) is contained relative to the total amount of the epoxy-resin curing agent (B), it is particularly preferable since a cured material of the epoxy resin composition of the present invention has significantly superior flame retardant properties and adhesion to a copper foil surface which is processed by blackening treatment. The reason for this is believed that since the cured material of the epoxy resin composition containing 60 percent by mass or more of the phenol resin (F') forms a foaming layer in ignition, a heat insulating effect can be easily obtained. Furthermore, when the amount of the phenol resin (F') is 80 percent by mass or more relative to the total amount of the epoxy-resin curing agent (B), it is preferable since the flame retardant properties are further improved.

In addition, the first and the second epoxy resin compositions of the present invention may contain an inorganic filler material (C).

In the present invention, as the inorganic filler material (C), known filler materials may be used. However, various metal hydrates are preferably used which include metal hydrates such as aluminum hydroxide and magnesium hydroxide, surface-treated aluminum hydroxide and magnesium hydroxide which are processed with various organic materials such as an epoxy resin and a phenol resin, and a solid solution of magnesium hydroxide or the like incorporating a metal and having improved acid resistance. Furthermore, among those mentioned above, since being superior in chemical resistance, aluminum hydroxide is suitably used for printed circuit boards, and of various types of aluminum hydroxides, a material containing a small amount of sodium is particularly preferable since also having superior solder heat resistance.

Furthermore, in the present invention, in the case in which aluminum hydroxide is used as the inorganic filler material (C), when the 50 mass% average particle diameter (D₅₀) of aluminum hydroxide is in the range of 0.5 to 20 µm, it is preferable since the effect of improving adhesion is superior.

In addition, in the present invention, when the 50 mass% average particle diameter (D₅₀) of aluminum hydroxide is in the range of 1 to 10 µm, it is preferable since the effect of improving adhesion is more superior.

That is, when the 50 mass% average particle diameter (D₅₀) of aluminum hydroxide is less than 1 µm, the viscosity of an epoxy resin composition containing the aluminum hydroxide is increased, and the wettability to a copper foil may probably be degraded. As a result, the adhesion may not be sufficient in some cases. In addition, when the 50 mass% average particle diameter of aluminum hydroxide is more than 10 µm, since the aluminum hydroxide may not be sufficiently dispersed in the epoxy resin composition, and as a result, the solder heat resistance may be degraded in some cases.

In addition, a third epoxy resin composition of the present invention contains an epoxy resin (A), an epoxy-resin curing agent (B), and aluminum hydroxide as the essential components; the epoxy resin (A) is an epoxy resin containing at least one epoxy compound X' represented by the above general formula (6) and an epoxy compound Y' represented by the above general formula (7); the epoxy-resin curing agent (B) is a phenol resin containing at least one of a structural unit X represented by the above general formula (1) and a structural unit Y represented by the above general formula (2); and the 50 mass% average particle diameter (D₅₀) of the aluminum hydroxide is in the range of 1 to 10 µm.

Furthermore, when the specific surface area of aluminum hydroxide is more than 0.05 to less than 2 m²/g, it is particularly preferable since the fluidity of the epoxy resin composition is further improved (wettability to a copper foil surface is improved), and the adhesion to a copper foil is further improved.

In addition, when the mass ratio (W) of the aluminum hydroxide is more than 15 to less than 50 percent by mass relative to the total of the epoxy resin (A), the epoxy-resin curing agent (B), and the inorganic filler material (C), it is more preferable since the epoxy resin composition of the present invention has superior flame retardant properties and solder heat resistance besides the heat resistance and the adhesion.

Furthermore, when the mass ratio (W) of the aluminum hydroxide is 20 to 45 percent by mass, it is particularly preferable. That is, when the W is less than 20 percent by mass, although the adhesion is superior, a sufficient endothermic effect caused by decomposition of the aluminum hydroxide and a sufficient filler filling effect (in particular, the viscosity of the epoxy resin composition is increased in burning) cannot be obtained, and as a result, the flame retardant properties may be degraded in some cases. In addition, when the W is more than 45 percent by mass, at a high temperature at which lead free solder or the like is used, the aluminum hydroxide is decomposed, and as a result, the solder heat resistance may be degraded in some cases.

Furthermore, as an inorganic filler material other than the metal hydrates, for example, there may be mentioned a powder composed, for example, of fused silica, crystalline silica, alumina, zircon, calcium silicate, calcium carbonate, silicon carbide, silicon nitride, boron nitride, beryllia, talc, mica, titanium oxide, or zirconia; spherical shaped beads formed of the above mentioned powder; or single crystal fibers of calcium titanate, silicon carbide, silicon nitride, boron nitride, alumina or the like. The inorganic filler materials mentioned above may be used alone or in combination. As described above, as another inorganic filler material to be used together with aluminum hydroxide (Mohs hardness: 3), which is a particularly favorable metal hydrate, when a powder such as talc (Mohs hardness: 1) or mica (Mohs hardness: 3) having a low hardness is used, it is particularly preferable since printed circuit boards also have superior workability.

In the present invention, an epoxy resin contained in the epoxy resin (A) other than the epoxy compound (G) represented by one of the above general formulas (8) to (10) and the epoxy compound (H) represented by one of the above general formulas (29) to (31) is not particularly limited. For examples, there may be mentioned a bisphenol A type epoxy resin, bisphenol F type epoxy resin, bisphenol S type epoxy resin, biphenyl type epoxy resin, naphthalenediol type epoxy resin, phenol novolac epoxy resin, cresol novolac epoxy resin, phenol diphenyl ether aralkyl type epoxy resin, naphthalene-containing novolac type epoxy resin, anthracene-containing novolac type epoxy resin, fluorene-containing novolac type epoxy resin, bisphenol fluorene-containing novolac type epoxy resin, bisphenol F-containing novolac type epoxy resin, bisphenol A-containing novolac type epoxy resin, phenol biphenyl triazine type epoxy resin, phenol xylylene triazine type epoxy resin, phenol triazine type epoxy resin, triglycidyl isocyanate, tetraphenylolethane type epoxy resin, trisphenylolethane type epoxy resin, polyphenol type epoxy resin, aliphatic epoxy resin, aromatic ester type epoxy resin, alicyclic ester type epoxy resin and ether ester type epoxy resin. In addition, a glycidylated amine compound such as a polyamide elastomer, diaminodiphenylmethane, diethylenetriamine, diaminodiphenylsulfone or the like, which has a functional group reactive with an epoxy resin, may also be used. These epoxy resins may be used alone or in combination. Although some of the above compounds may improve properties, such as the heat resistance or the adhesion, or degrades the flame retardant properties as compared to the case in which the epoxy compound (G) and the epoxy compound (H) are only used, in accordance with properties required in application of printed circuit boards, an optional material may be selected from the above epoxy resins for forming compositions.

Among those mentioned above, as a resin which is particularly effective for further improving the adhesion, for example, there may be mentioned a high molecular weight material (in general, a so-called epoxy group-containing phenoxy resin having a styrene-conversion weight average molecular weight of approximately 20,000 to 100,000) such as a bisphenol A type epoxy resin, bisphenol F type epoxy resin, bisphenol S type epoxy resin, or biphenyl type epoxy resin may be mentioned. The reason for this is believed that the flexibility of the cured material of the epoxy resin composition is improved when the above epoxy group-containing phenoxy resin is additionally used. In addition, when less than 20 percent by mass of the above epoxy group-containing phenoxy resin is added relative to the total amount of the epoxy resin (A) and the epoxy-resin curing agent (B), a sufficient effect of improving the adhesion can be obtained.

In addition, in order to simultaneously obtain superior adhesion to copper and superior flame retardant properties, the use of a nitrogen-containing resin such as the above phenol biphenyl triazine type epoxy resin, phenol xylylene triazine type epoxy resin, phenol triazine type epoxy resin, or the like is particularly preferable. It is believed that superior adhesion can be obtained by an effect of a polar functional group such as an amino group contained in the structure of the above nitrogen-containing resins. Furthermore, the flame retardant properties are significantly improved when the above nitrogen-containing resin is used together with an inorganic flame retardant containing zinc molybdate. This flame retardant mechanism has not been clearly understood. However, it is believed that the generation of a noncombustible gas and promotion of carbonization achieve the above improvement. That is, in the cured material of the epoxy resin of the present invention containing the nitrogen-containing resin and the inorganic flame retardant, at an initial stage of combustion, since pyrolysis of the cured material of the epoxy resin is promoted by the inorganic flame retardant, a large amount of a noncombustible gas is generated from the nitrogen-containing resin so as to perform self-extinguishing. Furthermore, at the latter stage of combustion, by carbide materials generated by the pyrolysis (promotion of carbonization), the fire is prevented from spreading to a place at which no combustion has occurred, and as a result, significant flame retardant properties can be obtained.

In the present invention, besides the phenol resin (F) and the phenol resin (F'), a curing agent contained in the epoxy-resin curing agent (B) is not particularly limited. For examples, there may be mentioned a bisphenol A type phenol resin, bisphenol F type phenol resin, bisphenol S type phenol resin, dihydroxyl ether of a biphenyl isomer, naphthalenediol type resin, phenol novolac resin, cresol novolac resin, phenol diphenyl ether aralkyl resin, naphthalene-containing novolac type resin, anthracene-containing novolac type resin, fluorene-containing novolac type resin, bisphenol fluorene-containing novolac type resin, bisphenol F-containing novolac type phenol resin, bisphenol A-containing novolac type phenol resin, phenol biphenyl triazine type resin, phenol xylylene triazine type resin, phenol triazine type resin, tetraphenylolethane type resin, trisphenylolethane type resin, polyphenol type resin, aromatic ester type phenol resin, alicyclic ester-containing phenol resin and ether ester type phenol resin. In addition, an amine compound such as a polyamide elastomer, diaminodiphenylmethane, diethylenetriamine, diaminodiphenylsulfone or the like, which has a functional group reactive with an epoxy resin, may also be used. The above curing agents may be used alone or in combination.

Among those mentioned above, as a curing agent particularly effective for further improving the adhesion, for example, there may be mentioned a high molecular weight material (in general, a so-called phenoxy resin having a styrene-conversion weight average molecular weight of approximately 20,000 to 100,000) such as a bisphenol A type resin, bisphenol F type resin, bisphenol S type resin, or hydroxyl ether of a biphenyl isomer may be mentioned. The reason for this is believed that the flexibility of the cured material of the epoxy resin composition is improved when the above phenoxy resin is additionally used. In addition, when less than 20 percent by mass of the phenoxy resin is added relative to the total amount of the epoxy resin (A) and the epoxy-resin curing agent (B), a sufficient effect of improving the adhesion can be obtained.

In addition, in order to simultaneously achieve superior adhesion to copper and superior flame retardant properties, the use of the above nitrogen-containing resin such as a phenol biphenyl triazine type resin, phenol xylylene triazine type resin, phenol triazine type resin, or the like is particularly preferable. It is believed that superior adhesion can be obtained by an effect of a polar functional group such as an amino group contained in the structure of the above nitrogen-containing resins. Furthermore, the flame retardant properties are significantly improved when the above nitrogen-containing resin is used together with an inorganic flame retardant containing zinc molybdate. This flame retardant mechanism has not been clearly understood. However, it is believed that the generation of a noncombustible gas and promotion of carbonization achieve the above improvement. That is, in the cured material of the epoxy resin of the present invention containing the nitrogen-containing resin and the inorganic flame retardant, at an initial stage of combustion, since pyrolysis of the cured material of the epoxy resin is promoted by the inorganic flame retardant, a large amount of a noncombustible gas is generated from the nitrogen-containing resin so as to perform self-extinguishing. Furthermore, at the latter stage of combustion, by carbide materials generated by the pyrolysis (promotion of carbonization), fire is prevented from spreading to a place at which no combustion has occurred, and as a result, significant flame retardant properties can be obtained.

Furthermore, as a curing promotion catalyst (D) of the present invention, a catalyst generally used for curing an epoxy resin and a curing agent may be used and is not particularly limited. For example, imidazole derivatives, diazocycloalkenes and its derivatives, and tertiary amines may be mentioned. These curing promotion agents may be used alone or in combination.

As another additive of the epoxy resin composition of the present invention, whenever necessary, a flexibilizer, such as a silicone rubber, silicone powder, acrylonitrile butadiene rubber (NBR), or indene, which is effective to improve the adhesion to a copper foil, may be used.

Furthermore, a coupling agent such as an organic silane compound, organic titanate compound, or organic aluminate compound may be optionally used. In particular, among the coupling agents mentioned above, an organic silane compound, that is, an alkoxysilane having a reactive functional group is effective to improve the adhesion and the solder heat resistance of the epoxy resin composition of the present invention. As particular examples of the alkoxysilane mentioned above, there may be mentioned an aminosilane compound such as γ-aminopropyltrimethoxysilane or N-phenyl-γ-aminopropyltriethoxysilane; an epoxy silane compound such as γ-glycidoxypropyltrimethoxysilane or γ-glycidoxypropylmethyldiethoxysilane; a mercapto silane compound such as γ-mercaptopropyltrimethoxysilane; or a ureidosilane compound such as γ-ureidopropyltriethoxysilane. Among these alkoxysilanes mentioned above, in order to improve the adhesion between the epoxy resin composition and a copper foil, a silane compound (aminosilane compound or ureidosilane compound) having an amino group at the end of the structure is preferable, and the ureidosilane compound is particularly effective. The reason for this has not been clearly understood. However, it is believed that since the reactivity of an amino group at the end of the structure of the ureidosilane compound is low, and the probability of reacting with an epoxy resin is also low, the ureidosilane compound has a larger number of amino groups, which form bonds with a copper surface, than that of the aminosilane compound, and as a result, superior adhesion can be obtained. On the other hand, it is also believed that since the reactivity of an amino group of the aminosilane compound is high, and the probability of reacting with an epoxy resin is high, the number of amino groups to form bonds with a copper surface is relatively small, and as a result, the adhesion may become insufficient in some cases. In addition, when an epoxy silane compound is used together with the aminosilane compound or the ureidosilane compound, epoxy groups and amino groups in the above compounds are likely to react with each other, and as a result, the adhesion may be degraded in some cases. That is, it is believed that this reaction product serves as a lubricant at the interface between the resin and the copper foil, and the adhesion of the epoxy resin composition to a surface of the copper foil processed by blackening treatment, which has a shallow anchor depth as compared to that of a mat surface of the copper foil, may be seriously decreased in some cases. Hence, the epoxy silane compound is preferably not to be used together with the aminosilane compound and/or the ureidosilane compound.

In addition, as an adhesion improver functioning between the epoxy resin composition and a copper foil surface, a triazole compound, a mercapto compound other than a mercaptosilane, and an imidazole copper complex may be added which are able to form bonds with a copper foil surface and are used as an antirust agent. As the triazole compound, for example, 1,2,3-benzotriazole and tolyltriazole are mentioned. As the mercapto compound, for example, 2,4,6-trimercapto-s-triazine, 2-di-n-butylamino-4,6-dimercapto-s-triazine, and 2-anilino-4,6-dimercapto-s-triazine may be mentioned. As the imidazole copper complex, for example, (2-methylimidazole)copper(II) complex may be mentioned. The compounds mentioned above may be used alone or in combination. In particular, when the mercapto compound mentioned above is used, in addition to a significant effect of improving the adhesion, the flame retardant properties are also significantly improved.

In addition, to the epoxy resin composition of the present invention, a flame retardant auxiliary agent may also be added, whenever necessary. As the flame retardant auxiliary agent mentioned above, there are mentioned nitrogen-based flame retardants, phosphorous-based flame retardants, and inorganic flame retardants other than metal hydrates.

As the nitrogen-based flame retardants, for example, melamine and isocyanuric acid compounds may be mentioned. As the phosphorus-based flame retardants, red phosphorus, phosphoric acid compounds, and organic phosphorous compounds may be mentioned by way of example. As the inorganic flame retardants other than metal hydrates, zinc molybdate, zinc stannate, and a compound of talc coated with zinc molybdate or zinc stannate may be mentioned by way of example. However, in the epoxy resin composition of the present invention, the amount of the flame retardant described above can be decreased, and hence degradation of other properties, such as humidity resistance and chemical resistance, can be suppressed.

In the epoxy resin composition of the present invention, known materials other than those mentioned above may be used. For example, as the known materials, pigments, antioxidants, and organic solvents may be mentioned, and any materials may be used without any limitation as long as they cause no degradation in properties of laminates and printed circuit boards.

In the present invention, the type and the amount of organic solvent which can be used as a solvent or a dispersion solvent of the epoxy resin composition are not particularly limited as long as a varnish solution in which the epoxy resin composition (including the epoxy resin, epoxy-resin curing agent, aluminum hydroxide, and curing promotion catalyst) of the present invention is homogeneously dissolved or dispersed has a viscosity and evaporation properties suitable for forming a prepreg. From workability point of view, as the organic solvent, for example, methyl ethyl ketone, 2-methoxyethanol, 2-methoxypropanol, 1-methoxy-2-propanol may be mentioned.

Furthermore, prepregs can be manufactured by a common method using the epoxy resin composition of the present invention by applying the above varnish solution onto a glass base material such as a glass fabric (glass cloth) or a non-woven glass fabric (glass paper) for impregnation, followed by heating. In addition, after plural prepregs thus formed are laminated to each other, one or two copper foils are adhered onto one surface or two surfaces of this laminate structure, respectively, and while a pressure is being applied thereto, heating is then performed, so that a glass epoxy resin copper-clad laminate can be manufactured. In this case, when the copper foil is not used, a laminate is obtained. A multilayer board can be manufactured using a common method by forming a circuit on a copper-clad laminate (inner plate), then etching a copper foil, placing a prepreg and a copper foil on at least one surface of the inner plate, and subsequently performing pressing, for example, at 180°C for 65 minutes under a pressure of 2.5 MPa. The laminate of the present invention thus manufactured simultaneously has superior heat resistance indicated by the glass transition temperature and superior adhesion to a copper foil and a base material.

Hereinafter, with reference to examples, the present invention will be further described in detail.

First, raw materials used in the examples of the present invention and comparative examples will be described.

Epoxy resins and epoxy-resin curing agents shown in Table 1 below were used.

The structures of an epoxy compound G1 and an epoxy resin H1 are represented by the following general formula (45). In addition, the structures of epoxy compounds G2, G3, and G4 are represented by the following general formula (46). In addition, the polystyrene-conversion weight average molecular weight (Mw) and the epoxy equivalent are also shown in the table.

**Table 1**

| | Low molecular weight epoxy resin (formed of repeating units (n) in the range of 0 to 10) | | | |
|---|---|---|---|---|
| Epoxy compound G | Material | Component | Molecular weight (MW) | Epoxy equivalent (g/eq) |
| | G1 | Phenolbiphenylenearalkyl epoxy resin | 1200 | 274 |
| | G2 | Phenolxylylenearalkyl epoxy resin | 2460 | 240 |
| | G3 | Phenolxylylenearalkyl epoxy resin | 1800 | 237 |
| | G4 | Phenolxylylenearalkyl epoxy resin | 1410 | 237 |

| | High molecular weight epoxy resin (formed of repeating units (n) in the range of 10 to less than 75) | | | |
|---|---|---|---|---|
| Epoxy resin H | Material | Component | Molecular weight (MW) | Epoxy equivalent (g/eq) |
| | H1 | Phenolbiphenylenearalkyl epoxy resin, Epoxy compound of Phenol F1 | 15000 | 280 |

| | | Material: Common epoxy resin | | |
|---|---|---|---|---|
| Another epoxy resin | | Component | Molecular weight (MW) | Epoxy equivalent (g/eq) |
| | | Phenol novolac type epoxy resin | 1100 | 180 |

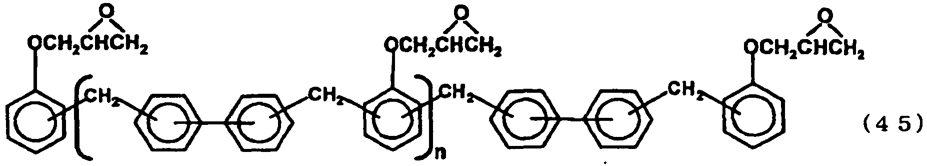

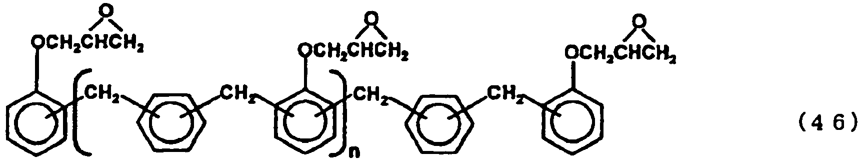

In addition, phenol resins used in the present invention are shown in Table 2 below, and the structures of phenol resins F1, F2, F'1 and F'2 are represented by the following general formula (47). In addition, the structures of phenol resins F'3, F'4 and F'5 are represented by the following general formula (48).

**Table 2**

| | High molecular weight phenol resin (formed of repeating units (n) in the range of more than 10 to less than 75) | | | |
|---|---|---|---|---|
| Phenol resin F | Material | Component | Molecular weight (MW) | Hydroxyl equivalent (g/eq) |
| | F1 | Phenolbiphenylenearalkyl resin | 13000 | 241 |
| | F2 | Phenolbiphenylenearalkyl resin | 3200 | 229 |

| | Low molecular weight epoxy resin (formed of repeating units (n) in the range of 0 to 10) | | | |
|---|---|---|---|---|
| Phenol resin F' | Material | Component | Molecular weight (MW) | Hydroxyl equivalent (g/eq) |
| | F'1 | Phenolbiphenylenearalkyl resin | 850 | 205 |
| | F'2 | Phenolbiphenylenearalkyl resin | 1400 | 218 |
| | F'3 | Phenolxylylenearalkyl resin | 1870 | 176 |
| | F'4 | Phenolxylylenearalkyl resin | 1460 | 175 |
| | F'5 | Phenolxylylenearalkyl resin | 1100 | 169 |
| | | Material: Common curing agent | | |

| Another phenol resin | | Component | Molecular weight (MW) | Hydroxyl equivalent (g/eq) |
|---|---|---|---|---|
| | | Phenol novolac resin | 1100 | 105 |

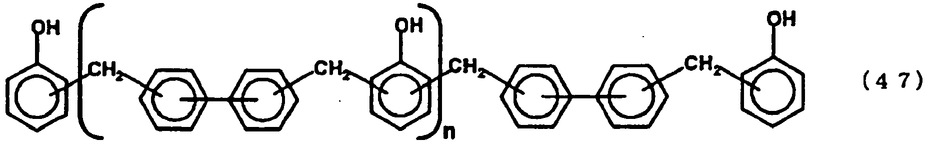

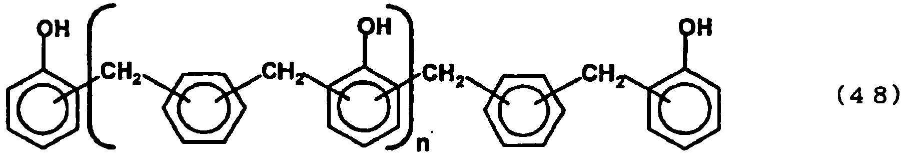

The other materials are shown in Table 3 below.

**Table 3**

| Material | | |
|---|---|---|
| Aluminum hydroxide | Aluminum hydroxide 1 | A surface area of 0.7 m²/g by a nitrogen adsorption method (BET), an average particle diameter of 5 µm by a laser diffraction method, and a total Na₂O amount of 0.03% |
| Curing promotion catalyst | Imidazole derivative | |
| Silane coupling agent | Aminosilane | |
| Glass cloth | 1031 manufactured by Arisawa Manufacturing Co., Ltd.: a mass of 107.2 g/m², and a thickness of 0.095 mm | |
| Copper foil | An electrolytic copper foil manufactured under the trade name of 3EC-111 by Mitsui Mining & Smelting Co., Ltd. having a thickness of 18 µm | |

Next, the evaluation methods of the glass transition temperature, adhesion, flame retardant properties, and solder heat resistance of the examples of the present invention and the comparative examples will be described.

### (i) Formation of prepregs

A varnish solution was formed by dissolving and dispersing the epoxy resin composition of the present invention in an organic solvent. After the resin component of this varnish solution was confirmed whether it was not crystallized at room temperature, this varnish solution was applied to a glass cloth.

Next, while the glass cloth thus processed was heated so as to have a gel time of approximately 120 seconds at 170°C, the solvent was removed therefrom (formation of a B stage prepreg: step of semi-curing the resin component), so that a prepreg was formed. A prepreg adjusted to contain approximately 50 percent by mass of the epoxy resin composition was used.

Next, evaluation samples were formed from the prepreg by press molding under the same condition (75°C x 0.5 MPa x 10 min → 130°C x 2.5 MPa x 25 min → 180°C x 2.5 MPa x 65 min).

### (ii) Measurement of glass transition temperature (evaluation method of heat resistance)

By using a laminate (thickness: 0.4 mm) formed by heating the four prepregs laminated to each other, DMA measurement (25 to 250°C, 10°C/min, bending of 15 mm, strain of 0.05%, and 1 Hz) was performed, so that the glass transition temperature (Tg, °C) was obtained.

### (iii) Evaluation of adhesion

By using a copper-clad laminate obtained by laminating one prepreg on a mat surface side of a copper foil, a tensile peeling strength (peel strength) of the copper foil or the cured prepreg was measured in accordance with JIS C 5012⁻¹⁹⁹⁵ 8.1, so that the adhesion was evaluated.

### Adhesion to copper foil

### (iv) Evaluation of flame retardant properties

A laminate (thickness: 0.4 mm) formed by heating the four prepregs laminated to each other was machined by cutting so as to have a shape as defined by UL 94 vertical burning test, and subsequently, the flame retardant properties were evaluated.

### (v) Evaluation of solder heat resistance

Four prepregs for a core material, formed by the method described above, were laminated to each other, and copper foils were then provided at the top and the bottom of this laminate, so that a two-side copper-clad laminate (two-side board) was formed. This two-side board was machined by cutting to have a size of 25 mm square (in a normal state, no pretreatment was performed) and was allowed to float in a solder bath at a predetermined temperature of 260°C, and a time was measured at which a defect (swelling or peeling) of the two-side board occurred. In this measurement, the maximum measurement time was set to 300 seconds, and in the case in which no defects occurred until this time, "no defect (o)" was shown in the table. In addition, when the defect occurred, a defect generation time was shown in the table.

### (Example 1)

To an epoxy resin composition containing 34.58 percent by mass of the epoxy compound G1 as the epoxy resin (A), 30.42 percent by mass of the phenol resin F1 as the epoxy-resin curing agent (B), and 35 percent by mass of aluminum hydroxide, 0.045 percent by mass of an imidazole derivative used as a curing promotion agent and 0.10 percent by mass of an aminosilane were added (relative to 100 percent by mass, that is, the total amount of the epoxy resin (A), the epoxy-resin curing agent (B), and aluminum hydroxide) to form a mixture, and the mixture thus obtained was dissolved or dispersed in methyl ethyl ketone (MEK), so that a varnish solution having a non-volatile component of 65 percent by mass was prepared.

The varnish solution thus obtained was continuously applied to a glass cloth for impregnation, so that a B-stage prepreg was formed. By using this prepreg thus formed, press molding was performed, so that various evaluation samples were formed. The evaluation results are shown in Tables 4 to 7.

### (Examples 2 to 16), (Comparative examples 1 to 10), and (Reference example 1)

Various evaluation samples were formed in an equivalent manner to that in Example 1 except that epoxy resin compositions shown in Tables 4 to 7 were used. The evaluation results are shown in Tables 4 to 7.

**Table 4**

| | Mw | Example 1 | Example 2 | Comparative example 1 | Comparative example 2 | Example 3 | Examples 4 | Example 5 | Comparative examples 3 | Comparative example 4 |
|---|---|---|---|---|---|---|---|---|---|---|
| | | | | | | | | | - | - |
| Epoxy compound G1 | 1200 | 34.58 | 35.41 | 37.18 | 36.20 | - | - | - | - | - |
| Epoxy compound G2 | 2460 | - | - | - | - | 32.43 | - | - | - | 37.50 |
| Epoxy compound G3 | 1820 | - | - | - | - | - | 32.23 | - | - | - |
| Epoxy compound G4 | 1410 | - | - | - | - | - | - | 32.23 | 37.94 | - |
| | | - | - | - | - | - | - | - | - | - |
| Phenol resin F1 | 13100 | 30.42 | - | - | - | 32.57 | 32.77 | 32.77 | - | - |
| Phenol resin F2 | 3200 | - | 29.59 | - | - | - | - | - | - | - |
| Phenol resin F'1 | 850 | - | - | 27.82 | - | - | - | - | - | - |
| Phenol resin F'2 | 1400 | | - | - | 28.80 | - | - | - | - | - |
| Phenol resin F'3 | 1870 | | | - | - | | | | - | 27.50 |
| Phenol resin F'5 | 1100 | - | - | - | - | | | | 27.08 | - |
| (Aluminum hydroxide) Aluminum hydroxide 1 | | 36 | 36 | 35 | 35 | 35 | 35 | 35 | 35 | 35 |
| (Curing promotion catalyst) Imidazole derivative | phr | 0.045 | 0.045 | 0.045 | 0.045 | 0.045 | 0.045 | 0.045 | 0.045 | 0.045 |
| (Coupling agent) Aminosilane | phr | 0.10 | 0.10 | 0.10 | 0.10 | 0.10 | 0.10 | 0.10 | 0.10 | 0.10 |
| (Physical properties) Glass transition temperature, Tg | °C | 160 | 151 | 125 | 128 | 153 | 165 | 178 | 146 | 116 |
| Adhesion to copper foil | kN/m | 1.51 | 1.42 | 1.08 | 1.11 | 1.30 | 1.65 | 1.81 | 1.11 | 1.18 |
| ULB4V ∑F | seconds | V-0 42 | V-0 45 | V-0 44 | V-0 42 | V-1 52 | V-0 42 | V-0 35 | V-1 61 | V-1 58 |
| Solder heat resistance at 260°C | No defects for 300 seconds or more | O | O | O | O | O | O | O | O | O |

**Table 5**

| | Mw | Example 6 | Example 7 | Example 8 | Example 9 | Example 10 | Comparative example 5 | Comparative example 6 |
|---|---|---|---|---|---|---|---|---|
| Epoxy compound H1 | 15000 | 37.53 | 36.55 | 39.91 | 40.00 | 40.53 | 34.93 | 35.76 |
| Phenol resin F'1 | 850 | 27.47 | - | - | - | - | - | - |
| Phenol resin F'2 | 1400 | - | 28.45 | - | - | - | - | - |
| Phenol resin F'3 | 1870 | - | - | 25.09 | | - | - | - |
| Phenol resin F'4 | 1460 | - | - | - | 25.00 | - | - | - |
| Phenol resin F'5 | 1100 | - | - | - | - | 24.47 | - | - |
| | | | | | | | | |
| henol resin F1 | 13100 | - | - | - | - | - | 30.07 | |
| Phenol resin F2 | 3200 | - | - | - | - | - | | 29.24 |
| (Aluminum hydroxide) | | | | | | | - | - |
| Aluminum hydroxide 1 | | 35 | 35 | 35 | 35 | 35 | 35 | 35 |
| (Curing promotion catalyst) | | | | | | | | |
| Imidazole derivative | phr | 0.045 | 0.045 | 0.045 | 0.045 | 0.045 | 0.045 | 0.045 |
| (Coupling agent) | | | | | | | | |
| Aminosilane | phr | 0.10 | 0.10 | 0.10 | 0.10 | 0.10 | 0.10 | 0.10 |
| (Physical properties) | | | | | | | | |
| Glass transition temperature, Tg | °C | 161 | 158 | 163 | 168 | 173 | 128 | 135 |
| Adhesion to copper foil | kN/m | 1.49 | 1.41 | 1.53 | 1.63 | 1.78 | 1.14 | 1.16 |
| UL94V ∑F | seconds | V-0 43 | V-0 46 | V-0 44 | V-0 40 | V-0 38 | V-0 34 | V-0 38 |
| Solder heat resistance at 260°C | No defects for 300 seconds or more | O | O | O | O | O | O | O |

**Table 6**

| | Mw | Example 11 | Example 12 | Example 13 | Comparative example 7 | Comparative example 8 |
|---|---|---|---|---|---|---|
| (High molecular weight epoxy) | | | | | | |
| Epoxy compound H1 | 1500 | | | 23.66 (60)*¹ | | |
| Epoxy compound G1 | 1200 | 22.94 (60)*¹ | 19.41 (60)*¹ | - | 19.42 (50)*¹ | - |
| Epoxy compound G2 | 2460 | | | | - | 18.99 (50)*¹ |
| Phenol resin F1 | 13100 | 16.06 (60)*² | 13.59 (60)*² | - | 13.08 (50)*² | 13.51 (50)*² |
| Phenol resin F'1 | 850 | - | - | 15.33 (60)*² | - | - |
| Common epoxy resin 1 | | 15.29 (40)*¹ | 12.94 (40)*¹ | 15.77 (40)*¹ | 19.42 (50)*¹ | 18.99 (50)*¹ |
| common curing agent 1 | | 10.71 (40)*² | 9.06 (40)*² | 10.22 (40)*² | 13.08 (50)*² | 13.51 (50)*² |
| (Aluminum hydroxide) | | | | | | |
| Aluminum hydroxide 1 | | 35 | 45 | 35 | 35 | 35 |
| (Curing promotion catalyst) | | | | | | |
| Imidazole derivative | phr | 0.045 | 0.045 | 0.045 | 0.045 | 0.045 |
| (Coupling agent) Aminosilane | phr | 0.10 | 0.10 | 0.10 | 0.10 | 0.10 |
| (Physical properties) | | | | | | |
| Glass transition temperature, Tg | °C | 170 | 172 | 172 | 158 | 159 |
| Adhesion to copper foil | kN/m | 1.32 | 1.26 | 1.26 | 1.17 | 1.19 |
| UL94V ∑F | seconds | V-0 44 | V-0 42 | V-0 46 | V-1 53 | V-1 82 |
| Solder heat resistance at 260°C | No defects for 300 seconds or more | O | 290 | O | O | O |

| | | | | | | |
|---|---|---|---|---|---|---|
| value in parentheses *1 indicates percent by mass of the total epoxy resin value in parentheses *2 indicates percent by mass of the total epoxy-resin curing agent | | | | | | |

**Table 7**

| | Mw | Example 14 | Example 15 | Example 1 | Example 16 | Reference example 1 | Comparative example 9 | Example 3 | Comparative example 10 |
|---|---|---|---|---|---|---|---|---|---|
| Epoxy compound G1 | 1200 | 42.56 | 39.90 | 34.58 | 31.92 | 45 | 26.60 | - | - |
| Epoxy compound G2 | 2460 | | | | | | | 32.43 | 24.95 |
| Phenol resin F1 | 13100 | 37.44 | 35.10 | 30.42 | 28.08 | 40 | 23.40 | 32.57 | 25.05 |
| (Aluminum hydroxide) Aluminum hydroxide 1 | | 20 | 25 | 35 | 40 | 15 | 50 | 35 | 50 |
| (Curing promotion catalyst) Imidazole derivative | phr | 0.045 | 0.045 | 0.045 | 0.045 | 0.045 | 0.045 | 0.045 | 0.045 |
| (Coupling agent) Aminosilane | phr | 0.10 | 0.10 | 0.10 | 0.10 | 0.10 | 0.10 | 0.10 | 0.10 |
| (Physical properties) Glass transition temperature, Tg | °C | 160 | 160 | 160 | 161 | 160 | 161 | 153 | 155 |
| Adhesion to mat surface | kN/m | 1.75 | 1.67 | 1.51 | 1.31 | 1.78 | 1.15 | 1.30 | 1.12 |
| UL94V ∑F | seconds | . V-0 49 | V-0 44 | V-0 42 | V-0 31 | V-0 70 | V-0 21 | V-1 52 | V-0 28 |
| Solder heat resistance at 260°C | No defects for 300 seconds or more | O | O | O | O | O | 180 | 0 | 120 |

From the results shown in Tables 4 to 7 above, it was understood that the epoxy resin composition of the present invention simultaneously has superior heat resistance and adhesion to those of the epoxy resin compositions of the comparative examples in accordance with conventional techniques. In addition, it was also understood that the epoxy resin composition of the present invention also has superior flame retardant properties and solder heat resistance.

As apparent from the comparison of Examples 1 and 2 of the present invention with Comparative examples 1 and 2, and that of Examples 3, 4 and 5 with Comparative examples 3 and 4, the epoxy resin composition of the present invention, which contains the high molecular weight phenol resin (phenol resin (F)) and the low molecular epoxy resin (epoxy compound (G)) as the essential components, simultaneously has superior heat resistance indicated by the glass transition temperature and superior adhesion to a mat surface of the copper foil.

Furthermore, as shown in Table 5, as apparent from the comparison of Examples 6, 7, 8, 9, and 10 of the present invention with Comparative examples 5 and 6, the epoxy resin composition of the present invention, which contains the high molecular epoxy resin (epoxy resin (H)) and the low molecular phenol resin (phenol resin (I)) as the essential components, simultaneously has superior heat resistance indicated by the glass transition temperature and superior adhesion to a mat surface of the copper foil.

In addition, as shown in Table 6, as apparent from the comparison of Examples 11, 12 and 13 of the present invention with Comparative examples 7 and 8, an epoxy resin composition simultaneously also has superior heat resistance indicated by the glass transition temperature and superior adhesion to a mat surface of the copper foil, the above epoxy resin composition being formed by replacing 60 percent by mass or more of the epoxy resin (A) and the epoxy-resin curing agent (B), which form the epoxy resin composition of the present invention, with a common epoxy resin (other than the epoxy resins (G) and (H)) and a common epoxy-resin curing agent (other than the phenol resins (F) and (I)), respectively.

In addition, as shown in Table 7, as apparent from the comparison of Examples 14, 15, 1 and 16 of the present invention with Reference example 1 and Comparative example 9, and from the comparison of Example 3 of the present invention with Comparative example 10, the epoxy resin composition of the present invention simultaneously has superior heat resistance indicated by the glass transition temperature, adhesion to a mat surface of the copper foil, flame retardant properties, and solder heat resistance, the above epoxy resin composition containing the aluminum hydroxide (C) in a weight ratio (W) of 20 to 45 percent by mass relative to the total amount of the epoxy resin (A), the epoxy-resin curing agent (B), and the aluminum hydroxide (C).

### (Examples 17 to 22 of the present invention) (Reference example 2)

As an example of the epoxy resin composition of the present invention having superior heat resistance and adhesion, by using the case in which the low molecular weight epoxy compound (G) and the high molecular weight phenol resin (F) are used in combination, the influences of the molecular weight (the repeating unit number (n)) of the phenol resin (F) on the heat resistance and the adhesion were confirmed.

Hence, as shown in Tables 8 and 9, the epoxy compound G1 was used as the epoxy resin (A), and phenol resins as the epoxy-resin curing agent (B) were blended therewith in a stoichiometric ratio, the phenols resins having the structure similar to that of the phenolbiphenylenearalkyl type resin represented by the general formula (38) of the phenol resins (F) and having different molecular weights (Mw of 2,500, 5,000, 8,000, and 10,000). Subsequently, laminates were formed in a manner similar to that in Example 1 of the present invention, and the glass transition temperature of each laminate and the adhesion thereof to a copper foil were evaluated. By the way, when the repeating unit number (n) was 10 in the general formula (38), the weight average molecular weight (Mw) was approximately 3,086. Hence, a molecular weight of approximately 3,100 corresponds to the lower limit of the molecular weight of the phenolbiphenylenearalkyl resin (general formula 38) contained in the phenol resin (F) of the present invention.

However, in the epoxy resin compositions (the total amount, that is, 100% of the epoxy resin (A), the epoxy-resin curing agent (B), and aluminum hydroxide) shown in Examples 17 to 22 and Reference example 2, the content of aluminum hydroxide was set to 35 percent by mass of the total amount, that is, 100% of the epoxy resin composition, and 0.045 percent by mass of an imidazole derivative and 0.10 percent by mass of an aminosilane were added relative to the total amount, that is, 100% of the epoxy resin composition. In addition, also in Table 9 below, the examples of the present invention are also shown.

**Table 8**

| Material | |
|---|---|
| Silane coupling agent | Ureidosilane |
| Phenoxy resin | Epoxy group-containing type: Phenoxy resin 1* |
| | Non-epoxy group-containing type: Phenoxy resin 2* |

| | |
|---|---|
| * Resin containing a bisphenol A type phenoxy resin and a bisphenol F type phenoxy resin in a ratio of 25 to 75 on a mass percentage basis | |

**Table 9**

| | Mw | Example 1 | Example 17 | Example 18 | Example 19 | Example 20 | Example 21 | Example 22 | Example 23 | Reference example 2 |
|---|---|---|---|---|---|---|---|---|---|---|
| | | | | | | | | | | |
| Epoxy compound G1 | 1200 | 34.58 | 31.92 | 31.92 | 29.26 | 26.60 | 26.60 | 26.60 | 26.60 | 23.94 |
| | | | | | | | | | | |
| Phenol resin F1 | 13100 | 30.42 | 28.08 | 28.08 | 25.74 | 23.40 | 23.40 | 23.40 | 23.40 | 21.06 |
| Phenoxy resin 1 | | | | | | | | | 15 | |
| Phenoxy resin 2 | | | 5 | 5 | 10 | 15 | 15 | 15 | | 20 |
| (Aluminum hydroxide) Aluminum hydroxide 1 | | 35 | 35 | 35 | 35 | 35 | 35 | 35 | 35 | 35 |
| (Curing promotion catalyst) Imidazole derivative | phr | 0.045 | 0.045 | 0.045 | 0.045 | 0.045 | 0.045 | 0.045 | 0.045 | 0.045 |
| (Coupling agent) Aminosilane | phr | 0.10 | 0.10 | | | | | | | |
| Ureidosilane | phr | | | 0.10 | 0.10 | 0.10 | 0.50 | 1.00 | 1.00 | 1.00 |
| (Physical properties) Glass transition temperature, Tg | °C | 160 | 158 | 157 | 156 | 155 | 153 | 152 | 154 | 154 |
| Adheslon to copper foil | kN/m | 1.51 | 1.83 | 1.85 | 1.86 | 1.91 | 1.95 | 1.98 | 1.99 | 1.82 |
| UL94V | | V-0 | V-0 | V-0 | V-0 | V-0 | V-0 | V-0 | V-0 | V-0 |
| ∑F | seconds | 42 | 43 | 43 | 44 | 46 | 47 | 48 | 49 | 42 |
| Solder heat resistance at 260°C | No defects for 300 seconds or more | O | O | O | O | O | O | O | O | O |

### (Examples 24 to 43 of the present invention)

As were Examples of 17 to 22 of the present invention described above, as one example of the epoxy resin composition having superior heat resistance and adhesion, by using the case in which the low molecular weight epoxy compound (G) and the high molecular weight phenol resin (F) were used in combination, the influences of the nitrogen-containing curing agent and the inorganic flame retardant were investigated, and in addition, the effect of a carbonization promotion catalyst and the addition effect of aluminum hydroxide were also investigated.

In addition, the inorganic flame retardant and nitrogen-containing phenol resin used as the nitrogen-containing curing agent are shown in Table 10 below, and the structure of the nitrogen-containing phenol resin is represented by the following general formula (40).

**Table 10**

| Material | |
|---|---|
| Nitrogen-containing phenol resin | Phenol triazine resin, nitrogen content of 12 percent by mass, hydroxyl equivalent of 125 g/eq. |
| Inorganic flame retardant | Talc processed by zinc molybdate treatment, specific gravity of 2.8, average particle diameter of 4 µm, manufactured by Japan Sherwin-Williams Co, Ltd. |

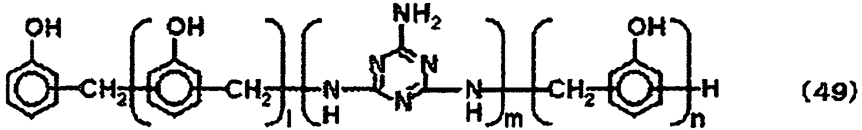

(where I and n each independently represent an integer of 0 to 10, and m is an integer of more than 1 to less than 10.)

The following Table 11 shows the effect of the nitrogen-containing resin. In addition, the following Table 12 shows the effect of the inorganic flame retardant and the effect thereof together with the nitrogen-containing resin. In addition, the following Table 13 shows the effect of the amount of the inorganic flame retardant added to the epoxy resin composition.
Furthermore, the following Tables 14 and 15 each show the effect of the aluminum hydroxide added to the epoxy resin composition.

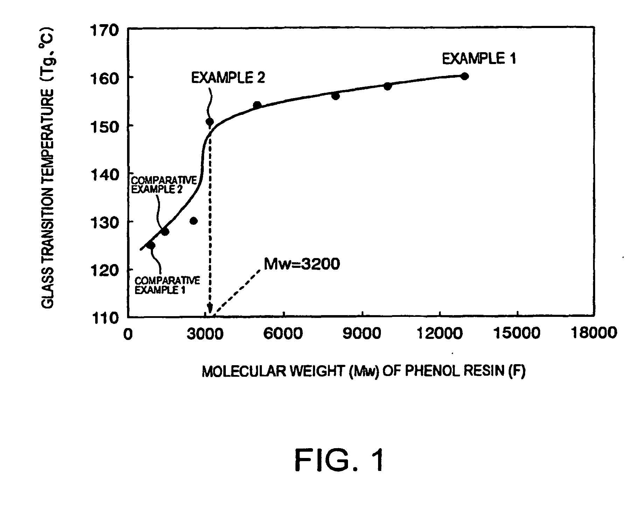

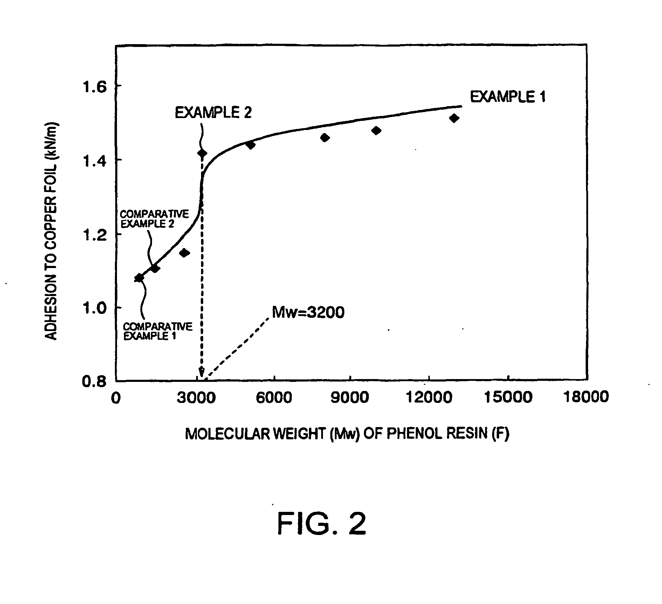

Fig. 1 is a graph showing the relationship between the molecular weight (Mw) of the phenol resin (F) and the glass transition temperature (Tg, °C) of the examples of the present invention, and Fig. 2 is a graph showing the relationship between the molecular weight (Mw) of the phenol resin (F) and the adhesion (kN/m) to a copper foil of the examples of the present invention.
As can be seen from Figs. 1 and 2, when the phenol resin (F) of the present invention is used, it is understood that significantly superior heat resistance (indicated by the glass transition temperature in this case) and adhesion (indicated by the adhesion to a copper foil in this case) can be obtained.

**Table 11**

| | | Mw | Example 1 | Example 16 | Comparative example 9 | Example 24 | Example 25 | Example 26 | Example 27 |
|---|---|---|---|---|---|---|---|---|---|
| Resin component | Epoxy compound G1 | 1200 | 34.58 | 31.92 | 26.60 | 31.92 | 33.20 | 35.00 | 37.48 |
| | Phenol resin F1 | 13100 | 30.42 | 28.08 | 23.40 | 28.08 | 24.12 | 18.75 | 11.26 |
| | (Nitrogen-containing resin) Phenotol triazine resin | | No | No | No | No | 2.68 (4.5%) | 6.25 (1034%) | 11.26 (1838%) |
| (Aluminum hydroxide) Aluminum hydroxide 1 | | | 35 | 40 | 50 | 40 | 40 | 40 | 40 |
| (Inorganic flame retardant) Talc processed by zinc molybdate treatment | | | No | No | No | No | No | No | No |
| (Curing promotion catalyst) Imidazole derivative | | phr | 0.05 | 0.05 | 0.05 | 0.05 | 0.05 | 0.05 | 0.05 |
| (Coupling agent) Aminosilane | | phr | 0.10 | 0.10 | 0.10 | No | No | No | No |
| (Physical properties) Glass transition temperature, Tg | | °C | 160 | 161 | 161 | 159 | 163 | 169 | 175 |
| Adhesion to mat surface | | kN/m | 1.51 | 1.31 | 1.15 | 1.30 | 1.41 | 1.45 | 1.52 |
| UL94V ∑F | | seconds | V-0 42 | V-0 31 | V-0 21 | V-0 30 | V-0 43 | V-0 38 | V-0 49 |
| Solder heat resistance at 260°C | | No defects for 300 seconds or more | O | O | 180 seconds | O | O | O | O |

| | | | | | | | | | |
|---|---|---|---|---|---|---|---|---|---|
| * Ratio on a weight basis to the total resin component | | | | | | | | | |

**Table 12**

| | | Mw | Example 24 | Example 28 | Example 29 | Example 30 | Example 31 | Example 32 |
|---|---|---|---|---|---|---|---|---|
| Resin component | Epoxy compound G1 | 1200 | 31.92 | 31.92 | 29.26 | 29.26 | 32.08 | 32.08 |
| | Phenol resin F1 | 13100 | 28.08 | 28.08 | 25.74 | 25.74 | 17.19 | 17.19 |
| | (Nitrogen-containing resin) Phenol triazine resin | Phenol | No | No | No | No | 5.73 (10.4%) | 5.73 (10.4%) |
| (Aluminum hydroxide) Aluminum hydroxide 1 | | | 40 | 35 | 40 | 45 | 45 | 40 |
| (Inorganic flame retardant) Talc processed by zinc molybdate treatment | | | No | 5 | 5 | No | No | 5 |
| (Curing promotion catalyst) Imidazole derivative | | phr | 0.05 | 0.05 | 0.05 | 0.05 | 0.05 | 0.05 |
| (Coupling agent) Aminosilane | | phr | No | No | No | No | No | No |
| (Physical properties) Glass transition temperature, Tg | | °C | 161 | 161 | 161 | 161 | 167 | 167 |
| Adhesion to mat surface | | kN/m | 1.30 | 1.29 | 1.22 | 1.23 | 1.28 | 1.27 |
| UL94V ∑F | | seconds | V-0 30 | V-0 46 | V-0 44 | V-0 28 | V-0 35 | V-0 12 |
| Solder heat resistance at 260°C | | No defects for 300 seconds or more | O | O | O | O | O | O |

| | | | | | | | | |
|---|---|---|---|---|---|---|---|---|
| * Ratio on a weight basis to the total resin component | | | | | | | | |

**Table 13**

| | | Mw | Example 26 | Example 33 | Example 34 | Example 35 | Example 36 | Example 32 |
|---|---|---|---|---|---|---|---|---|
| Resin component | Epoxy compound G1 | 1200 | 35.00 | 34.41 | 33.83 | 33.25 | 32.67 | 32.08 |
| | Phenol resin F1 | 13100 | 18.75 | 18.44 | 18.13 | 17.81 | 17.50 | 17.19 |
| | (Nitrogen-containing resin) Phenol triazine resin | | 6.25 (10.4%) | 6.15 (10.4%) | 6.04 (10.4%) | 5.94 (10.4%) | 5.83 (10.4%) | 5.73 (10.4%) |
| (Aluminum hydroxide) Aluminum hydroxide 1 | | | 40 | 40 | 40 | 40 | 40 | 40 |
| (Inorganic flame retardant) Talc processed by zinc molybdate treatment | | | No | 1 | 2 | 3 | 4 | 5 |
| (Curing promotion catalyst) Imidazole derivative | | phr | 0.05 | 0.05 | 0.05 | 0.05 | 0.05 | 0.05 |
| (Coupling agent) Aminosilane | | phr | No | No | No | No | No | No |
| (Physical properties) Glass transition temperature | | °C | 167 | 167 | 167 | 167 | 167 | 167 |
| Adhesion to mat surface | | kN/m | 1.45 | 1.39 | 1.34 | 1.30 | 1.28 | 1.27 |
| UL94V ∑F | | seconds | V-0 38 | V-0 25 | V-0 21 | V-0 19 | V-0 15 | V-0 12 |
| Solder heat resistance at 260°C | | No defects for 300 seconds or more | O | O | O | O | O | O |

| | | | | | | | | |
|---|---|---|---|---|---|---|---|---|
| * Ratio on a weight basis to the total resin component | | | | | | | | |

**Table 14**

| | | Mw | Example 37 | Example 38 | Example 32 | Example 39 |
|---|---|---|---|---|---|---|
| Resin component | Epoxy compound G1 | 1200 | 33.83 | 33.25 | 32.67 | 32.08 |
| | Phenol resin F1 | 13100 | 18.13 | 17.81 | 17.50 | 17.19 |
| | (Nitrogen-containing resin) Phenol triazine resin | | 6.04 (10.4%)* | 5.94 (10.4%)* | 5.83 (10.4%)* | 5.73 (10.4%)* |
| (Aluminum hydroxide) Aluminum hydroxide 1 | | | 38 | 39 | 40 | 41 |
| (Inorganic flame retardant) Talc processed by zinc molybdate treatment | | | 4 | 4 | 4 | 4 |
| (Curing promotion catalyst) Imidazole derivative | | phr | 0.05 | 0.05 | 0.05 | 0.05 |
| (Coupling agent) Aminosilane | | phr | No | No | No | No |
| (Physical properties) Glass transition temperature, Tg | | °C | 167 | 167 | 167 | 167 |
| Adhesion to mat surface | | kN/m | 1.33 | 1.31 | 1.28 | 1.26 |
| UL94V ∑F | | seconds | V-0 20 | V-0 18 | V-0 15 | V-0 10 |
| Solder heat resistance at 260°C | | No defects for 300 seconds or more | O | O | O | O |

| | | | | | | |
|---|---|---|---|---|---|---|
| * Ratio on a weight basis to the total resin component | | | | | | |

**Table 15**

| | | Mw | Example 40 | Example 41 | Example 42 | Example 34 | Example 43 | Example 44 |
|---|---|---|---|---|---|---|---|---|
| Resin component | Epoxy compound G1 | 1200 | 36.75 | 35.00 | 34.41 | 33.25 | 33.83 | 31.50 |
| | Phenol resin F1 | 13100 | 19.69 | 18.75 | 18.44 | 17.81 | 18.13 | 16.88 |
| | (Nitrogen-containing resin) Phenol triazine resin | | 6.56 (10.4%) | 6.25 (10.4%) | 6.15 (10.4%) | 5.94 (10.4%) | 6.04 (10.4%) | 5.62 (10.4%) |
| (Aluminum hydroxide) Aluminum hydroxide 1 | | | 35 | 38 | 39 | 40 | 41 | 41 |
| (Inorganic flame retardant) Talc processed by zinc molybdate treatment | | | 2 | 2 | 2 | 2 | 2 | 5 |
| (Curing promotion catalyst) Imidazole derivative | | phr | 0.05 | 0.05 | 0.05 | 0.05 | 0.05 | 0.05 |
| (Coupling agent) Aminosilane | | phr | No | No | No | No | No | No |
| (Physical properties) Glass transition temperature, Tg | | °C | 167 | 167 | 167 | 167 | 167 | 167 |
| Adhesion to mat surface | | kN/m | 1.49 | 1.43 | 1.38 | 1.34 | 1.30 | 1.24 |
| UL94V ∑F | | seconds | V-0 30 | V-0 27 | V-0 24 | V-0 21 | V-0 18 | V-0 8 |
| Solder heat resistance at 260°C | | No defects for 300 seconds or more | O | O | O | O | O | O |

| | | | | | | | | |
|---|---|---|---|---|---|---|---|---|
| * Ratio on a weight basis to the total resin component | | | | | | | | |

As shown in the tables, the present invention can realize the epoxy resin composition for printed circuit boards, simultaneously having superior heat resistance and adhesion without using a halogen-based and a phosphorus-based flame retardant.

That is, in the present invention, a phenolaralkyl type resin is contained as the epoxy-resin curing agent, which has a higher molecular weight than that of the preceding example and which has a molecular weight distribution in a specific range, and a phenolaralkyl type epoxy resin is used as the epoxy resin, which has a specific molecular weight distribution (within that of the preceding example and having a lower molecular weight than that of the epoxy-resin curing agent to be used at the same time); hence, a particular effect of improving the heat resistance and adhesion can be obtained.

Furthermore, in the present invention, a phenolaralkyl type resin is used as the epoxy-resin curing agent, which has a specific molecular weight distribution (within that of the preceding example and having a lower molecular weight than that of an epoxy resin to be used at the same time), and a phenolaralkyl type epoxy resin is contained as the epoxy resin, which has a higher molecular weight than that of the preceding example and which has a molecular weight distribution in a specific range; hence, a particular effect of improving the heat resistance and adhesion can be obtained.

### Industrial Applicability

As has thus been described, since the epoxy resin composition according to the present invention does not use a halogen-based and a phosphorus-based flame retardant and simultaneously has superior heat resistance and adhesion, the epoxy resin composition described above can be applied to an epoxy resin composition for printed circuit boards.

## Claims

1. An epoxy resin composition comprising: an epoxy resin (A); and an epoxy-resin curing agent (B) including a phenol resin (F) represented by one of the general formulas (3) to (8), the phenol resin (F) containing at least one of a structural unit X, which is represented by the following general formula (1) obtained by reaction between a phenol-based compound and a biphenyl isomer or a mixture of biphenyl isomers, and a structural unit Y, which is represented by the following general formula (2) obtained by reaction between a phenol-based compound and a benzene isomer or a mixture of benzene isomers, the sum of the number of repetitions of the structural unit X and the number of repetitions of the structural unit Y (n or m+m') being more than 10 to less than 75, the general formulas being: 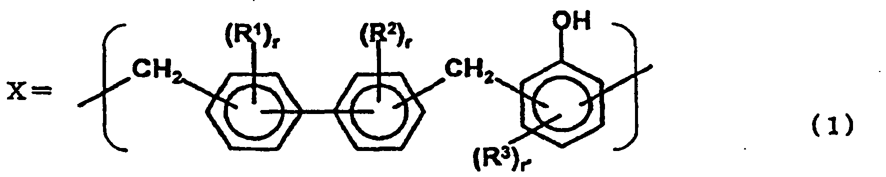 (where R¹, R², and R³ each independently represent hydrogen or a monovalent substituent having 1 to 3 carbon atoms, each r independently represents an integer from 0 to 4, and r' represents an integer from 0 to 3); 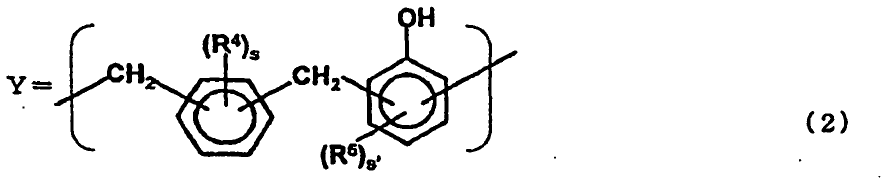 (where R⁴ and R⁵ each independently represent hydrogen or a monovalent substituent having 1 to 3 carbon atoms, s represents an integer from 0 to 4, and s' represents an integer from 0 to 3); 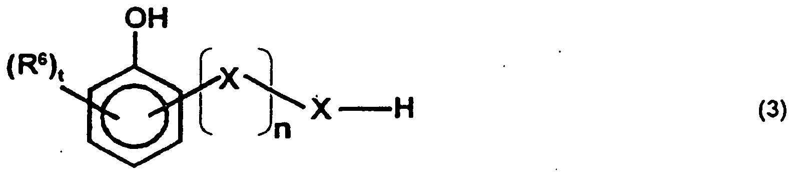 or 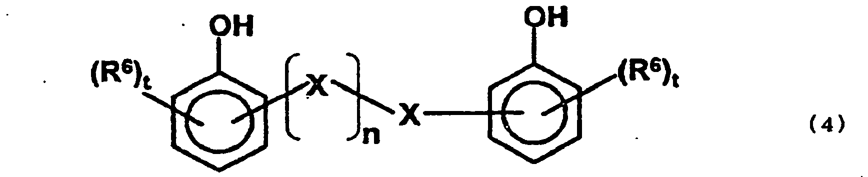 (where R⁶ represents hydrogen or a monovalent substituent having 1 to 3 carbon atoms, t represents an integer from 0 to 4, and n is more than 10 to less than 75): 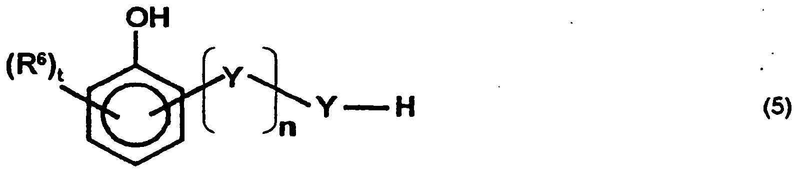 or 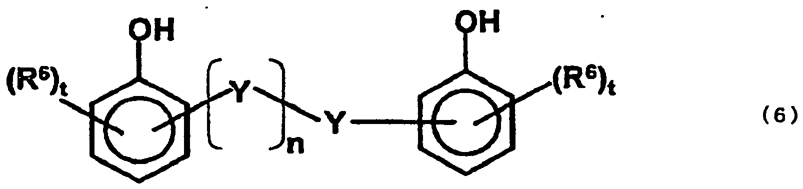 (where R⁶ represents hydrogen or a monovalent substituent having 1 to 3 carbon atoms, t represents an integer from 0 to 4, and n is more than 10 to less than 75); and 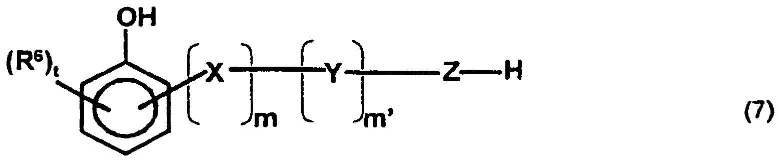 or 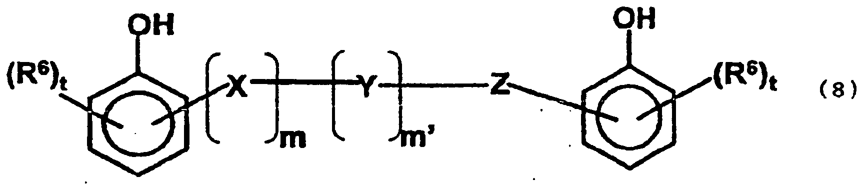 (where R⁶ represents hydrogen or a monovalent substituent having 1 to 3 carbon atoms, t represents an integer from 0 to 4, m and m' are each independently 1 to 74, m+m' is more than 10 to less than 75, and Z represents one of X and Y).

2. The epoxy resin composition according to Claim 1, wherein the epoxy resin (A) includes an epoxy compound (G) represented by one of the general formulas (11) to (16), the epoxy compound (G) containing at least one of a structural unit X', which is represented by the following general formula (9) obtained by epoxidation of a product by reaction between a phenol-based compound and a biphenyl isomer or a mixture of biphenyl isomers, and a structural unit Y', which is represented by the following general formula (10) obtained by epoxidation of a product by reaction between a phenol-based compound and a benzene isomer or an mixture of benzene isomers, the sum of the number of repetitions of the structural unit X' and the number of repetitions of the structural unit Y' (n or m+m') being 0 to 10, the general formulas being: 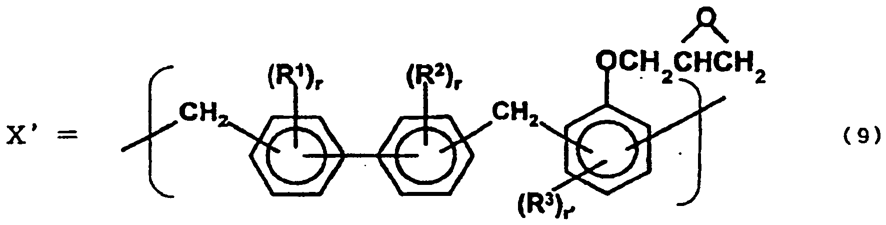 (where R¹, R², and R³ each independently represent hydrogen or a monovalent substituent having 1 to 3 carbon atoms, each r independently represents an integer from 0 to 4, and r' represents an integer from 0 to 3); 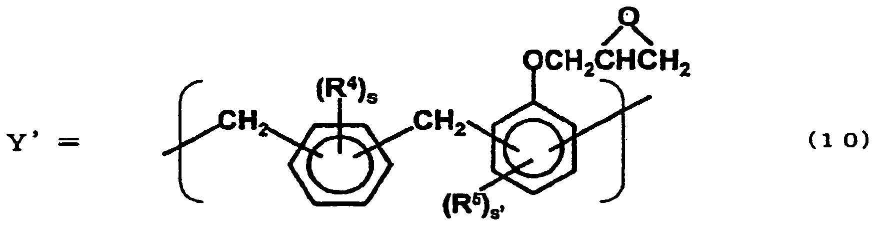 (where R⁴ and R⁵ represent hydrogen or a monovalent substituent having 1 to 3 carbon atoms, s represents an integer from 0 to 4, and s' represents an integer from 0 to 3): 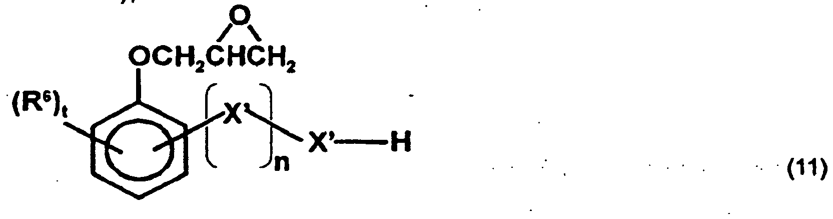 or 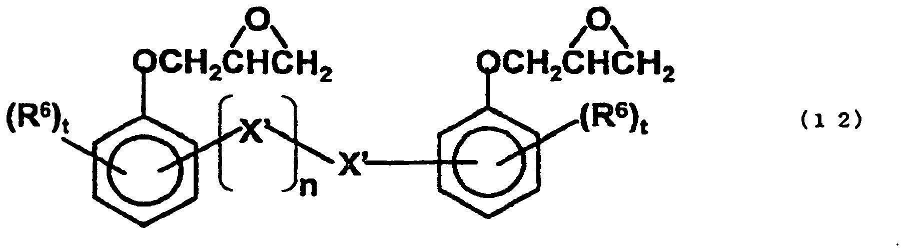 (where R⁶ represents hydrogen or a monovalent substituent having 1 to 3 carbon atoms, t represents an integer from 0 to 4, and n is 0 to 10); 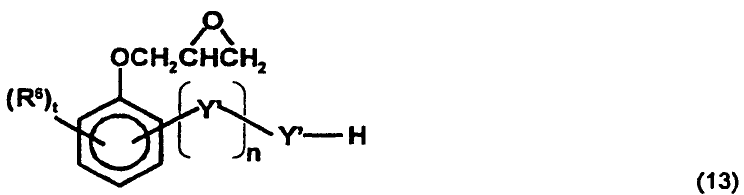 or 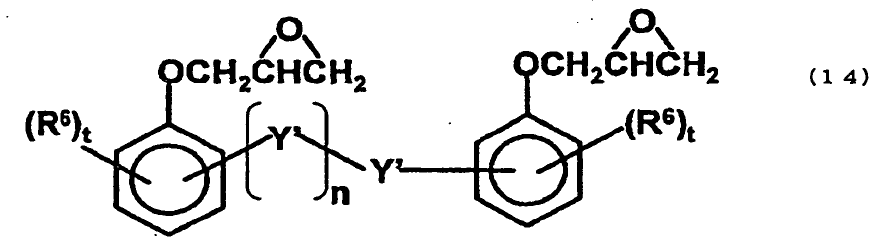 (where R⁶ represents hydrogen or a monovalent substituent having 1 to 3 carbon atoms, t represents an integer from 0 to 4, and n is 0 to 10); and 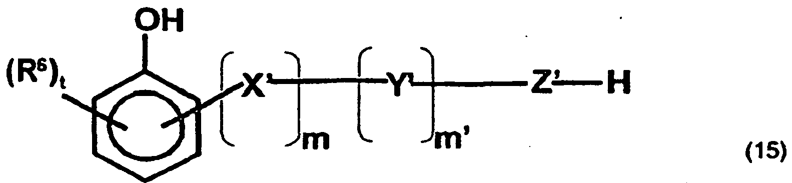 or 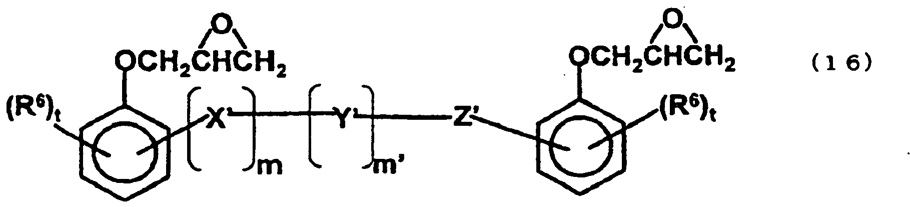 (where R⁶ represents hydrogen or a monovalent substituent having 1 to 3 carbon atoms, t represents an integer from 0 to 4, m and m' are each independently 1 to 9, m+m' is 1 to 10, and Z' represents one of X' and Y').

3. The epoxy resin composition according to Claim 1 or 2, further comprising an inorganic filler (C).

4. The epoxy resin composition according to Claim 3, wherein the inorganic filler (C) is aluminum hydroxide (C').

5. The epoxy resin composition according to Claim 4, wherein the 50 mass% average particle diameter (D₅₀) of the aluminum hydroxide (C') is 0.5 to 20 µm.

6. The epoxy resin composition according to one of Claims 1 to 5, further comprising a curing promotion catalyst (D).

7. The epoxy resin composition according to one of Claims 1 to 6, further comprising one of a phenoxy resin containing an epoxy group and a phenoxy resin containing no epoxy group.

8. The epoxy resin composition according to one of Claims 1 to 7, further comprising a rubber component as a flexibilizer

9. The epoxy resin composition according to one of Claims 1 to 8, further comprising a silane coupling agent.

10. The epoxy resin composition according to one of Claims 1 to 9, further comprising a mercapto compound.

11. The epoxy resin composition according to one of Claims 1 to 10, further comprising at least one of a nitrogen-containing curing agent and an inorganic flame retardant.

12. A varnish solution comprising: an organic solvent; and the epoxy resin composition according to one of Claims 1 to 11 which is dissolved or dispersed therein.

13. A prepreg material comprising: a resin sheet in a semi-cured state, obtained after a process including impregnating a base material with the varnish solution according to Claim 12, followed by removal of the solvent.

14. A laminate comprising: the prepreg material according to Claim 13.

15. A copper-clad laminate comprising: the prepreg material according to Claim 13; and a copper foil which is adhered to one surface thereof.

16. A copper foil provided with a resin, produced by a process comprising the step of: applying the varnish solution according to Claim 12 onto a surface of a copper foil.

17. A printed circuit board comprising: a copper foil; and a resin material laminated thereto, the resin material being only formed of an epoxy resin composition or being formed of a base material containing an epoxy resin, said epoxy resin composition containing the epoxy resin composition according to one of Claims 1 to 11 and being in a semi-cured state or in a cured state.

18. The printed circuit board according to Claim 17, wherein the resin material includes a prepreg material comprising a resin sheet in a semi-cured state, which is obtained after a process including the steps of: impregnating a base material with a varnish solution which contains an organic solvent and an epoxy resin composition dissolved or dispersed therein; and removing the solvent therefrom.

19. The printed circuit board according to Claim 17, wherein the resin material includes the epoxy resin composition applied on the copper foil.

20. An epoxy resin composition comprising: an epoxy resin (A) and an epoxy-resin curing agent (B), the epoxy resin (A) including an epoxy compound (H) represented by one of the general formulas (35) to (40), the epoxy compound (H) containing at least one of a structural unit X', which is represented by the above general formula (9) obtained by reaction between a phenol-based compound and a biphenyl isomer or a mixture of biphenyl isomers, and a structural unit Y', which is represented by the above general formula (10) obtained by reaction between a phenol-based compound and a benzene isomer or an mixture of benzene isomers, the sum of the number of repetitions of the structural unit X' and the number of repetitions of the structural unit Y' (n or m+m') being more than 10 to less than 75, the general formulas being: 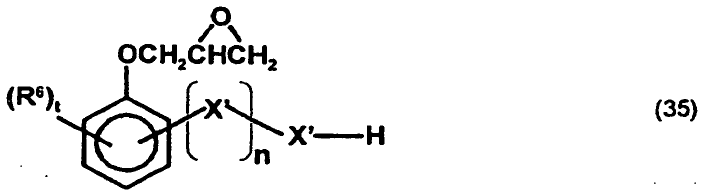 or 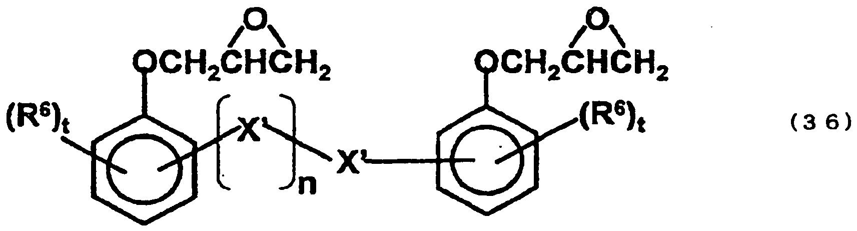 (where R⁶ represents hydrogen or a monovalent substituent having 1 to 3 carbon atoms, t represents an integer from 0 to 4, and n is more than 10 to less than 75); 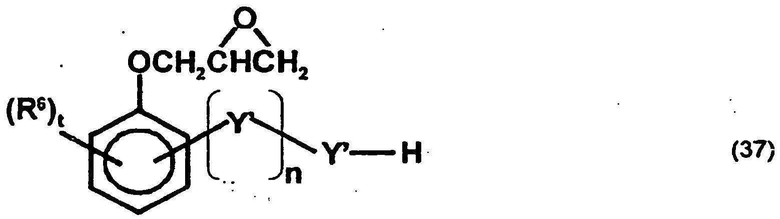 or 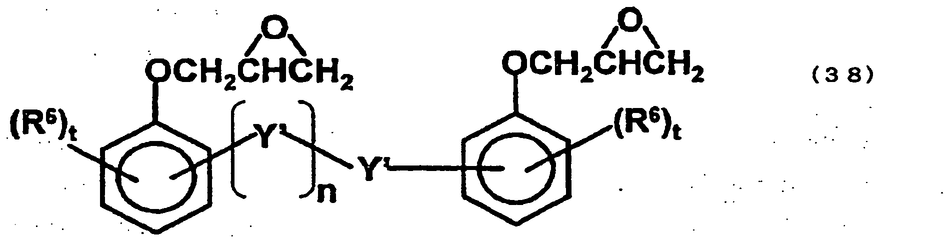 (where R⁶ represents hydrogen or a monovalent substituent having 1 to 3 carbon atoms, t represents an integer from 0 to 4, and n is more than 10 to less than 75); and and 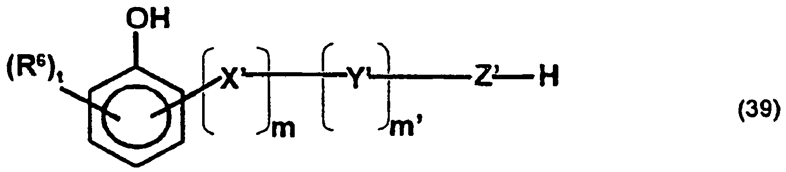 or 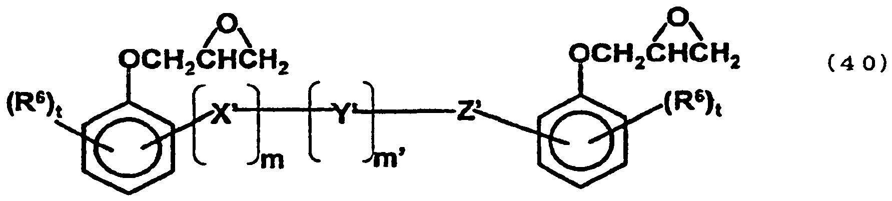 (where R⁶ represents hydrogen or a monovalent substituent having 1 to 3 carbon atoms, t represents an integer from 0 to 4, m and m' are each independently 1 to 74, m+m' is more than 10 to less than 75, and Z' represents one of X' and Y').

21. The epoxy resin composition according to Claim 20, wherein the epoxy-resin curing agent (B) includes a phenol resin (F') represented by one of the following general formulas (21) to (26), the number of repeating units (n or m+m') being 0 to 10, the general formulas being: 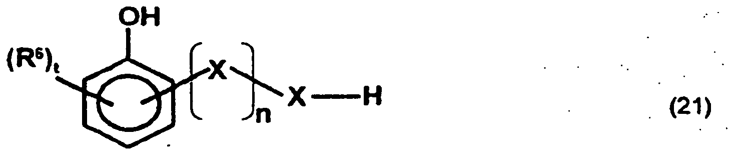 or 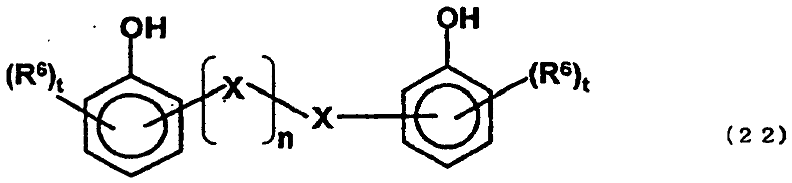 (where R⁶ represents hydrogen or a monovalent substituent having 1 to 3 carbon atoms, t represents an integer from 0 to 4, and n is 0 to 10); 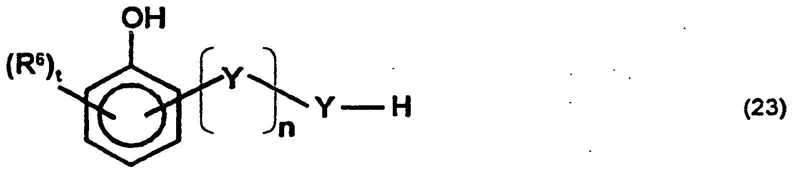 or 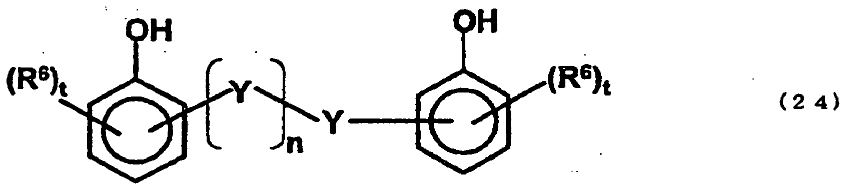 (where R⁶ represents hydrogen or a monovalent substituent having 1 to 3 carbon atoms, t represents an integer from 0 to 4, and n is 0 to 10); and 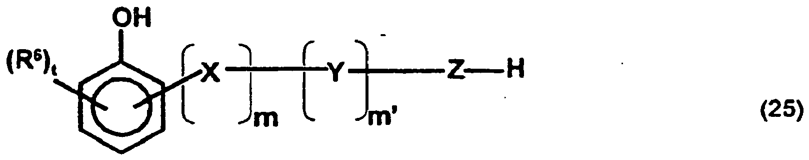 or 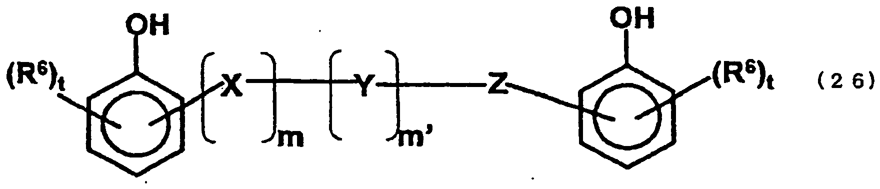 (where R⁶ represents hydrogen or a monovalent substituent having 1 to 3 carbon atoms, t represents an integer from 0 to 4, m and m' are each independently 1 to 9, m+m' is 1 to 10, and Z represents one of X and Y).

22. The epoxy resin composition according to Claim 20 or 21, further comprising an inorganic filler (C).

23. The epoxy resin composition according to Claim 22, wherein the inorganic filler (C) is aluminum hydroxide (C').

24. The epoxy resin composition according to Claim 23, wherein the 50 mass% average particle diameter (D₅₀) of the aluminum hydroxide (C') is 0.5 to 20 µm.

25. The epoxy resin composition according to one of Claims 21 to 24, further comprising a curing promotion catalyst (D).

26. The epoxy resin composition according to one of Claims 21 to 25, further comprising one of a phenoxy resin containing an epoxy group and a phenoxy resin containing no epoxy group.

27. The epoxy resin composition according to one of Claims 21 to 25, further comprising a rubber component as a flexibilizer.

28. The epoxy resin composition according to one of Claims 21 to 27, further comprising a silane coupling agent.

29. The epoxy resin composition according to one of Claims 21 to 28, further comprising a mercapto compound.

30. The epoxy resin composition according to one of Claims 21 to 29, further comprising at least one of a nitrogen-containing curing agent and an inorganic flame retardant.

31. A varnish solution comprising: an organic solvent; and the epoxy resin composition according to one of Claims 21 to 30 which is dissolved or dispersed therein.

32. A prepreg material comprising: a resin sheet in a semi-cured state, obtained after a process including impregnating a base material with the varnish solution according to Claim 31, followed by removal of the solvent.

33. A laminate comprising: the prepreg material according to Claim 32.

34. A copper-clad laminate comprising: the prepreg material according to Claim 32; and a copper foil which is adhered to one surface thereof.

35. A copper foil provided with a resin, produced by a process comprising the step of: applying the varnish solution according to Claim 31 onto a surface of a copper foil.

36. A printed circuit board comprising: a copper foil; and a resin material laminated thereto, the resin material being only formed of an epoxy resin composition or being formed of a base material containing an epoxy resin, said epoxy resin composition containing the epoxy resin composition according to one of Claims 21 to 30 and being in a semi-cured state or in a cured state.

37. The printed circuit board according to Claim 36, wherein the resin material includes a prepreg material comprising a resin sheet in a semi-cured state, which is obtained after a process including the steps of: impregnating a base material with a varnish solution which contains an organic solvent and an epoxy resin composition dissolved or dispersed therein; and removing the solvent therefrom.

38. The printed circuit board according to Claim 36, wherein the resin material includes the epoxy resin composition applied on the copper foil.

39. An epoxy resin composition comprising: an epoxy resin (A), the epoxy-resin curing agent (B); and aluminum hydroxide (C'),
wherein the epoxy-resin curing agent (B) is a phenol resin (E) containing at least one of a structural unit X, which is represented by the following general formula (1) obtained by reaction between a phenol-based compound and a biphenyl isomer or a mixture of biphenyl isomers, and a structural unit Y, which is represented by the following general formula (2) obtained by reaction between a phenol-based compound and a benzene isomer or an mixture of benzene isomers,
the epoxy resin (A) is an epoxy compound (E') of the phenol resin (E), and
the aluminum hydroxide (C') has a 50 mass% average particle diameter (D₅₀) of 1 to 10 µm, the general formulas being: 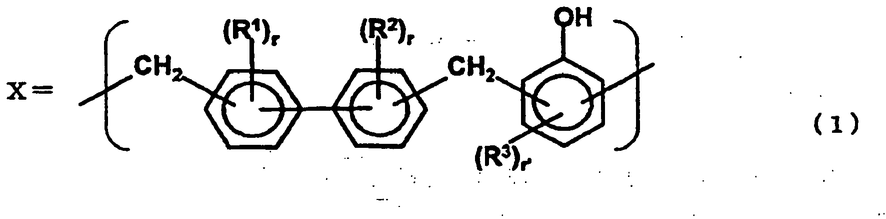 (where R¹, R², and R³ each independently represent hydrogen or a monovalent substituent having 1 to 3 carbon atoms, each r independently represents an integer from 0 to 4, and r' represents an integer from 0 to 3); and 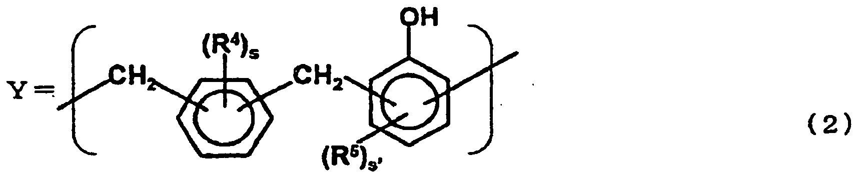 (where R⁴ and R⁵ each independently represent hydrogen or a monovalent substituent having 1 to 3 carbon atoms, each s independently represents an integer from 0 to 4, and s' represents an integer from 0 to 3).

40. The epoxy resin composition according to Claim 39, further comprising a curing promotion catalyst (D).

41. The epoxy resin composition according to Claim 39 or 40, further comprising one of a phenoxy resin containing an epoxy group and a phenoxy resin containing no epoxy group.

42. The epoxy resin composition according to one of Claims 39 to 41, further comprising a rubber component as a flexibilizer.

43. The epoxy resin composition according to one of Claims 39 to 42, further comprising a silane coupling agent.

44. The epoxy resin composition according to one of Claims 39 to 43, further comprising a mercapto compound.

45. The epoxy resin composition according to one of Claims 39 to 44, further comprising at least one of a nitrogen-containing curing agent and an inorganic flame retardant.

46. A varnish solution comprising: an organic solvent; and the epoxy resin composition according to one of Claims 39 to 45 which is dissolved or dispersed therein.

47. A prepreg material comprising: a resin sheet in a semi-cured state, obtained after a process including impregnating a base material with the varnish solution according to Claim 46, followed by removal of the solvent.

48. A laminate comprising: the prepreg material according to Claim 47.

49. A copper-clad laminate comprising: the prepreg material according to Claim 46; and a copper foil which is adhered to one surface thereof.

50. A copper foil provided with a resin, produced by a process comprising the step of: applying the varnish solution according to Claim 45 onto a surface of a copper foil.

51. A printed circuit board comprising: a copper foil; and a resin material laminated thereto, the resin material being only formed of an epoxy resin composition or being formed of a base material containing an epoxy resin, said epoxy resin composition containing the epoxy resin composition according to one of Claims 39 to 45 and being in a semi-cured state or in a cured state.

52. The printed circuit board according to Claim 51, wherein the resin material includes a prepreg material comprising a resin sheet in a semi-cured state, which is obtained after a process including the steps of: impregnating a base material with a varnish solution which contains an organic solvent and an epoxy resin composition dissolved or dispersed therein; and removing the solvent therefrom.

53. The printed circuit board according to Claim 51, wherein the resin material includes the epoxy resin composition applied on the copper foil.

## Patentansprüche

1. Epoxyharz-Zusammensetzung, umfassend: ein Epoxyharz (A); und ein Epoxyharz-Härtungsmittel (B), das ein durch eine der allgemeinen Formeln (3) bis (8) dargestelltes Phenolharz (F) einschließt, wobei das Phenolharz (F) mindestens eine Struktureinheit X, die durch die folgende allgemeine Formel (1) dargestellt wird und durch Reaktion zwischen einer Verbindung auf Phenol-Basis und einem Biphenyl-Isomer oder einer Mischung von Biphenyl-Isomeren erhalten wird, und/oder eine Struktureinheit Y enthält, die durch die folgende allgemeine Formel (2) dargestellt wird und durch Reaktion zwischen einer Verbindung auf Phenol-Basis und einem Benzol-Isomer oder einer Mischung von Benzol-Isomeren erhalten wird, wobei die Summe der Zahl der Wiederholungen der Struktureinheit X und der Zahl der Wiederholungen der Struktureinheit Y (n oder m+m') mehr als 10 und weniger als 75 ist, wobei die allgemeinen Formeln sind: 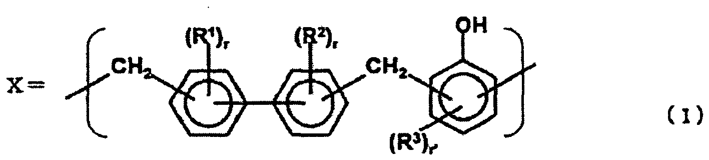 (worin R¹, R² und R³ jeweils unabhängig Wasserstoff oder einen einwertigen Substituenten mit 1 bis 3 Kohlenstoffatomen darstellen, jedes r unabhängig eine ganze Zahl von 0 bis 4 darstellt und r' eine ganze Zahl von 0 bis 3 darstellt); 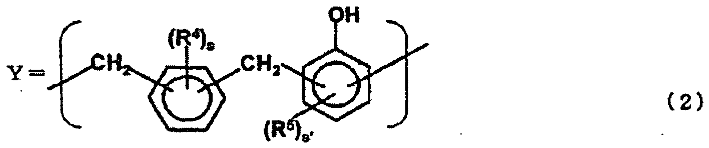 (worin R⁴ und R⁵ jeweils unabhängig Wasserstoff oder einen einwertigen Substituenten mit 1 bis 3 Kohlenstoffatomen darstellen, s eine ganze Zahl von 0 bis 4 darstellt und s' eine ganze Zahl von 0 bis 3 darstellt); 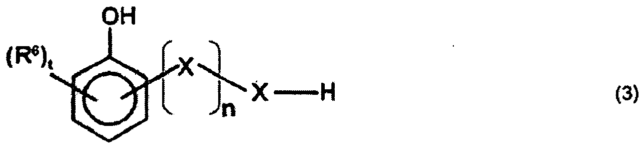 oder 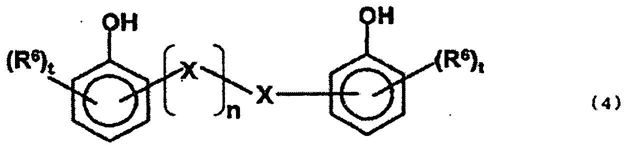 (worin R⁶ Wasserstoff oder einen einwertigen Substituenten mit 1 bis 3 Kohlestoffatomen darstellt, t eine ganze Zahl von 0 bis 4 darstellt, und n mehr als 10 bis weniger als 75 ist); 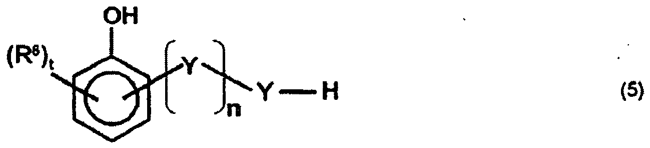 oder 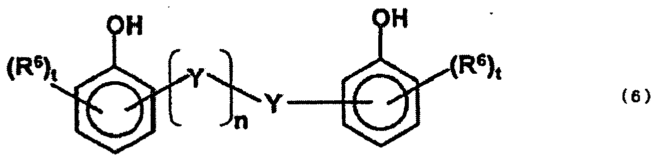 (worin R⁶ Wasserstoff oder einen einwertigen Substituenten mit 1 bis 3 Kohlenstoffatomen darstellt, t eine ganze Zahl von 0 bis 4 darstellt und n mehr als 10 bis weniger als 75 ist); und 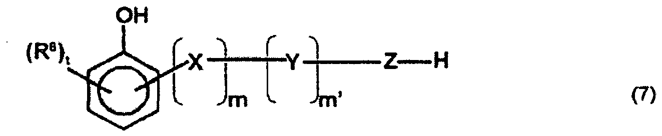 oder 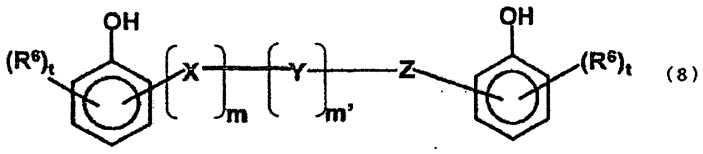 (worin R⁶ Wasserstoff oder einen einwertige n Substituenten mit 1 bis 3 Kohlenstoffatomen darstellt, t eine ganze Zahl von 0 bis 4 darstellt, m und m' jeweils unabhängig 1 bis 74 sind, m+m' mehr als 10 bis weniger als 75 ist und Z eines von X und Y darstellt).

2. Epoxyharz-Zusammensetzung nach Anspruch 1, bei der das Epoxyharz (A) eine Epoxy-Verbindung (G) einschließt, die durch eine der allgemeinen Formeln (11) bis (16) dargestellt wird, wobei die Epoxy-Verbindung (G) eine Struktureinheit X', die durch die folgende allgemeine Formel (9) dargestellt wird und durch Epoxidation eines Produkts durch Reaktion zwischen einer Verbindung auf Phenol-Basis und einem Biphenyl-Isomer oder einer Mischung von Biphenyl-Isomeren erhalten wird, und/oder eine Struktureinheit Y' enthält, die durch die folgende allgemeine Formel (10) dargestellt wird und durch Epoxidation eines Produkts durch Reaktion zwischen einer Verbindung auf Phenol-Basis und einem Benzol-Isomer oder einer Mischung von Benzol-Isomeren erhalten wird, wobei die Summe der Zahl der Wiederholungen der Struktureinheit X' und der Zahl der Wiederholungen der Struktureinheit Y' (n oder m+m') 0 bis 10 ist, wobei die allgemeinen Formeln sind: 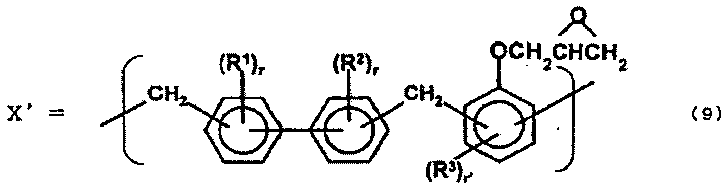 (worin R¹, R² und R³ jeweils unabhängig Wasserstoff oder einen einwertigen Substituenten mit 1 bis 3 Kohlenstoffatomen darstellen, jedes r unabhängig eine ganze Zahl von 0 bis 4 darstellt und r' eine ganze Zahl von 0 bis 3 darstellt); 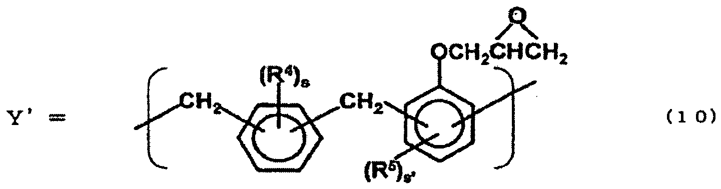 (worin R⁴ und R⁵ Wasserstoff oder einen einwertigen Substituenten mit 1 bis 3 Kohlenstoffatomen darstellen, s eine ganze Zahl von 0 bis 4 darstellt und s' eine ganze Zahl von 0 bis 3 darstellt); 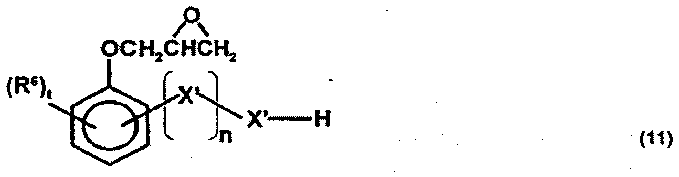 oder 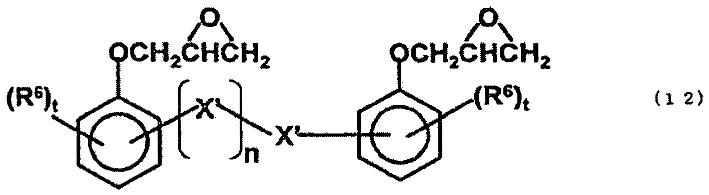 (worin R⁶ Wasserstoff oder einen einwertigen Substituenten mit 1 bis 3 Kohlenstoffatomen darstellt, t eine ganze Zahl von 0 bis 4 darstellt und n 0 bis 10 ist); 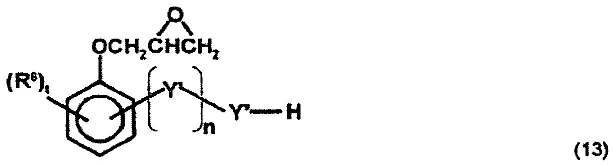 oder 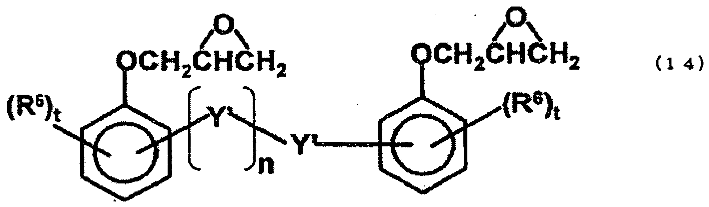 (worin R⁶ Wasserstoff oder einen einwertigen Substituenten mit 1 bis 3 Kohlenstoffatomen darstellt, t eine ganze Zahl von 0 bis 4 darstellt und n 0 bis 10 ist);
und 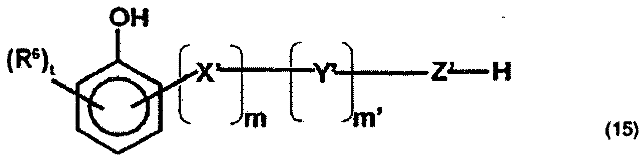 oder 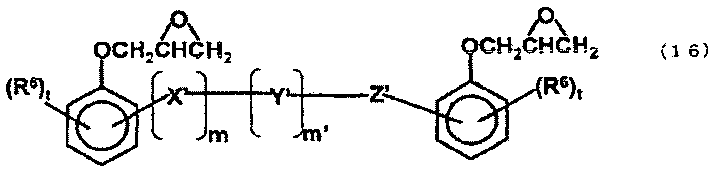 (worin R⁶ Wasserstoff oder einen einwertigen Substituenten mit 1 bis 3 Kohlenstoffatomen darstellt, t eine ganze Zahl von 0 bis 4 darstellt, m und m' jeweils unabhängig 1 bis 9 sind, m+m' 1 bis 10 ist und Z' eines von X' und Y'darstellt).

3. Epoxyharz-Zusammensetzung nach Anspruch 1 oder 2, weiter umfassend einen anorganischen Füllstoff (C).

4. Epoxyharz-Zusammensetzung nach Anspruch 3, bei der der anorganische Füllstoff (C) Aluminiumhydroxid (C') ist.

5. Epoxyharz-Zusammensetzung nach Anspruch 4, bei der der 50 Masse%-Mittelwert des Teilchendurchmessers (D₅₀) des Aluminiumhydroxids (C') 0,5 bis 20 µm beträgt.

6. Epoxyharz-Zusammensetzung nach einem der Ansprüche 1 bis 5, weiter umfassend einen die Härtung fördernden Katalysator (D).

7. Epoxyharz-Zusammensetzung nach einem der Ansprüche 1 bis 6, weiter umfassend eines aus einem Phenoxyharz, das eine Epoxygruppe enthält, und einem Phenoxyharz, das keine Epoxygruppe enthält.

8. Epoxyharz-Zusammensetzung nach einem der Ansprüche 1 bis 7, weiter umfassend eine Kautschuk-Komponente als flexibel machendes Mittel.

9. Epoxyharz-Zusammensetzung nach einem der Ansprüche 1 bis 8, weiter umfassend einen Silan-Haftvermittler.

10. Epoxyharz-Zusammensetzung nach einem der Ansprüche 1 bis 9, weiter umfassend eine Mercapto-Verbindung.

11. Epoxyharz-Zusammensetzung nach einem der Ansprüche 1 bis 10, weiter umfassend mindestens ein stickstoffhaltiges Härtungsmittel und/oder ein anorganisches Flammverzögerungsmittel.

12. Lacklösung, umfassend: ein organisches Lösungsmittel; und die Epoxyharz-Zusammensetzung nach einem der Ansprüche 1 bis 11, die darin gelöst oder dispergiert ist.

13. Prepreg-Material, umfassend: eine Harzfolie in halbgehärtetem Zustand, erhalten nach einem Verfahren, welches das Imprägnieren eines Grundmaterials mit der Lacklösung nach Anspruch 12 umfasst, gefolgt von der Entfernung des Lösungsmittels.

14. Laminat, umfassend das Prepreg-Material nach Anspruch 13.

15. Mit Kupfer verkleidetes Laminat, umfassend: das Prepreg-Material nach Anspruch 13; und eine Kupferfolie, die an eine Oberfläche desselben geklebt ist.

16. Kupferfolie, versehen mit einem Harz, hergestellt durch ein Verfahren, das den Schritt umfasst: Auftragen der Lacklösung nach Anspruch 12 auf eine Oberfläche einer Kupferfolie.

17. Gedruckte Schaltung, umfassend: eine Kupferfolie; und ein daran laminiertes Harzmaterial, wobei das Harzmaterial nur aus einer Epoxyharz-Zusammensetzung gebildet ist oder aus einem Grundmaterial, das ein Epoxyharz enthält, gebildet ist, wobei die Epoxyharz-Zusammensetzung die Epoxyharz-Zusammensetzung nach einem der Ansprüche 1 bis 11 enthält und in halbgehärtetem Zustand oder gehärtetem Zustand vorliegt.

18. Gedruckte Schaltung nach Anspruch 17, bei der das Harzmaterial ein Prepreg-Material einschließt, das eine Harzfolie in halbgehärtetem Zustand umfasst, die erhalten wird nach einem Verfahren, welches die Schritte einschließt: Imprägnieren eines Grundmaterials mit einer Lacklösung, die ein organisches Lösungsmittel und eine Epoxyharz-Zusammensetzung darin dispergiert oder gelöst einschließt; und Entfernen des Lösungsmittels aus demselben.

19. Gedruckte Schaltung nach Anspruch 17, bei der das Harzmaterial die Epoxyharz-Zusammensetzung einschließt, welche auf der Kupferfolie aufgebracht ist.

20. Epoxyharz-Zusammensetzung, aufweisend: eine Epoxyharz-Zusammensetzung (A) und ein Epoxyharz-Härtungsmittel (B), wobei das Epoxyharz (A) eine Epoxy-Verbindung (H) einschließt, die durch eine der allgemeinen Formeln (35) bis (40) dargestellt wird, wobei die Epoxy-Verbindung (H) eine Struktureinheit X', die durch die obige allgemeine Formel (9) dargestellt wird und durch Reaktion zwischen einer Verbindung auf Phenol-Basis und einem Biphenyl-Isomer oder einer Mischung von Biphenyl-Isomeren erhalten wird, und/oder eine Struktureinheit Y' enthält, die durch die folgende allgemeine Formel (10) dargestellt wird und durch Reaktion zwischen einer Verbindung auf Phenol-Basis und einem Benzol-Isomer oder einer Mischung von Benzol-Isomeren erhalten wird, wobei die Summe der Zahl der Wiederholungen der Struktureinheit X' und der Zahl der Wiederholungen der Struktureinheit Y' (n oder m+m') mehr als 10 bis weniger als 75 ist, wobei die allgemeinen Formeln sind: 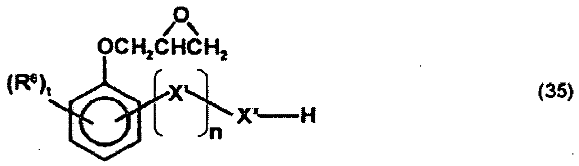 oder 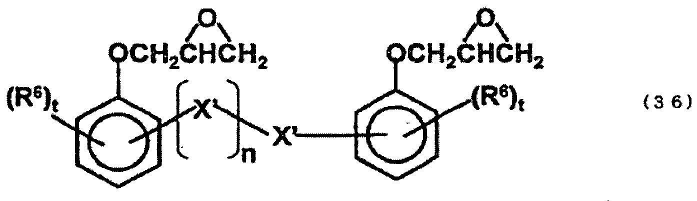 (worin R⁶ Wasserstoff oder einen einwertigen Substituenten mit 1 bis 3 Kohlenstoffatomen darstellt, t eine ganze Zahl von 0 bis 4 darstellt und n mehr als 10 bis weniger als 75 ist); 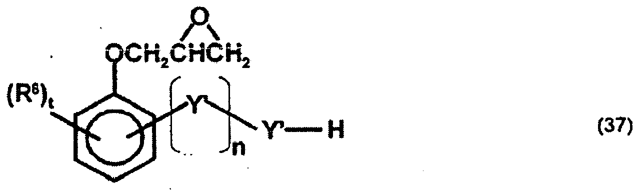 oder 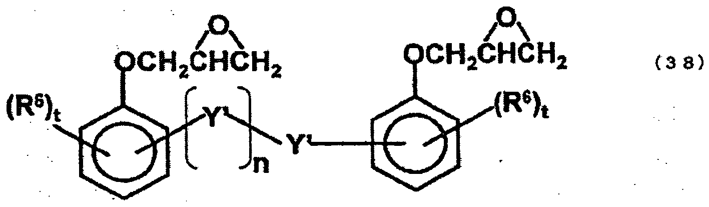 (worin R⁶ Wasserstoff oder einen einwertigen Substituenten mit 1 bis 3 Kohlenstoffatomen darstellt, t eine ganze Zahl von 0 bis 4 darstellt und n mehr als 10 bis weniger als 75 ist); und 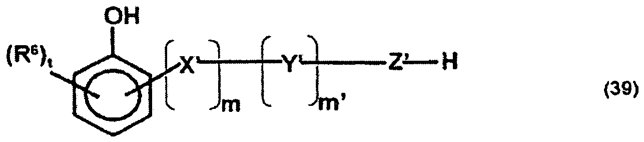 oder 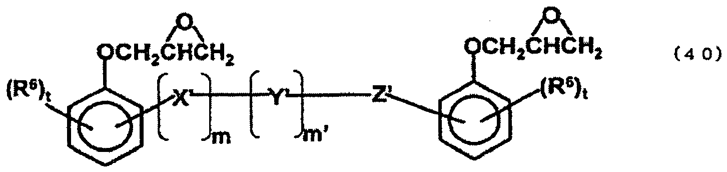 (worin R⁶ Wasserstoff oder einen einwertigen Substituenten mit 1 bis 3 Kohlenstoffatomen darstellt, t eine ganze Zahl von 0 bis 4 darstellt, m und m' jeweils unabhängig 1 bis 74 sind, m+m' mehr als 10 bis weniger als 75 ist und Z eines von X' und Y' darstellt).

21. Epoxyharz-Zusammensetzung nach Anspruch 20, bei der das Epoxyharz-Härtungsmittel (B) ein Phenolharz (F') einschließt, das durch eine der folgenden allgemeinen Formeln (21) bis (26) dargestellt wird, wobei die Zahl der Wiederholungseinheiten (n oder m+m') 0 bis 10 ist, wobei die allgemeinen Formeln sind: 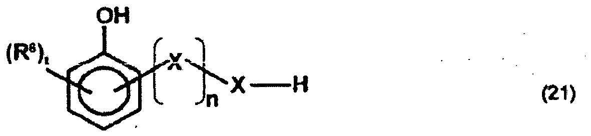 oder 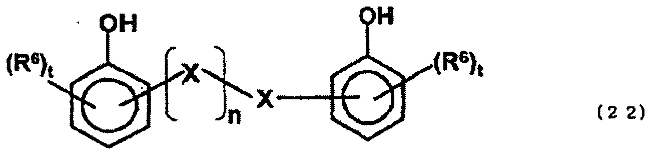 (worin R⁶ Wasserstoff oder einen einwertigen Substituenten mit 1 bis 3 Kohlenstoffatomen darstellt, t eine ganze Zahl von 0 bis 4 darstellt und n 0 bis 10 ist); 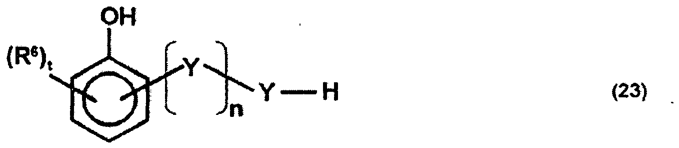 oder 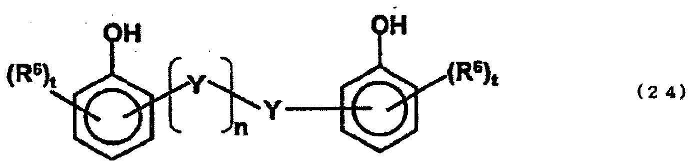 (worin R⁶ Wasserstoff oder einen einwertigen Substituenten mit 1 bis 3 Kohlenstoffatomen darstellt, t eine ganze Zahl von 0 bis 4 darstellt und n 0 bis 10 ist); 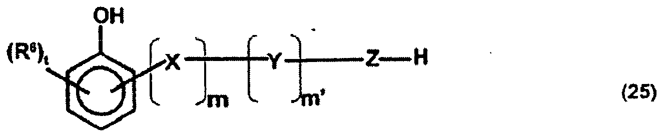 oder 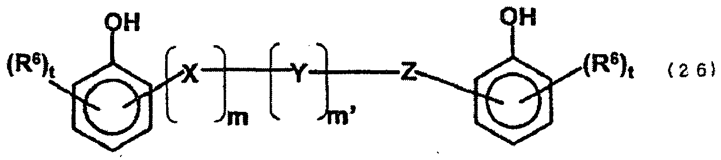 (worin R⁶ Wasserstoff oder einen einwertigen Substituenten mit 1 bis 3 Kohlenstoffatomen darstellt, t eine ganze Zahl von 0 bis 4 darstellt, m und m' jeweils unabhängig 1 bis 9 sind, m+m' 1 bis 10 ist und Z eines von X und Y darstellt).

22. Epoxyharz-Zusammensetzung nach Anspruch 20 oder 21, weiter umfassend einen anorganischen Füllstoff (C).

23. Epoxyharz-Zusammensetzung nach Anspruch 22, bei der der anorganische Füllstoff (C) Aluminiumhydroxid (C') ist.

24. Epoxyharz-Zusammensetzung nach Anspruch 23, bei der der 50 Masse%-Mittelwert des Teilchendurchmessers (D₅₀) des Aluminiumhydroxids (C') 0,5 bis 20 µm beträgt.

25. Epoxyharz-Zusammensetzung nach einem der Ansprüche 21 bis 24, weiter umfassend einen die Härtung fördernden Katalysator (D).

26. Epoxyharz-Zusammensetzung nach einem der Ansprüche 21 bis 25, weiter umfassend eines aus einem Phenoxyharz, das eine Epoxygruppe enthält, und einem Phenoxyharz, das keine Epoxygruppe enthält.

27. Epoxyharz-Zusammensetzung nach einem der Ansprüche 21 bis 25, weiter umfassend eine Kautschuk-Komponente als flexibel machendes Mittel.

28. Epoxyharz-Zusammensetzung nach einem der Ansprüche 21 bis 27, weiter umfassend einen Silan-Haftvermittler.

29. Epoxyharz-Zusammensetzung nach einem der Ansprüche 21 bis 28, weiter umfassend eine Mercapto-Verbindung.

30. Epoxyharz-Zusammensetzung nach einem der Ansprüche 21 bis 29, weiter umfassend mindestens ein stickstoffhaltiges Härtungsmittel und/oder ein anorganisches Flammverzögerungsmittel.

31. Lacklösung, umfassend: ein organisches Lösungsmittel; und die Epoxyharz-Zusammensetzung nach einem der Ansprüche 21 bis 30, die darin gelöst oder dispergiert ist.

32. Prepreg-Material, umfassend: eine Harzfolie in halbgehärtetem Zustand, erhaiten nach einem Verfahren, welches das Imprägnieren eines Grundmaterials mit der Lacklösung nach Anspruch 31 umfasst, gefolgt von der Entfernung des Lösungsmittels.

33. Laminat, umfassend das Prepreg-Material nach Anspruch 32.

34. Mit Kupfer verkleidetes Laminat, umfassend: das Prepreg-Material nach Anspruch 32 und eine Kupferfolie, die an eine Oberfläche desselben geklebt ist.

35. Kupferfolie, versehen mit einem Harz, hergestellt durch ein Verfahren, das den Schritt umfasst: Auftragen der Lacklösung nach Anspruch 31 auf eine Oberfläche einer Kupferfolie.

36. Gedruckte Schaltung, umfassend: eine Kupferfolie; und ein daran laminiertes Harzmaterial, wobei das Harzmaterial nur aus einer Epoxyharz-Zusammensetzung gebildet ist oder aus einem Grundmaterial, das ein Epoxyharz enthält, gebildet ist, wobei die Epoxyharz-Zusammensetzung die Epoxyharz-Zusammensetzung nach einem der Ansprüche 21 bis 30 enthält und in halbgehärtetem Zustand oder gehärtetem Zustand vorliegt.

37. Gedruckte Schaltung nach Anspruch 36, bei der das Harzmaterial ein Prepreg-Material einschließt, das eine Harzfolie in halbgehärtetem Zustand umfasst, die erhalten wird nach einem Verfahren, welches die Schritte einschließt: Imprägnieren eines Grundmaterials mit einer Lacklösung, die ein organisches Lösungsmittel und eine Epoxyharz-Zusammensetzung darin dispergiert oder gelöst einschließt; und Entfernen des Lösungsmittels aus demselben.

38. Gedruckte Schaltung nach Anspruch 36, bei der das Harzmaterial die Epoxyharz-Zusammensetzung einschließt, welche auf der Kupferfolie aufgebracht ist.

39. Epoxyharz-Zusammensetzung, umfassend: ein Epoxyharz (A), das Epoxyharz-Härtungsmittel (B); und Aluminiumhydroxid (C'),
wobei das Epoxyharz-Härtungsmittel (B) ein Phenolharz (E) ist, das mindestens eine Struktureinheit X, die durch die folgende allgemeine Formel (1) dargestellt wird und durch Reaktion zwischen einer Verbindung auf Phenol-Basis und einem Biphenyl-Isomer oder einer Mischung von Biphenyl-Isomeren erhalten wird, und/oder eine Struktureinheit Y enthält, die durch die folgende allgemeine Formel (2) dargestellt wird und durch Reaktion zwischen einer Verbindung auf Phenol-Basis und einem Benzol-Isomer oder einer Mischung von Benzol-Isomeren erhalten wird,
das Epoxyharz (A) eine Epoxy-Verbindung (E') des Phenolharzes (E) ist, und das Aluminiumhydroxid (C') einen durchschnittlichen 50 Masse%-Mittelwert des Teilchendurchmessers (D₅₀) von 1 bis 10 µm aufweist, wobei die allgemeinen Formeln sind: 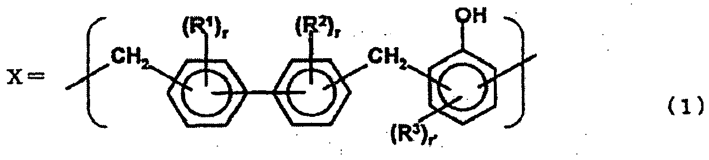 (worin R¹, R² und R³ jeweils unabhängig Wasserstoff oder einen einwertigen Substituenten mit 1 bis 3 Kohlenstoffatomen darstellen, jedes r unabhängig eine ganze Zahl von 0 bis 4 darstellt und r' eine ganze Zahl von 0 bis 3 darstellt); und 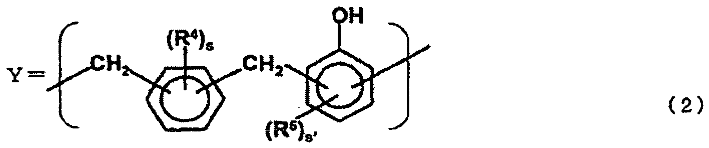 (worin R⁴ und R⁵ jeweils unabhängig Wasserstoff oder einen einwertigen Substituenten mit 1 bis 3 Kohlenstoffatomen darstellen, jedes s unabhängig eine ganze Zahl von 0 bis 4 darstellt und s' eine ganze Zahl von 0 bis 3 darstellt.

40. Epoxyharz-Zusammensetzung nach Anspruch 39, weiter umfassend einen die Härtung fördernden Katalysator (D).

41. Epoxyharz-Zusammensetzung nach einem der Ansprüche 39 oder 40, weiter umfassend eines aus einem Phenoxyharz, das eine Epoxygruppe enthält, und einem Phenoxyharz, das keine Epoxygruppe enthält.

42. Epoxyharz-Zusammensetzung nach einem der Ansprüche 39 bis 41, weiter umfassend eine Kautschuk-Komponente als flexibel machendes Mittel.

43. Epoxyharz-Zusammensetzung nach einem der Ansprüche 39 bis 42, weiter umfassend einen Silan-Haftvermittler.

44. Epoxyharz-Zusammensetzung nach einem der Ansprüche 39 bis 43, weiter umfassend eine Mercapto-Verbindung.

45. Epoxyharz-Zusammensetzung nach einem der Ansprüche 39 bis 44, weiter umfassend mindestens ein stickstoffhaltiges Härtungsmittel und ein anorganisches Flammverzögerungsmittel.

46. Lacklösung, umfassend: ein organisches Lösungsmittel; und die Epoxyharz-Zusammensetzung nach einem der Ansprüche 39 bis 45, die darin gelöst oder dispergiert ist.

47. Prepreg-Material, umfassend: eine Harzfolie in halbgehärtetem Zustand, erhalten nach einem Verfahren, welches das Imprägnieren eines Grundmaterials mit der Lacklösung nach Anspruch 46 umfasst, gefolgt von der Entfernung des Lösungsmittels.

48. Laminat, umfassend das Prepreg-Material nach Anspruch 47.

49. Mit Kupfer verkleidetes Laminat, umfassend: das Prepreg-Material nach Anspruch 46 und eine Kupferfolie, die an eine Oberfläche desselben geklebt ist.

50. Kupferfolie, versehen mit einem Harz, hergestellt durch ein Verfahren, das den Schritt umfasst: Auftragen der Lacklösung nach Anspruch 45 auf eine Oberfläche einer Kupferfolie.

51. Gedruckte Schaltung, umfassend: eine Kupferfolie; und ein daran laminiertes Harzmaterial, wobei das Harzmaterial nur aus einer Epoxyharz-Zusammensetzung gebildet ist oder aus einem Grundmaterial, das ein Epoxyharz enthält, gebildet ist, wobei die Epoxyharz-Zusammensetzung die Epoxyharz-Zusammensetzung nach einem der Ansprüche 39 bis 45 enthält und in halbgehärtetem Zustand oder gehärtetem Zustand vorliegt.

52. Gedruckte Schaltung nach Anspruch 51, bei der das Harzmaterial ein Prepreg-Material einschließt, das eine Harzfolie in halbgehärtetem Zustand umfasst, die erhalten wird nach einem Verfahren, welches die Schritte einschließt: Imprägnieren eines Grundmaterials mit einer Lacklösung, die ein organisches Lösungsmittel und eine Epoxyharz-Zusammensetzung darin dispergiert oder gelöst einschließt; und Entfernen des Lösungsmittels aus demselben.

53. Gedruckte Schaltung nach Anspruch 51, bei der das Harzmaterial die Epoxyharz-Zusammensetzung einschließt, welche auf der Kupferfolie aufgebracht ist.

## Revendications

1. Composition de résine époxy comprenant : une résine époxy (A) ; et un durcisseur pour résine époxy (B) incluant une résine phénolique (F) représentée par l'une des formules générales (3) à (8), la résine phénolique (F) contenant au moins l'un parmi un motif structural X, qui est représenté par la formule générale (1) suivante, obtenu par la réaction entre un composé à base de phénol et un isomère biphényle ou un mélange d'isomères biphényle, et un motif structural Y, qui est représenté par la formule générale (2) suivante, obtenu par la réaction entre un composé à base de phénol et un isomère benzène ou un mélange d'isomères benzène, la somme du nombre de répétitions du motif structural X et du nombre de répétitions du motif structural Y (n ou m + m') étant supérieure à 10 et inférieure à 75, les formules générales étant : 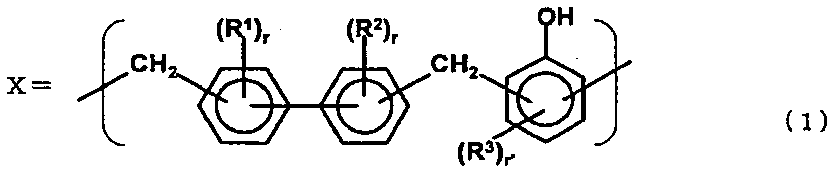 (où R¹, R² et R³ représentent chacun indépendamment un hydrogène ou un substituant monovalent comportant de 1 à 3 atomes de carbone, chaque r représente indépendamment un nombre entier de 0 à 4, et r' représente un nombre entier de 0 à 3) ; 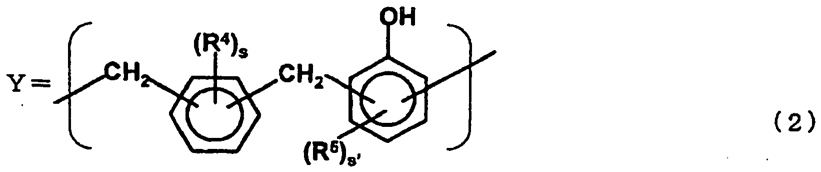 (où R⁴ et R⁵ représentent chacun indépendamment un hydrogène ou un substituant monovalent comportant de 1 à 3 atomes de carbone, s représente un nombre entier de 0 à 4, et s' représente un nombre entier de 0 à 3) ; 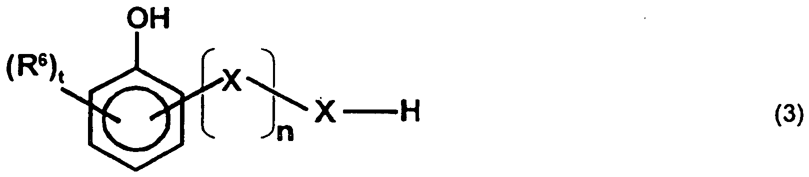 ou 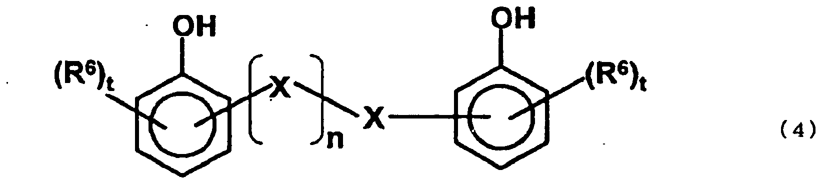 (où R⁶ représente un hydrogène ou un substituant monovalent comportant de 1 à 3 atomes de carbone, t représente un nombre entier de 0 à 4, et n est supérieur à 10 et inférieur à 75) ; 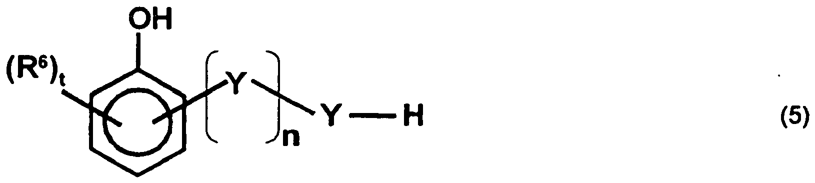 ou 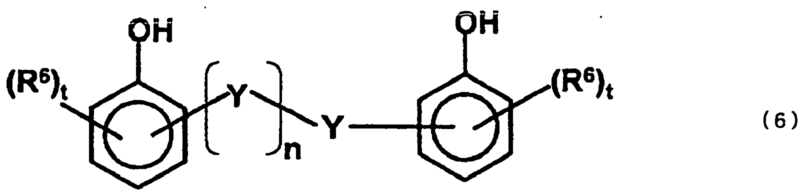 (où R⁶ représente un atome d'hydrogène ou un substituant monovalent comportant de 1 à 3 atomes de carbone, t représente un nombre entier de 0 à 4, et n est supérieur à 10 et inférieur à 75) ; et 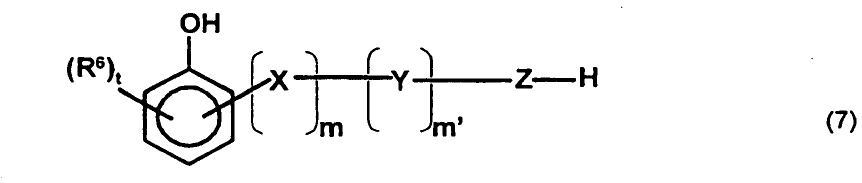 ou 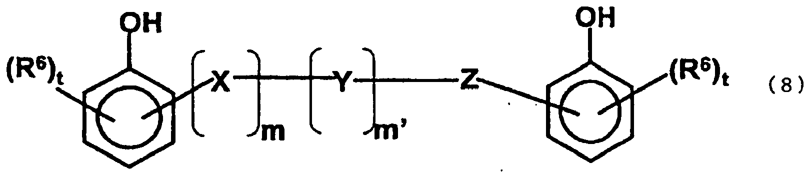 (où R⁶ représente un hydrogène ou un substituant monovalent comportant de 1 à 3 atomes de carbone, t représente un nombre entier de 0 à 4, m et m' valent chacun indépendamment 1 à 74, m + m' est supérieur à 10 et inférieur à 75, et Z représente l'un de X et de Y).

2. Composition de résine époxy selon la revendication 1, dans laquelle la résine époxy (A) inclut un composé époxy (G) représenté par l'une des formules générales (11) à (16), le composé époxy (G) contenant au moins un motif structural X', qui est représenté par la formule générale (9) suivante, obtenu par époxydation d'un produit par réaction entre un composé à base de phénol et un isomère biphényle ou un mélange d'isomères biphényle, et un motif structural Y', qui est représenté par la formule générale (10) suivante, obtenu par époxydation d'un produit par réaction entre un composé à base de phénol et un isomère benzène ou un mélange d'isomères benzène, la somme du nombre de répétitions du motif structural X' et le nombre de répétitions du motif structural Y' (n ou m + m') allant de 0 à 10, les formules générales étant : 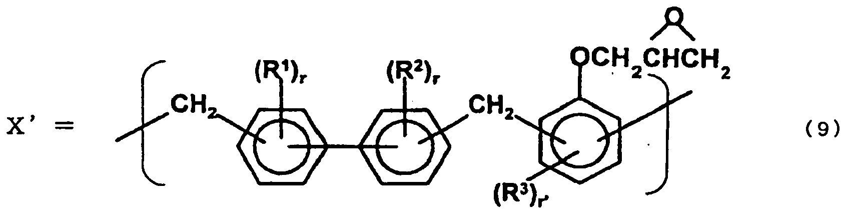 (où R¹, R² et R³ représentent chacun indépendamment un hydrogène ou un substituant monovalent comportant de 1 à 3 atomes de carbone, chaque r représente indépendamment un nombre entier de 0 à 4, et r' représente un nombre entier de 0 à 3) ; 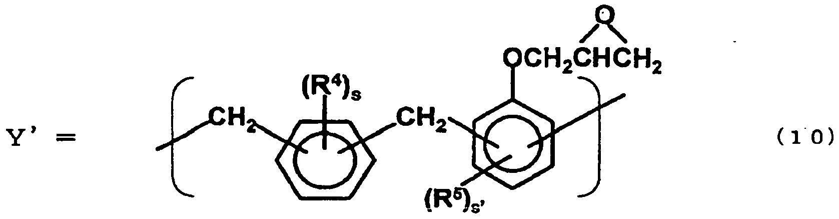 (où R⁴ et R⁵ représentent un hydrogène ou un substituant monovalent comportant de 1 à 3 atomes de carbone, s représente un nombre entier de 0 à 4, et s' représente un nombre entier de 0 à 3) ; 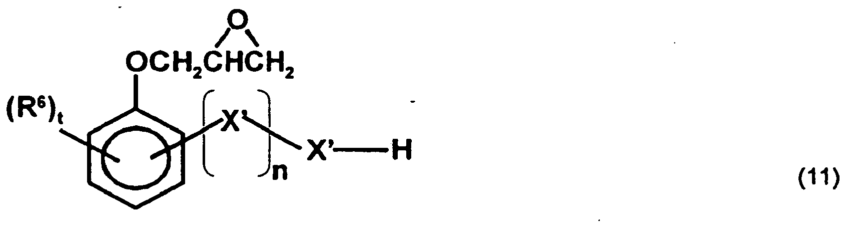 ou 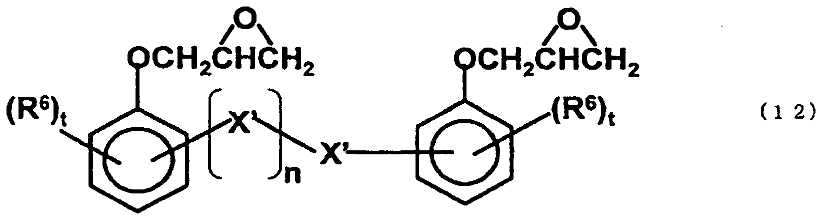 (où R⁶ représente un hydrogène ou un substituant monovalent comportant de 1 à 3 atomes de carbone, t représente un nombre entier de 0 à 4, et n vaut de 0 à 10) ; 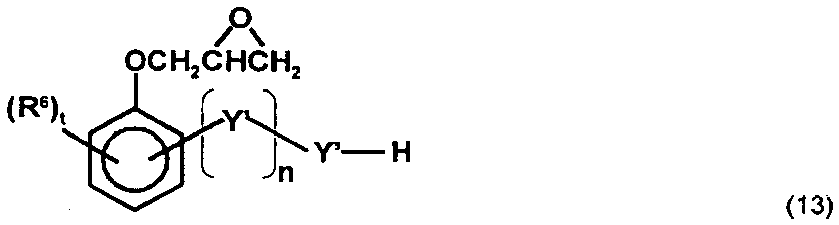 ou 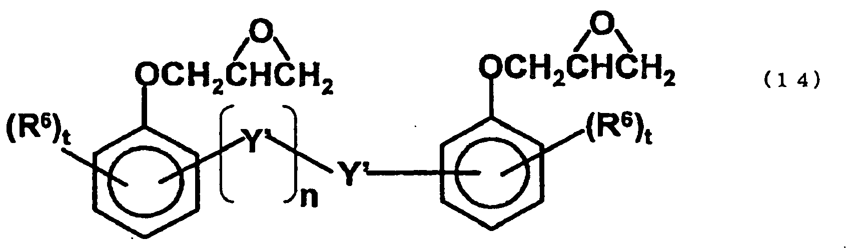 (où R⁶ représente un hydrogène ou un substituant monovalent comportant de 1 à 3 atomes de carbone, t représente un nombre entier de 0 à 4, et n vaut de 0 à 10) ; et 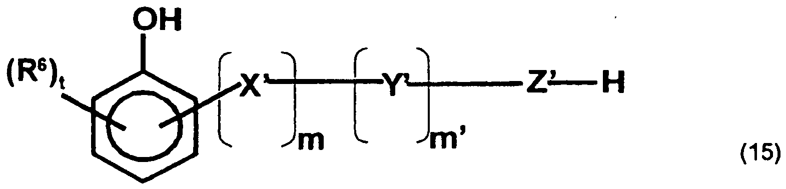 ou 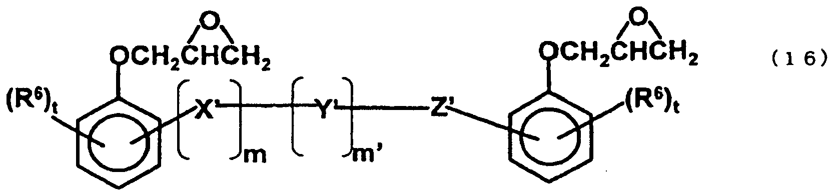 (où R⁶ représente un hydrogène ou un substituant monovalent comportant de 1 à 3 atomes de carbone, t représente un nombre entier de 0 à 4, m et m' valent chacun indépendamment de 1 à 9, m + m' vaut de 1 à 10, et Z' représente l'un de X' et de Y').

3. Composition de résine époxy selon la revendication 1 ou 2, comprenant en outre une charge inorganique (C).

4. Composition de résine époxy selon la revendication 3, dans laquelle la charge inorganique (C) est de l'hydroxyde d'aluminium (C').

5. Composition de résine époxy selon la revendication 4, dans laquelle le diamètre moyen de particule par rapport à 50 % de la masse (D₅₀) de l'hydroxyde d'aluminium (C') est de 0,5 à 20 µm.

6. Composition de résine époxy selon l'une quelconque des revendications 1 à 5, comprenant en outre un catalyseur favorisant le durcissement (D).

7. Composition de résine époxy selon l'une quelconque des revendications 1 à 6, comprenant en outre une résine phénoxy contenant un groupe époxy et une résine phénoxy ne contenant aucun groupe époxy.

8. Composition de résine époxy selon l'une quelconque des revendications 1 à 7, comprenant en outre un composant caoutchouc en tant que flexibilisateur.

9. Composition de résine époxy selon l'une quelconque des revendications 1 à 8, comprenant en outre un agent de couplage silane.

10. Composition de résine époxy selon l'une quelconque des revendications 1 à 9, comprenant en outre un composé mercapto.

11. Composition de résine époxy selon l'une quelconque des revendications 1 à 10, comprenant en outre au moins un durcisseur contenant de l'azote et un retardateur de flammes inorganique.

12. Solution de vernis comprenant : un solvant organique ; et la composition de résine époxy selon l'une quelconque des revendications 1 à 11 qui est dissoute ou dispersée dedans.

13. Matériau préimprégné comprenant : une feuille de résine dans un état semi-durci, obtenue après un procédé incluant l'imprégnation d'un matériau de base avec la solution de vernis selon la revendication 12, suivie de l'élimination du solvant.

14. Stratifié comprenant : le matériau préimprégné selon la revendication 13.

15. Stratifié revêtu de cuivre comprenant : le matériau préimprégné selon la revendication 13 ; et une feuille de cuivre qui adhère à une surface de celui-ci.

16. Feuille de cuivre fournie avec une résine, produite par un procédé comprenant l'étape d'application de la solution de vernis selon la revendication 12 sur une surface d'une feuille de cuivre.

17. Carte de circuit imprimé comprenant : une feuille de cuivre ; et un matériau de résine stratifié dessus, le matériau de résine étant formé uniquement d'une composition de résine époxy ou étant formé d'un matériau de base contenant une résine époxy, ladite composition de résine époxy contenant la composition de résine époxy selon l'une quelconque des revendications 1 à 11 et étant dans un état semi-durci ou dans un état durci.

18. Carte de circuit imprimé selon la revendication 17, dans laquelle le matériau de résine inclut un matériau préimprégné comprenant une feuille de résine dans un état semi-durci, qui est obtenu après un procédé incluant les étapes : d'imprégnation d'un matériau de base avec une solution de vernis qui contient un solvant organique et une composition de résine époxy dissoute ou dispersée dedans, et d'élimination du solvant de celle-ci.

19. Carte de circuit imprimé selon la revendication 17, dans laquelle le matériau de résine inclut la composition de résine époxy appliquée sur la feuille de cuivre.

20. Composition de résine époxy comprenant : une résine époxy (A) et un durcisseur pour résine époxy (B), la résine époxy (A) incluant un composé époxy (H) représenté par l'une des formules générales (35) à (40), le composé époxy (H) contenant au moins l'un parmi un motif structural X', qui est représenté par la formule générale (9) ci-dessus, obtenu par réaction entre un composé à base de phénol et un isomère biphényle ou un mélange d'isomères biphényle, et un motif structural Y', qui est représenté par la formule générale (10) ci-dessus, obtenu par réaction entre un composé à base de phénol et un isomère benzène ou un mélange d'isomères benzène, la somme du nombre de répétitions du motif structural X' et du nombre de répétitions du motif structural Y' (n ou m + m') étant supérieure à 10 et inférieure à 75, les formules générales étant : 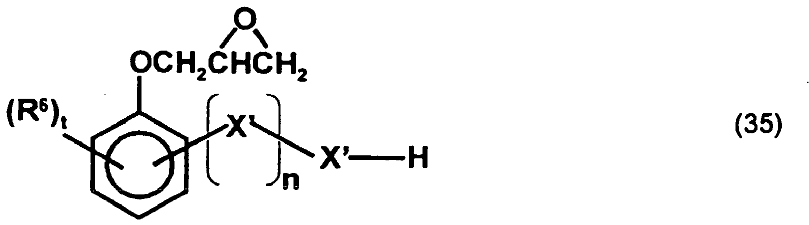 ou 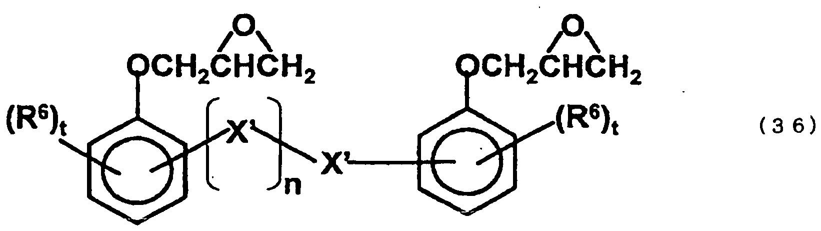 (où R⁶ représente un hydrogène ou un substituant monovalent comportant de 1 à 3 atomes de carbone, t représente un nombre entier de 0 à 4, et n est supérieur à 10 et inférieur à 75) ; 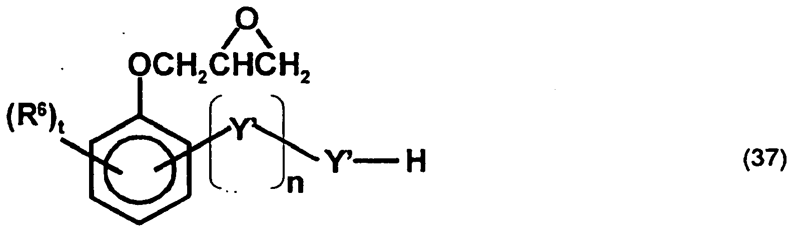 ou 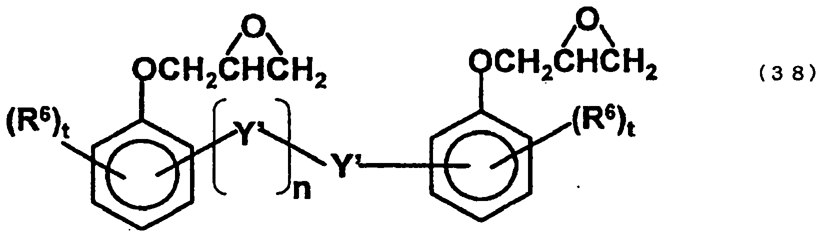 (où R⁶ représente un hydrogène ou un substituant monovalent comportant de 1 à 3 atomes de carbone, t représente un nombre entier de 0 à 4, et n est supérieur à 10 et inférieur à 75) ; et 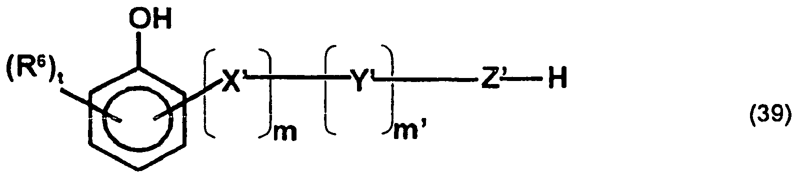 ou 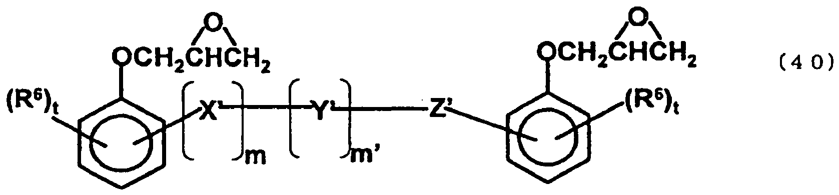 (où R⁶ représente un hydrogène ou un substituant monovalent comportant de 1 à 3 atomes de carbone, t représente un nombre entier de 0 à 4, m et m' valent chacun indépendamment de 1 à 74, m + m' est supérieur à 10 et inférieur à 75, et Z' représente l'un de X' et de Y').

21. Composition de résine époxy selon la revendication 20, dans laquelle le durcisseur pour résine époxy (B) inclut une résine phénolique (F') représentée par l'une des formules générales (21) à (26) suivantes, le nombre de motifs de répétitions (n ou m+ m') allant de 0 à 10, les formules générales étant : 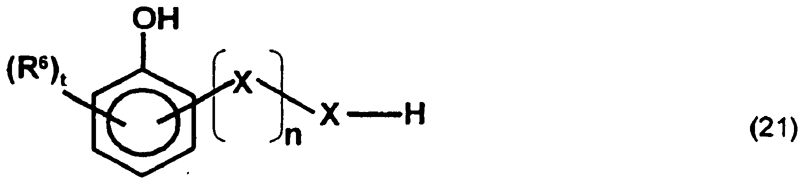 ou 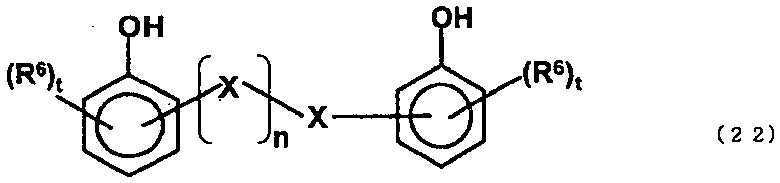 (où R⁶ représente un hydrogène ou un substituant monovalent comportant de 1 à 3 atomes de carbone, t représente un nombre entier de 0 à 4, et n vaut de 0 à 10) ; 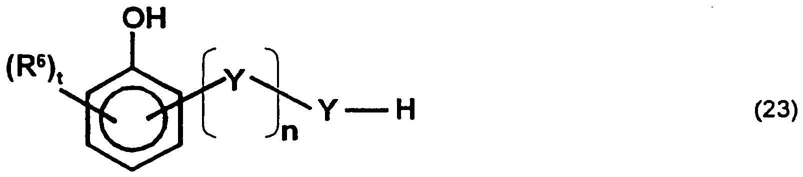 ou 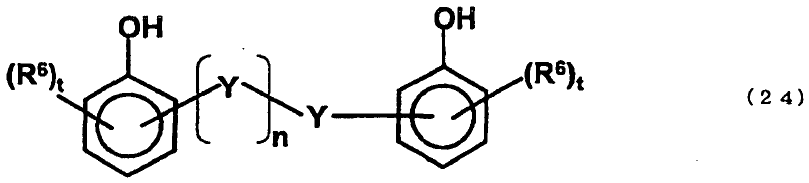 (où R⁶ représente un hydrogène ou un substituant monovalent comportant de 1 à 3 atomes de carbone, t représente un nombre entier de 0 à 4, et n vaut de 0 à 10) ; et 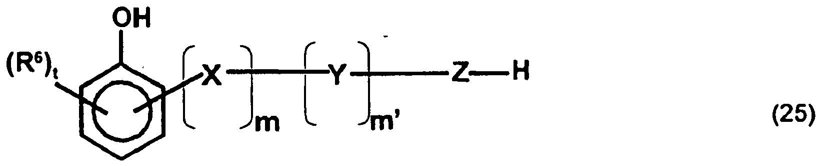 ou 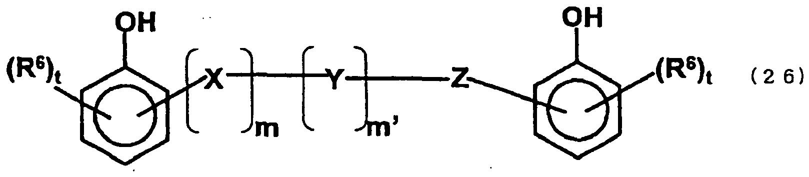 (où R⁶ représente un hydrogène ou un substituant monovalent comportant de 1 à 3 atomes de carbone, t représente un nombre entier de 0 à 4, m et m' valent chacun indépendamment de 1 à 9, m+ m' vaut de 1 à 10, et Z représente l'un de X et de Y).

22. Composition de résine époxy selon la revendication 20 ou 21, comprenant en outre une charge inorganique (C).

23. Composition de résine époxy selon la revendication 22, dans lequel la charge inorganique (C) est de l'hydroxyde d'aluminium (C').

24. Composition de résine époxy selon la revendication 23, dans laquelle le diamètre moyen de particule par rapport à 50 % de la masse (D₅₀) de l'hydroxyde d'aluminium (C') est de 0,5 à 20 µm.

25. Composition de résine époxy selon l'une quelconque des revendications 21 à 24, comprenant en outre un catalyseur favorisant le durcissement (D).

26. Composition de résine époxy selon l'une quelconque des revendications 21 à 25, comprenant en outre une résine phénoxy contenant un groupe époxy et une résine phénoxy ne contenant aucun groupe époxy.

27. Composition de résine époxy selon l'une quelconque des revendications 21 à 25, comprenant en outre un composant caoutchouc en tant que flexibilisateur.

28. Composition de résine époxy selon l'une quelconque des revendications 21 à 27, comprenant en outre un agent de couplage silane.

29. Composition de résine époxy selon l'une quelconque des revendications 21 à 28, comprenant en outre un composé mercapto.

30. Composition de résine époxy selon l'une quelconque des revendications 21 à 29, comprenant en outre au moins un durcisseur contenant de l'azote et un retardateur de flammes inorganique.

31. Solution de vernis comprenant : un solvant organique ; et la composition de résine époxy selon l'une quelconque des revendications 21 à 30 qui est dissoute ou dispersée dedans.

32. Matériau préimprégné comprenant : une feuille de résine dans un état semi-durci, obtenue après un procédé incluant l'imprégnation d'un matériau de base avec la solution de vernis selon la revendication 31, suivie de l'élimination du solvant.

33. Stratifié comprenant : le matériau préimprégné selon la revendication 32.

34. Stratifié revêtu de cuivre comprenant : le matériau préimprégné selon la revendication 32 ; et une feuille de cuivre qui adhère à une surface de celui-ci.

35. Feuille de cuivre fournie avec une résine, produite par un procédé comprenant l'étape d'application de la solution de vernis selon la revendication 31 sur une surface d'une feuille de cuivre.

36. Carte de circuit imprimé comprenant : une feuille de cuivre ; et un matériau de résine stratifié dessus, le matériau de résine étant formé uniquement d'une composition de résine époxy ou étant formé d'un matériau de base contenant une résine époxy, ladite composition de résine époxy contenant la composition de résine époxy selon l'une quelconque des revendications 21 à 30 et étant dans un état semi-durci ou dans un état durci.

37. Carte de circuit imprimé selon la revendication 36, dans laquelle le matériau de résine inclut un matériau préimprégné comprenant une feuille de résine dans un état semi-durci, qui est obtenu après un procédé incluant les étapes : d'imprégnation d'un matériau de base avec une solution de vernis qui contient un solvant organique et une composition de résine époxy dissoute ou dispersée dedans, et d'élimination du solvant de celle-ci.

38. Carte de circuit imprimé selon la revendication 36, dans laquelle le matériau de résine inclut la composition de résine époxy appliquée sur la feuille de cuivre.

39. Composition de résine époxy comprenant : une résine époxy (A), le durcisseur pour résine époxy (B) ; et de l'hydroxyde d'aluminium (C'),
dans laquelle le durcisseur pour résine époxy (B) est une résine phénolique (E) contenant au moins un motif structural X, qui est représenté par la formule générale (1) suivante, obtenu par réaction entre un composé à base de phénol et un isomère biphényle ou un mélange d'isomères biphényle, et un motif structural Y, qui est représenté par la formule générale (2) suivante, obtenu par réaction entre un composé à base de phénol et un isomère benzène ou un mélange d'isomères benzène,
la résine époxy (A) est un composé époxy (E') de la résine phénolique (E), et
l'hydroxyde d'aluminium (C') a un diamètre moyen de particule par rapport à 50 % de la masse (D₅₀) de 1 à 10 µm, les formules générales étant : 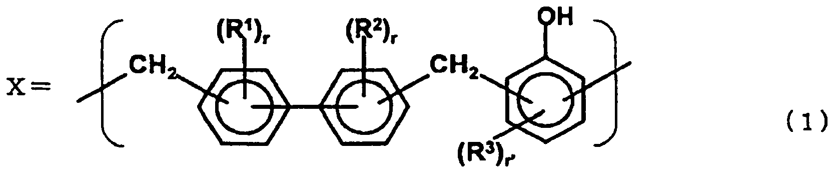 (où R¹, R² et R³ représentent chacun indépendamment un hydrogène ou un substituant monovalent comportant de 1 à 3 atomes de carbone, chaque r représente indépendamment un nombre entier de 0 à 4, et r' représente un nombre entier de 0 à 3) ; et 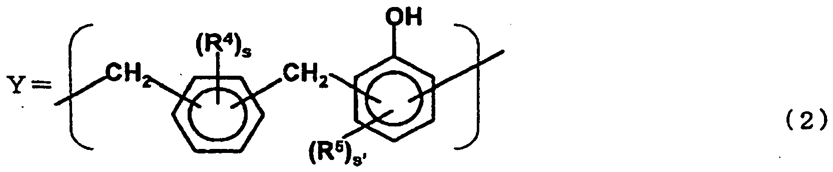 (où R⁴ et R⁵ représentent chacun indépendamment un hydrogène ou un substituant monovalent comportant 1 à 3 atomes de carbone, chaque s représente indépendamment un nombre entier de 0 à 4, et s' représente un nombre entier de 0 à 3).

40. Composition de résine époxy selon la revendication 39, comprenant en outre un catalyseur favorisant le durcissement (D).

41. Composition de résine époxy selon la revendication 39 ou 40, comprenant en outre une résine phénoxy contenant un groupe époxy et une résine phénoxy ne contenant aucun groupe époxy.

42. Composition de résine époxy selon l'une quelconque des revendications 39 à 41, comprenant en outre un composant caoutchouc en tant que flexibilisateur.

43. Composition de résine époxy selon l'une quelconque des revendications 39 à 42, comprenant en outre un agent de couplage silane.

44. Composition de résine époxy selon l'une quelconque des revendications 39 à 43, comprenant en outre un composé mercapto.

45. Composition de résine époxy selon l'une quelconque des revendications 39 à 44, comprenant en outre au moins un durcisseur contenant de l'azote et un retardateur de flammes inorganique.

46. Solution de vernis comprenant : un solvant organique ; et la composition de résine époxy selon l'une quelconque des revendications 39 à 45 qui est dissoute ou dispersée dedans.

47. Matériau préimprégné comprenant : une feuille de résine dans un état semi-durci, obtenue après un procédé incluant l'imprégnation d'un matériau de base avec la solution de vernis selon la revendication 46, suivie de l'élimination du solvant.

48. Stratifié comprenant : le matériau préimprégné selon la revendication 47.

49. Stratifié revêtu de cuivre comprenant : le matériau préimprégné selon la revendication 46 ; et une feuille de cuivre qui adhère à une surface de celui-ci.

50. Feuille de cuivre fournie avec une résine, produite par un procédé comprenant l'étape d'application de la solution de vernis selon la revendication 45 sur une surface d'une feuille de cuivre.

51. Carte de circuit imprimé comprenant : une feuille de cuivre ; et un matériau de résine stratifié dessus, le matériau de résine étant formé uniquement d'une composition de résine époxy ou étant formé d'un matériau de base contenant une résine époxy, ladite composition de résine époxy contenant la composition de résine époxy selon l'une quelconque des revendications 39 à 45 et étant dans un état semi-durci ou dans un état durci.

52. Carte de circuit imprimé selon la revendication 51, dans laquelle le matériau de résine inclut un matériau préimprégné comprenant une feuille de résine dans un état semi-durci, qui est obtenu après un procédé incluant les étapes : d'imprégnation d'un matériau de base avec une solution de vernis qui contient un solvant organique et une composition de résine époxy dissoute ou dispersée dedans, et d'élimination du solvant de celle-ci.

53. Carte de circuit imprimé selon la revendication 51, dans laquelle le matériau de résine inclut la composition de résine époxy appliquée sur la feuille de cuivre.
